(19) Europäisches Patentamt
European Patent Office
Office européen des brevets

(11) EP 4 131 443 A1

(12) EUROPEAN PATENT APPLICATION
published in accordance with Art. 153(4) EPC

(43) Date of publication:
**08.02.2023 Bulletin 2023/06**

(21) Application number: **21781388.0**

(22) Date of filing: **22.03.2021**

(51) International Patent Classification (IPC):
***H01L 51/42*** *(2006.01)* ***H01L 31/10*** *(1974.07)*
***H01L 27/30*** *(2006.01)*

(52) Cooperative Patent Classification (CPC):
**H01L 27/30; H01L 27/32; H01L 31/10; H01L 51/42; H01L 51/50; H05B 33/02;** Y02E 10/549

(86) International application number:
**PCT/JP2021/011597**

(87) International publication number:
**WO 2021/200317 (07.10.2021 Gazette 2021/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2020 JP 2020063539**

(71) Applicant: **Sumitomo Chemical Company, Limited**
**Tokyo 103-6020 (JP)**

(72) Inventors:
- **FERRARA, Giovanni**
  **Tsukuba-shi, Ibaraki 300-3294 (JP)**
- **ARAKI, Takafumi**
  **Tsukuba-shi, Ibaraki 300-3294 (JP)**
- **OZEKI, Miho**
  **Tsukuba-shi, Ibaraki 300-3294 (JP)**

(74) Representative: **Vossius & Partner**
**Patentanwälte Rechtsanwälte mbB**
**Siebertstraße 3**
**81675 München (DE)**

# (54) PHOTODETECTOR ELEMENT

(57) To improve specific detectivity. A photodetector element 10 includes: an anode 12; a cathode 16; and an active layer 14 provided between the anode and the cathode and containing a p-type semiconductor material and an n-type semiconductor material, wherein a value (ΔEA + ΔEB) of a sum of a value (ΔEA) obtained by subtracting an absolute value of an energy level of HOMO of the p-type semiconductor material from an absolute value of an energy level of HOMO of the n-type semiconductor material and a value (ΔEB) obtained by subtracting an absolute value of an energy level of LUMO of the p-type semiconductor material from an absolute value of an energy level of LUMO of the n-type semiconductor material is in a range of more than 0 and less than 0.88.

[FIG. 1]

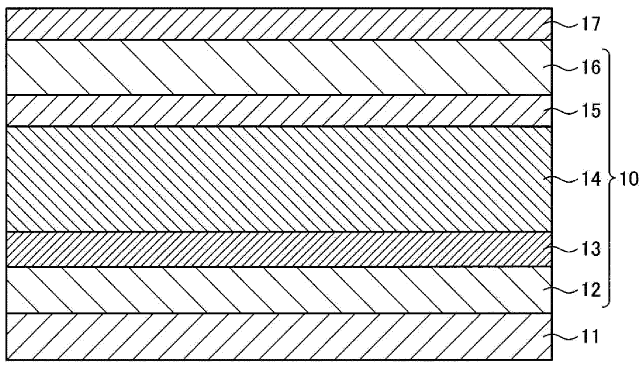




Processed by Luminess, 75001 PARIS (FR)

## Description

TECHNICAL FIELD

The present invention relates to a photodetector element.

BACKGROUND ART

Photoelectric conversion elements including a photodetector element are an extremely useful device in view of, for example, energy saving and reduction in discharge amount of carbon dioxide, and therefore have attracted attention.

The photoelectric conversion element is an electron element including: at least a pair of electrodes composed of an anode and a cathode; and an active layer containing an organic semiconductor material and provided between the pair of electrodes. In the photoelectric conversion element, any one of the electrodes is formed of a light-transmissive material, and light is incident on the active layer from the light-transmissive electrode side. Then, charges (holes and electrons) are generated in the active layer by the energy (hv) of the light incident on the active layer. The generated holes move toward the anode, and the electrons move toward the cathode. Then, charges which have reached the anode and the cathode are extracted outside the photoelectric conversion element.

The photoelectric conversion element is used for a photodetector element, for example. The photodetector element is usually used in a state where a voltage (reverse bias voltage) in a direction opposite to an electromotive force generated by irradiation with light is applied, and incident light is converted into a current and detected. However, even in a state where no light is incident on the photodetector element, a weak current flows. Such a current is known as dark current, and is a factor that lowers the accuracy in photodetection.

As an attempt to improve the specific detectivity (D*) of the photodetector element, an aspect in which a charge injection layer is used is known (see, Non-Patent Document 1), and an aspect in which the active layer is optimized by devising a production process is known (see, Non-Patent Document 2).

PRIOR ART DOCUMENTS

NON-PATENT DOCUMENTS

Non-Patent Document 1: Scientific Reports | 6: 39201 | DOI: 10.1038/srep 39201
Non-Patent Document 2: Adv. Mater. 2015, 27, 6411 to 6417

SUMMARY OF THE INVENTION

PROBLEMS TO BE SOLVED BY THE INVENTION

However, the conventional photodetector element has a problem that the specific detectivity is not yet sufficient. Further improvement of the specific detectivity in the photodetector element is required.

MEANS FOR SOLVING THE PROBLEMS

The present inventors have extensively conducted studies for solving the above-described problem, and resultantly found that the problem can be solved by adjusting the relationship between the energy level of the highest occupied molecular orbital (HOMO) of a p-type semiconductor material contained in the active layer and the energy level of the HOMO of an n-type semiconductor material contained in the active layer, and the relationship between the energy level of the lowest unoccupied molecular orbital (LUMO) of the p-type semiconductor material and the energy level of the HOMO of the n-type semiconductor material, leading to completion of the present invention.

That is, the present invention provides the following [1] to [20].

[1] A photodetector element including: an anode; a cathode; and an active layer provided between the anode and the cathode and containing a p-type semiconductor material and an n-type semiconductor material,
wherein a value ($\Delta$EA + $\Delta$EB) of a sum of a value ($\Delta$EA) obtained by subtracting an absolute value of an energy level of a highest occupied molecular orbital (HOMO) of the p-type semiconductor material from an absolute value of an energy level of a HOMO of the n-type semiconductor material and a value ($\Delta$EB) obtained by subtracting an

absolute value of an energy level of a lowest unoccupied molecular orbital (LUMO) of the p-type semiconductor material from an absolute value of an energy level of a LUMO of the n-type semiconductor material is in a range of more than 0 and less than 0.88.

[2] The photodetector element according to [1], wherein the value ($\Delta$EA + $\Delta$EB) of the sum is in a range of 0.20 to 0.67.

[3] The photodetector element according to [1] or [2], wherein the p-type semiconductor material is a polymer compound containing a constituent unit represented by Formula (I):

[Chemical Formula 1]

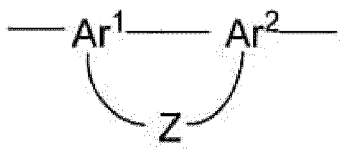

(I)

where $Ar^1$ and $Ar^2$ represent a trivalent aromatic heterocyclic group optionally having a substituent or a trivalent aromatic carbocyclic group optionally having a substituent, and Z represents a group represented by Formulae (Z-1) to (Z-7);

[Chemical Formula 2]

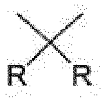
(Z-1)

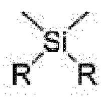
(Z-2)

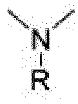
(Z-3)

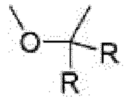
(Z-4)

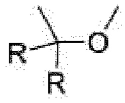
(Z-5)

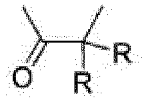
(Z-6)

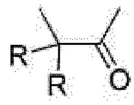
(Z-7)

where

R each independently represents

a hydrogen atom,
a halogen atom,
an alkyl group optionally having a substituent,
an aryl group optionally having a substituent,
a cycloalkyl group optionally having a substituent,
an alkyloxy group optionally having a substituent,
a cycloalkyloxy group optionally having a substituent,
an aryloxy group optionally having a substituent,
an alkylthio group optionally having a substituent,
a cycloalkylthio group optionally having a substituent,
an arylthio group optionally having a substituent,
a monovalent heterocyclic group optionally having a substituent,

a substituted amino group optionally having a substituent,

an imine residue optionally having a substituent,
an amide group optionally having a substituent,
an acid imide group optionally having a substituent,
a substituted oxycarbonyl group optionally having a substituent,
an alkenyl group optionally having a substituent,
a cycloalkenyl group optionally having a substituent,
an alkynyl group optionally having a substituent,
a cycloalkynyl group optionally having a substituent,
a cyano group,
a nitro group,

a group represented by -C(=O)-$R^a$, or
a group represented by -$SO_2$-$R^b$,

$R^a$ and $R^b$ each independently represent

a hydrogen atom,
an alkyl group optionally having a substituent,
an aryl group optionally having a substituent,
an alkyloxy group optionally having a substituent,
an aryloxy group optionally having a substituent, or
a monovalent heterocyclic group optionally having a substituent, and

when there are two Rs, the two Rs may be the same or different.

[4] The photodetector element according to any one of [1] to [3], wherein the p-type semiconductor material is a polymer compound containing a constituent unit represented by Formula (II) or (III):

[Chemical Formula 3]

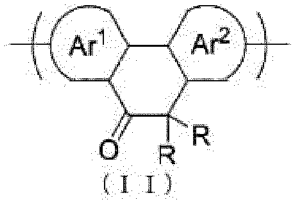

(II)

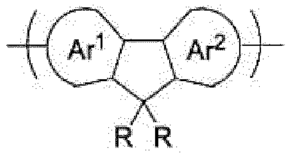

(III)

where $Ar^1$, $Ar^2$, and R are as defined above.

[5] The photodetector element according to [4], wherein the p-type semiconductor material is a polymer compound containing a constituent unit represented by Formula (IV):

[Chemical Formula 4]

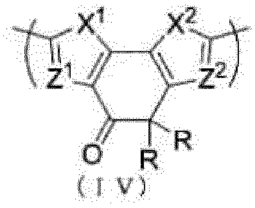

(IV)

where

$X^1$ and $X^2$ are each independently a sulfur atom or an oxygen atom,
$Z^1$ and $Z^2$ are each independently a group represented by =C(R)- or a nitrogen atom, and
R is as defined above.

[6] The photodetector element according to [5], wherein in Formula (IV), $X^1$ and $X^2$ are a sulfur atom, and $Z^1$ and $Z^2$ are a group represented by =C(R)-.

[7] The photodetector element according to any one of [1] to [6], wherein the p-type semiconductor material is a polymer compound containing a constituent unit represented by Formulae (VI-1) to (VI-7):

[Chemical Formula 5]

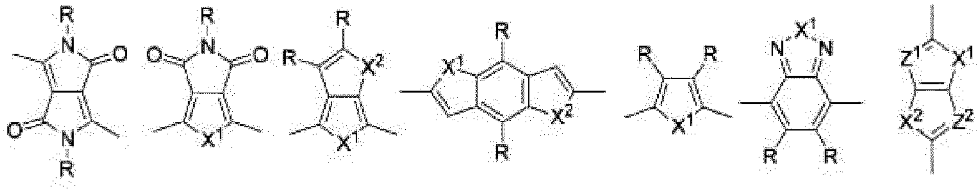

(VI-1) (VI-2) (VI-3) (VI-4) (VI-5) (VI-6) (VI-7)

where $X^1$, $X^2$, $Z^1$, $Z^2$, and R are as defined above, and when there are two Rs, the two Rs may be the same or different.

[8] The photodetector element according to any one of [1] to [7], wherein the n-type semiconductor material is a compound represented by Formula (VIII):

$$A^1\text{-}B^{10}\text{-}A^2 \qquad \text{(VIII)}$$

where

$A^1$ and $A^2$ each independently represent an electron-withdrawing group, and
$B^{10}$ represents a group including a $\pi$ conjugated system.

[9] The photodetector element according to [8], wherein the n-type semiconductor material is a compound represented by Formula (IX):

$$A^1\text{-}(S^1)_{n1}\text{-}B^{11}\text{-}(S^2)_{n2}\text{-}A^2 \qquad \text{(IX)}$$

where

$A^1$ and $A^2$ are as defined above,
$S^1$ and $S^2$ each independently represent
a divalent carbocyclic group optionally having a substituent,
a divalent heterocyclic group optionally having a substituent,
a group represented by $-C(R^{s1})=C(R^{s2})-$, or
a group represented by $-C\equiv C-$,
$R^{s1}$ and $R^{s2}$ each independently represent a hydrogen atom or a substituent,
$B^{11}$ is a divalent group including a condensed ring formed through condensation of two or more ring structures selected from the group consisting of carbocyclic rings and heterocyclic rings, and represents a divalent group including no ortho-peri condensed structure and optionally having a substituent, and
n1 and n2 each independently represent an integer of 0 or more.

[10] The photodetector element according to [9], wherein $B^{11}$ is a divalent group including a condensed ring formed through condensation of two or more ring structures selected from the group consisting of structures represented by Formulae (Cy1) to (Cy9), and is a divalent group optionally having a substituent:

[Chemical Formula 6]

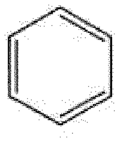 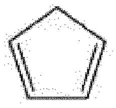

(Cy1) (Cy2)

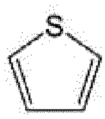 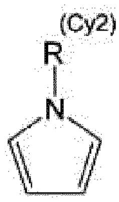 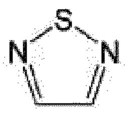 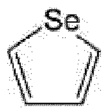 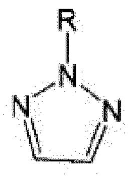

(Cy3) (Cy4) (Cy5) (Cy6) (Cy7)

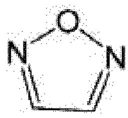 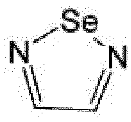

(Cy8) (Cy9)

where R is as defined above.

[11] The photodetector element according to [9] or [10], wherein $S^1$ and $S^2$ are each independently a group represented by Formula (s-1) or a group represented by Formula (s-2):

[Chemical Formula 7]

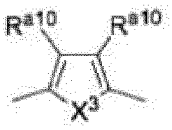 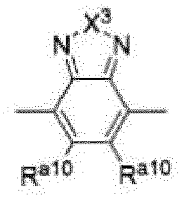

**(s-1)** **(s-2)**

where

$X^3$ represents an oxygen atom or a sulfur atom, and
$R^{a10}$ each independently represents a hydrogen atom, a halogen atom, or an alkyl group.

[12] The photodetector element according to any one of [8] to [11], wherein $A^1$ and $A^2$ are each independently a group represented by $-CH=C(-CN)_2$ and a group selected from the group consisting of groups represented by Formulae (a-1) to (a-9) :

[Chemical Formula 8]

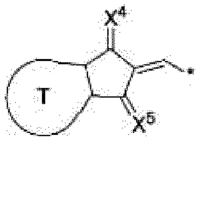

(a-1)

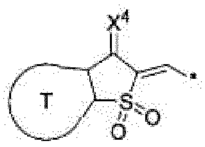

(a-2)

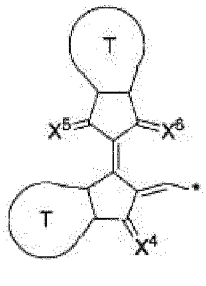

(a-3)

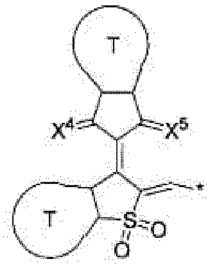

(a-4)

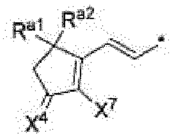

(a-5)

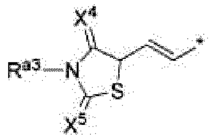

(a-6)

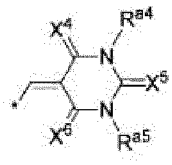

(a-7)

where

T is

a carbocyclic ring optionally having a substituent, or
a heterocyclic ring optionally having a substituent,

$X^4$, $X^5$, and $X^6$ each independently represent an oxygen atom, a sulfur atom, an alkylidene group, or a group represented by $=C(-CN)_2$,
$X^7$ represents a hydrogen atom, a halogen atom, a cyano group, an alkyl group optionally having a substituent, an alkyloxy group optionally having a substituent, an aryl group optionally having a substituent, or a monovalent heterocyclic group optionally having a substituent, and
$R^{a1}$, $R^{a2}$, $R^{a3}$, $R^{a4}$, and $R^{a5}$ each independently represent a hydrogen atom, an alkyl group optionally having a substituent, a halogen atom, an alkyloxy group optionally having a substituent, an aryl group optionally having a substituent, or a monovalent heterocyclic group;

[Chemical Formula 9]

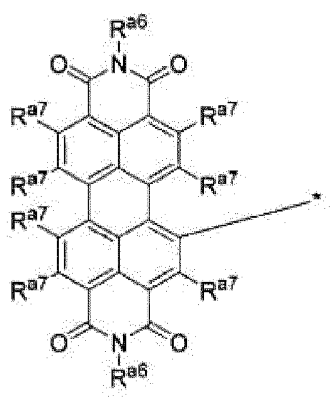

(a-8)

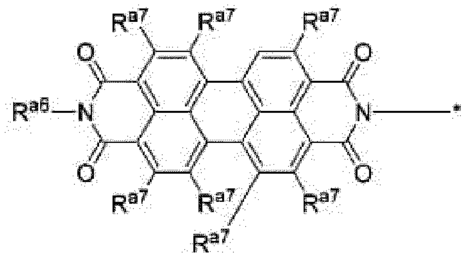

(a-9)

where

$R^{a6}$ and $R^{a7}$ each independently represent

a hydrogen atom,
a halogen atom,
an alkyl group optionally having a substituent,
a cycloalkyl group optionally having a substituent,
an alkyloxy group optionally having a substituent,
a cycloalkyloxy group optionally having a substituent,
a monovalent aromatic carbocyclic group optionally having a substituent, or
a monovalent aromatic heterocyclic group optionally having a substituent, and a plurality of $R^{a6}$s and $R^{a7}$s may be the same or different.

[13] The photodetector element according to any one of [1] to [7], wherein the n-type semiconductor material is a compound represented by Formula (X) or (XI):

[Chemical Formula 10]

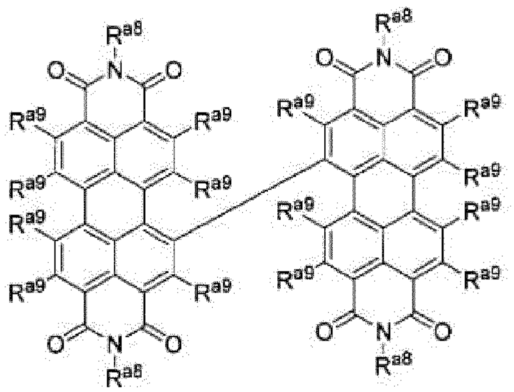

(X)

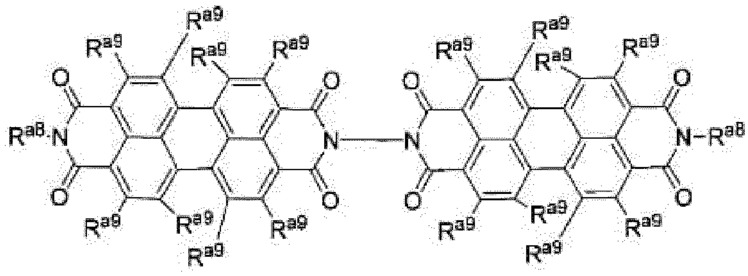

(XI)

where

$R^{a8}$ and $R^{a9}$ are each independently represent

a hydrogen atom,
a halogen atom,
an alkyl group optionally having a substituent,
a cycloalkyl group optionally having a substituent,
an alkyloxy group optionally having a substituent,
a cycloalkyloxy group optionally having a substituent,
a monovalent aromatic carbocyclic group optionally having a substituent, or
a monovalent aromatic heterocyclic group optionally having a substituent, and a plurality of $R^{a8}$s and $R^{a9}$s may be the same or different.

[14] The photodetector element according to [13], wherein the n-type semiconductor material is a compound represented by Formula N-5:

[Chemical Formula 11]

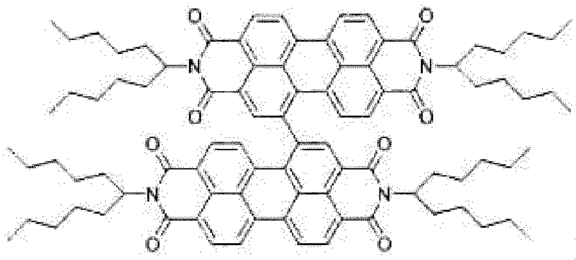

N-5

[15] A sensor including the photodetector element according to any one of [1] to [14].

[16] A biometric authentication device including the photodetector element according to any one of [1] to [14].

[17] An X-ray sensor including the photodetector element according to any one of [1] to [14].

[18] A near-infrared sensor including the photodetector element according to any one of [1] to [14].

[19] A composition containing: an n-type semiconductor material; and a p-type semiconductor material, wherein a value (ΔEA + ΔEB) of a sum of a value (ΔEA) obtained by subtracting an absolute value of an energy level of a HOMO of the p-type semiconductor material from an absolute value of an energy level of a HOMO of the n-type semiconductor material and a value (ΔEB) obtained by subtracting an absolute value of an energy level of a LUMO of the p-type semiconductor material from an absolute value of an energy level of a LUMO of the n-type semiconductor material is in a range of more than 0 and less than 0.88.

[20] An ink composition containing: the composition according to [19]; and a solvent.

EFFECT OF THE INVENTION

The photodetector element according to the present invention can further improve the specific detectivity.

BRIEF DESCRIPTION OF THE DRAWINGS

Fig. 1 is a schematic view illustrating a configuration example of a photodetector element.

Fig. 2 is a schematic view illustrating a configuration example of an image detection part.

Fig. 3 is a schematic view illustrating a configuration example of a fingerprint detection part.

MODE FOR CARRYING OUT THE INVENTION

Hereinafter, a photodetector element according to an embodiment of the present invention will be described with reference to drawings. Note that the drawings merely schematically show the shape, size, and arrangement of each component to the extent that the invention can be understood. The present invention is not limited to the descriptions below, and various changes and modifications can be appropriately made on each of the components without departing from the spirit and scope of the present invention. Further, the configurations according to an embodiment of the present invention are not necessarily produced or used in the arrangements illustrated in the drawings.

1. Explanation of common terms

First, terms used as a common meaning in the present specification will be described.

The "polymer compound" refers to a polymer having molecular weight distribution and having a number average molecular weight of $1 \times 10^3$ or more and $1 \times 10^8$ or less in terms of polystyrene. The constituent units contained in the polymer compound are 100 mol% in total.

The "constituent unit" refers to one or more units present in a polymer compound.

The "hydrogen atom" may be a light hydrogen atom or a heavy hydrogen atom.

The "halogen atom" includes a fluorine atom, a chlorine atom, a bromine atom, and an iodine atom.

The aspect "optionally having a substituent" includes both aspects of a case where all the hydrogen atoms constituting the compound or group are not substituted and a case where some or all of one or more hydrogen atoms are substituted with a substituent.

Examples of the "substituent" include a halogen atom, an alkyl group, a cycloalkyl group, an alkenyl group, a

cycloalkenyl group, an alkynyl group, a cycloalkynyl group, an alkyloxy group, a cycloalkyloxy group, an alkylthio group, a cycloalkylthio group, an aryl group, an aryloxy group, an arylthio group, a monovalent heterocyclic group, a substituted amino group, an acyl group, an imine residue, an amide group, an acid imide group, a substituted oxycarbonyl group, a cyano group, an alkylsulfonyl group, and a nitro group.

In the present specification, the "alkyl group" may be any of straight-chain, branched, or cyclic unless otherwise noted. The number of carbon atoms of the straight-chain alkyl group does not include the number of carbon atoms of the substituent, and is usually 1 to 50, preferably 1 to 30, and more preferably 1 to 20. The number of carbon atoms of each of the branched and cyclic alkyl groups does not include the number of carbon atoms of the substituent, and is usually 3 to 50, preferably 3 to 30, and more preferably 4 to 20.

Specific examples of the alkyl group include a methyl group, an ethyl group, an n-propyl group, an isopropyl group, an n-butyl group, an isobutyl group, a tert-butyl group, an n-pentyl group, an isoamyl group, a 2-ethyl butyl group, an n-hexyl group, a cyclohexyl group, an n-heptyl group, a cyclohexylmethyl group, a cyclohexylethyl group, an n-octyl group, a 2-ethylhexyl group, a 3-n-propylheptyl group, an adamantyl group, an n-decyl group, a 3,7-dimethyloctyl group, a 2-ethyloctyl group, a 2-n-hexyldecyl group, an n-dodecyl group, a tetradecyl group, a hexadecyl group, an octadecyl group, and an icosyl group.

The alkyl group may have a substituent. The alkyl group having a substituent is, for example, a group in which a hydrogen atom in the alkyl group exemplified above is substituted with a substituent such as an alkyloxy group, an aryl group, or a fluorine atom.

Specific examples of the alkyl having a substituent include a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group, and a 6-ethyloxyhexyl group.

The "cycloalkyl group" may be a monocyclic group or a polycyclic group. The cycloalkyl group may have a substituent. The number of carbon atoms of the cycloalkyl group does not include the number of carbon atoms of the substituent, and is usually 3 to 30, and preferably 12 to 19.

Examples of the cycloalkyl group include an alkyl group having no substituent, such as a cyclopentyl group, a cyclohexyl group, a cycloheptyl group, or an adamantyl group, and a group in which a hydrogen atom in these groups is substituted with a substituent such as an alkyl group, an alkyloxy group, an aryl group, or a fluorine atom.

Specific examples of the cycloalkyl group having a substituent include a methylcyclohexyl group and an ethylcyclohexyl group.

The "p-valent aromatic carbocyclic group" refers to a remaining atomic group in which p hydrogen atoms directly bonded to a carbon atom constituting a ring are removed from an aromatic hydrocarbon optionally having a substituent. The p-valent aromatic carbocyclic group may further have a substituent.

The "aryl group" is a monovalent aromatic carbocyclic group, and refers to a remaining atomic group in which one hydrogen atom directly bonded to a carbon atom constituting a ring is removed from an aromatic hydrocarbon optionally having a substituent.

The aryl group may have a substituent. Specific examples of the aryl group include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, a 4-phenylphenyl group, and a group in which a hydrogen atom in these groups is substituted with a substituent such as an alkyl group, an alkyloxy group, an aryl group, or a fluorine atom.

The "alkyloxy group" may be any of straight-chain, branched, and cyclic. The number of carbon atoms of the straight-chain alkyloxy group does not include the number of carbon atoms of the substituent, and is usually 1 to 40, and preferably 1 to 10. The number of carbon atoms of the branched or cyclic alkyloxy group does not include the number of carbon atoms of the substituent, and is usually 3 to 40, and preferably 4 to 10.

The alkyloxy group may have a substituent. Specific examples of the alkyloxy group include a methoxy group, an ethoxy group, an n-propyloxy group, an isopropyloxy group, an n-butyloxy group, an isobutyloxy group, a tert-butyloxy group, an n-pentyloxy group, an n-hexyloxy group, a cyclohexyloxy group, an n-heptyloxy group, an n-octyloxy group, a 2-ethylhexyloxy group, an n-nonyloxy group, an n-decyloxy group, a 3,7-dimethyloctyloxy group, a 3-heptyldodecyloxy group, a lauryloxy group, and a group in which a hydrogen atom in these groups is substituted with an alkyloxy group, an aryl group, or a fluorine atom.

The cycloalkyl group included in the "cycloalkyloxy group" may be a monocyclic group or a polycyclic group. The cycloalkyloxy group may have a substituent. The number of carbon atoms of the cycloalkyloxy group does not include the number of carbon atoms of the substituent, and is usually 3 to 30, and preferably 12 to 19.

Examples of the cycloalkyloxy group include a cycloalkyloxy group having no substituent, such as a cyclopentyloxy group, a cyclohexyloxy group, and a cycloheptyloxy group, and a group in which a hydrogen atom in these groups is substituted with a fluorine atom or an alkyl group.

The number of carbon atoms of the "aryloxy group" does not include the number of carbon atoms of the substituent, and is usually 6 to 60, and preferably 6 to 48.

The aryloxy group may have a substituent. Specific examples of the aryloxy group include a phenoxy group, a 1-naphthyloxy group, a 2-naphthyloxy group, a 1-anthracenyloxy group, a 9-anthracenyloxy group, a 1-pyrenyloxy group, and a group in which a hydrogen atom in these groups is substituted with a substituent such as an alkyl group, an alkyloxy group, or a fluorine atom.

The "alkylthio group" may be any of straight-chain, branched, and cyclic. The number of carbon atoms of the straight-chain alkylthio group does not include the number of carbon atoms of the substituent, and is usually 1 to 40, and preferably 1 to 10. The number of carbon atoms of the branched or cyclic alkylthio group does not include the number of carbon atoms of the substituent, and is usually 3 to 40, and preferably 4 to 10.

The alkylthio group may have a substituent. Specific examples of the alkylthio group include a methylthio group, an ethylthio group, a propylthio group, an isopropylthio group, a butylthio group, an isobutylthio group, a tert-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group, a laurylthio group, and a trifluoromethylthio group.

The cycloalkyl group included in the "cycloalkylthio group" may be a monocyclic group or a polycyclic group. The cycloalkylthio group may have a substituent. The number of carbon atoms of the cycloalkylthio group does not include the number of carbon atoms of the substituent, and is usually 3 to 30, and preferably 12 to 19.

Examples of the cycloalkylthio group optionally having a substituent include a cyclohexylthio group.

The number of carbon atoms of the "arylthio group" does not include the number of carbon atoms of the substituent, and is usually 6 to 60, and preferably 6 to 48.

The arylthio group may have a substituent. Examples of the arylthio group include a phenylthio group, a C1-C12 alkyloxyphenylthio group (C1-C12 represents that the number of carbon atoms of a group described immediately after this description is 1 to 12, the same applies hereinafter.), a C1-C12 alkylphenylthio group, a 1-naphthylthio group, a 2-naphthylthio group, and a pentafluorophenylthio group.

The "p-valent heterocyclic group" (p represents an integer of 1 or more.) refers to a remaining atomic group in which p hydrogen atoms among hydrogen atoms directly bonded to a carbon atom or heteroatom constituting a ring are removed from a heterocyclic compound optionally having a substituent.

The p-valent heterocyclic group may further have a substituent. The number of carbon atoms of the p-valent heterocyclic group does not include the number of carbon atoms of the substituent, and is usually 2 to 30, and preferably 2 to 6.

Examples of the substituent optionally included in the heterocyclic compound include a halogen atom, an alkyl group, an aryl group, an alkyloxy group, an aryloxy group, an alkylthio group, an arylthio group, a monovalent heterocyclic group, a substituted amino group, an acyl group, an imine residue, an amide group, an acid imide group, a substituted oxycarbonyl group, an alkenyl group, an alkynyl group, a cyano group, and a nitro group. The p-valent heterocyclic group includes a "p-valent aromatic heterocyclic group".

The "p-valent aromatic heterocyclic group" refers to a remaining atomic group in which p hydrogen atoms among hydrogen atoms directly bonded to a carbon atom or heteroatom constituting a ring are removed from an aromatic heterocyclic compound optionally having a substituent. The p-valent aromatic heterocyclic group may further have a substituent.

The aromatic heterocyclic compound includes compounds in which a heterocyclic ring itself exhibits no aromaticity but an aromatic ring is condensed to the heterocyclic ring, in addition to compounds in which a heterocyclic ring itself exhibits aromaticity.

Among the aromatic heterocyclic compounds, specific examples of the compound in which a heterocyclic ring itself exhibits aromaticity include oxadiazole, thiadiazole, thiazole, oxazole, thiophene, pyrrole, phosphole, furan, pyridine, pyrazine, pyrimidine, triazine, pyridazine, quinoline, isoquinoline, carbazole, and dibenzophosphole.

Among the aromatic heterocyclic compound, specific examples of the compound in which an aromatic heterocyclic ring itself exhibits no aromaticity and an aromatic ring is condensed to the heterocyclic ring include phenoxazine, phenothiazine, dibenzoborole, dibenzosilole, and benzopyran.

The number of carbon atoms of the monovalent heterocyclic group does not include the number of carbon atoms of the substituent, and is usually 2 to 60, and preferably 4 to 20.

The monovalent heterocyclic group may have a substituent, and specific examples of the monovalent heterocyclic group include a thienyl group, a pyrrolyl group, a furyl group, a pyridyl group, a piperidyl group, a quinolyl group, an isoquinolyl group, a pyrimidinyl group, a triazinyl group, and a group in which a hydrogen atom in these groups is substituted with an alkyl group, an alkyloxy group, or the like.

The "substituted amino group" refers to an amino group having a substituent. Examples of the substituent of the amino group include an alkyl group, an aryl group, and a monovalent heterocyclic group, and an alkyl group, an aryl group, or a monovalent heterocyclic group is preferable. The number of carbon atoms of the substituted amino group is usually 2 to 30.

Examples of the substituted amino group include dialkylamino groups such as a dimethylamino group and a

diethylamino group; and diarylamino groups such as a diphenylamino group, a bis(4-methylphenyl)amino group, a bis(4-tert-butylphenyl)amino group, and a bis(3,5-di-tert-butylphenyl)amino group.

The "acyl group" may have a substituent. The number of carbon atoms of the acyl group does not include the number of carbon atoms of the substituent, and is usually 2 to 20, and preferably 2 to 18. Specific examples of the acyl group include an acetyl group, a propionyl group, a butyryl group, an isobutyryl group, a pivaloyl group, a benzoyl group, a trifluoroacetyl group, and a pentafluorobenzoyl group.

The "imine residue" refers to a remaining atomic group in which one hydrogen atom directly bonded to a carbon atom or a nitrogen atom constituting a carbon atom-nitrogen atom double bond is removed from an imine compound. The "imine compound" refers to an organic compound having a carbon atom-nitrogen atom double bond in the molecule. Examples of the imine compound include aldimine, ketimine, and compounds in which a hydrogen atom bonded to a nitrogen atom constituting a carbon atom-nitrogen atom double bond in aldimine is substituted with an alkyl group or the like.

The number of carbon atoms of the imine residue is usually from 2 to 20, and preferably 2 to 18. Examples of the imine residue include groups represented by the following structural formulae.

[Chemical Formula 12]

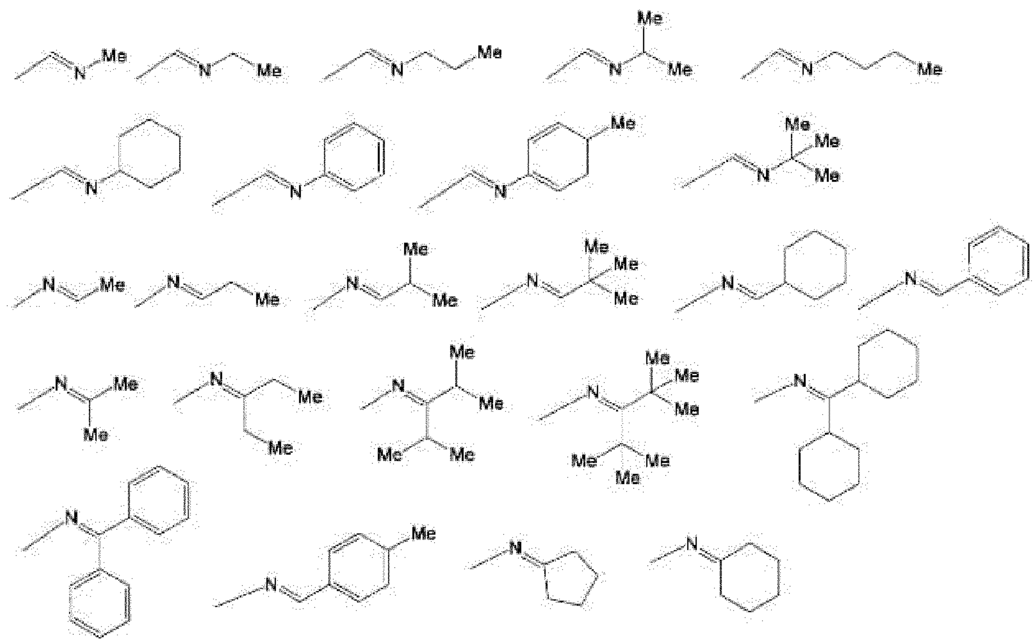

The "amide group" refers to a remaining atomic group in which one hydrogen atom bonded to a nitrogen atom is removed from amide. The number of carbon atoms of the amide group is usually 1 to 20, and preferably 1 to 18.

Specific examples of the amide group include a formamide group, an acetamide group, a propioamide group, a butyroamide group, a benzamide group, a trifluoroacetamide group, a pentafluorobenzamide group, a diformamide group, a diacetamide group, a dipropioamide group, a dibutyroamide group, a dibenzamide group, a ditrifluoroacetamide group, and a dipentafluorobenzamide group.

The "acid imide group" refers to a remaining atomic group in which one hydrogen atom bonded to a nitrogen atom is removed from acid imide. The number of carbon atoms of the acid imide group is usually 4 to 20. Specific examples of the acid imide group include groups represented by the following structural formulae.

[Chemical Formula 13]

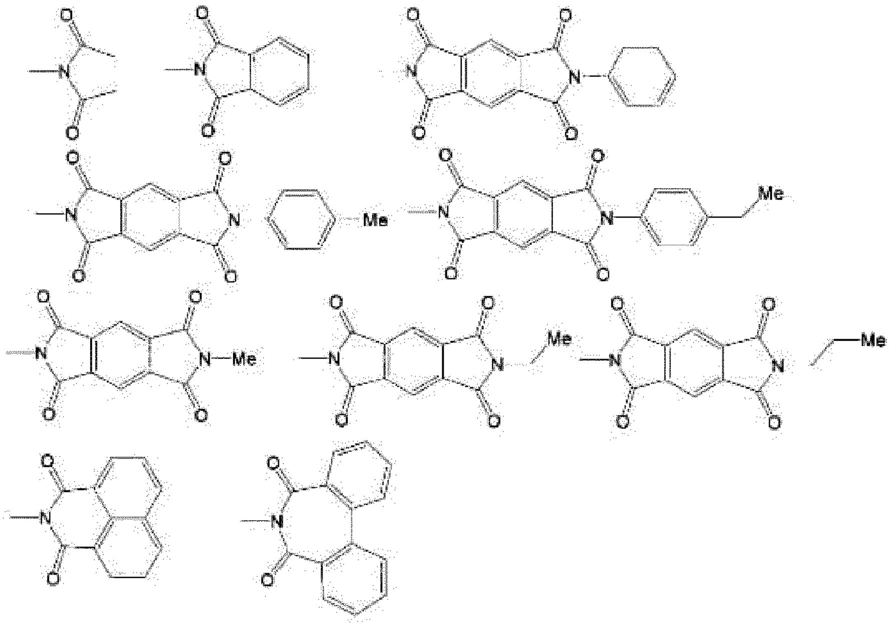

The "substituted oxycarbonyl group" refers to a group represented by R'-O-(C=O)-.

Here, R' represents an alkyl group, an aryl group, an arylalkyl group, or a monovalent heterocyclic group.

The number of carbon atoms of the substituted oxycarbonyl group does not include the number of carbon atoms of the substituent, and is usually 2 to 60, and preferably 2 to 48.

Specific examples of the substituted oxycarbonyl group include a methoxycarbonyl group, an ethoxycarbonyl group, a propoxycarbonyl group, an isopropoxycarbonyl group, a butoxycarbonyl group, an isobutoxycarbonyl group, a tert-butoxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a trifluoromethoxycarbonyl group, a pentafluoroethoxycarbonyl group, a perfluorobutoxycarbonyl group, a perfluorohexyloxycarbonyl group, a perfluorooctyloxycarbonyl group, a phenoxycarbonyl group, a naphthoxycarbonyl group, and a pyridyloxycarbonyl group.

The "alkenyl group" may be any of straight-chain, branched, and cyclic. The number of carbon atoms of the straight-chain alkenyl group does not include the number of carbon atoms of the substituent, and is usually 2 to 30, and preferably 3 to 20. The number of carbon atoms of the branched or cyclic alkenyl group does not include the number of carbon atoms of the substituent, and is usually 3 to 30, and preferably 4 to 20.

The alkenyl group may have a substituent. Specific examples of the alkenyl group include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and a group in which a hydrogen atom in these groups is substituted with an alkyl group, an alkyloxy group, an aryl group, or a fluorine atom.

The "cycloalkenyl group" may be a monocyclic group or a polycyclic group. The cycloalkenyl group may have a substituent. The number of carbon atoms of the cycloalkenyl group does not include the number of carbon atoms of the substituent, and is usually 3 to 30, and preferably 12 to 19.

Examples of the cycloalkenyl group include a cycloalkenyl group having no substituent, such as a cyclohexenyl group, and a group in which a hydrogen atom in these groups is substituted with an alkyl group, an alkyloxy group, an aryl group, or a fluorine atom.

Examples of the cycloalkenyl group having a substituent include a methylcyclohexenyl group and an ethylcyclohexenyl group.

The "alkynyl group" may be any of straight-chain, branched, and cyclic. The number of carbon atoms of the straight-chain alkenyl group does not include the number of carbon atoms of the substituent, and is usually 2 to 20, and preferably 3 to 20. The number of carbon atoms of the branched or cyclic alkenyl group does not include the number of carbon atoms of the substituent, and is usually 4 to 30, and preferably 4 to 20.

The alkynyl group may have a substituent. Specific examples of the alkynyl group include an ethynyl group, a 1-propynyl group, a 2-propynyl group, a 2-butynyl group, a 3-butynyl group, a 3-pentynyl group, a 4-pentynyl, a 1-hexenyl group, a 5-hexenyl group, and a group in which a hydrogen atom in these groups is substituted with an alkyloxy group, an aryl group, or a fluorine atom.

The "cycloalkynyl group" may be a monocyclic group or a polycyclic group. The cycloalkynyl group may have a substituent. The number of carbon atoms of the cycloalkynyl group does not include the number of carbon atoms of the substituent, and is usually 4 to 30, and preferably 12 to 19.

Examples of the cycloalkynyl group include a cycloalkynyl group having no substituent, such as a cyclohexynyl group, and a group in which a hydrogen atom in these groups is substituted with an alkyl group, an alkyloxy group, an aryl group, or a fluorine atom.

Examples of the cycloalkynyl group having a substituent include a methylcyclohexynyl group and an ethylcyclohexynyl group.

The "alkylsulfonyl group" may be straight-chain or branched. The alkylsulfonyl group may have a substituent. The number of carbon atoms of the alkylsulfonyl group does not include the number of carbon atoms of the substituent, and is usually 1 to 30. Specific examples of the alkylsulfonyl group include a methylsulfonyl group, an ethylsulfonyl group, and a dodecylsulfonyl group.

The symbol "*" attached to the chemical formula represents a bond.

The "ink composition" means a liquid composition used in a coating method, and is not limited to a colored liquid. The "coating method" includes a method of forming a film (layer) by using a liquid substance, and examples thereof include a slot die coating method, a slit coating method, a knife coating method, a spin coating method, a casting method, a micro gravure coating method, a gravure coating method, a bar coating method, a roll coating method, a wire bar coating method, a dip coating method, a spray coating method, a screen printing method, a gravure printing method, a flexo printing method, an offset printing method, an inkjet coating method, a dispenser printing method, a nozzle coating method, and a capillary coating method.

The ink composition may be a solution, a dispersion, or a dispersion such as an emulsion and a suspension.

The "absorption peak wavelength" is a parameter specified based on an absorption peak of an absorption spectrum measured in a predetermined wavelength range. The absorption peak wavelength is a wavelength of an absorption peak having the largest absorbance among absorption peaks of the absorption spectrum.

## 2. Photodetector element

As will be described later, the specific detectivity is proportional to a value obtained by dividing the external quantum efficiency (EQE) by the square root of $J_d$. Thus, the specific detectivity can be improved by reducing $J_d$ while the EQE is increased, but in general, improvement of the EQE and reduction in $J_d$ are in a trade-off relationship. In the present invention, by setting the HOMO and LUMO energies of the n-type semiconductor material and the p-type semiconductor material within predetermined ranges, Jd can be reduced while the EQE is increased. That is, it is considered that, by setting $\Delta EA + \Delta EB$ to a small range, the movement of electrons from the p-type semiconductor material to the n-type semiconductor material and the movement of holes from the n-type semiconductor material to the p-type semiconductor material can be minimized in a state where light is not emitted, and thus Jd is reduced.

Further, it is considered that, by setting $\Delta EA + \Delta EB$ to a small range, the difference between the LUMO of the p-type semiconductor material and the LUMO of the n-type semiconductor material is set to a small range, charge separation efficiently occurs at the pin interface during light absorption, resulting in improved EQE.

Here, possible configuration examples of the photodetector element of the present embodiment will be described. Fig. 1 is a schematic view illustrating a configuration of a photodetector element of the present embodiment.

As illustrated in Fig. 1, a photodetector element 10 is provided on a supporting substrate 11. The photodetector element 10 includes: a first electrode 12 provided in contact with the supporting substrate 11; an electron transportation layer 13 provided in contact with the first electrode 12; an active layer 14 provided in contact with the electron transportation layer 13; a hole transportation layer 15 provided in contact with the active layer 14; and a second electrode 16 provided in contact with the hole transportation layer 15.

In this configuration example, a sealing member 17 is further provided in contact with the second electrode 16.

In the first electrode 12, electrons are sent out to an external circuit. In the second electrode 16, electrons flow in from the external circuit.

Hereinafter, components that can be included in the photodetector element of the present embodiment will be specifically described.

### (Substrate)

The photodetector element is usually formed on a substrate (supporting substrate). Further, there is also a case where the photodetection element is sealed by a substrate (sealing substrate). One of a pair of electrodes is usually formed on the substrate.

The material of the substrate is not particularly limited particularly as long as the material does not chemically change in the formation of a layer containing an organic compound.

Examples of the material of the substrate include glass, plastic, a polymer film, and silicon. In a case where an opaque substrate is used, an electrode opposite to an electrode provided on the opaque substrate side (that is, an electrode provided far from the opaque substrate) is preferably a transparent or translucent electrode.

(Electrode)

The photodetector element includes a first electrode and a second electrode which are a pair of electrodes. At least one of the pair of electrodes is preferably a transparent or translucent electrode in order to allow light to enter.

Examples of the material of the transparent or translucent electrode include a conductive metal oxide film, and a translucent metal thin film. Specific examples thereof include conductive materials such as indium oxide, zinc oxide, tin oxide, and indium tin oxide (ITO), indium zinc oxide (IZO), and NESA which are composites thereof, gold, platinum, silver, and copper. As the material of the transparent or translucent electrode, ITO, IZO, and zinc oxide are preferable. Also, a transparent conductive film formed by using, as a material, an organic compound such as polyaniline and a derivative thereof, and polythiophene and a derivative thereof may be used as the electrode. The transparent or translucent electrode may be the first electrode or the second electrode.

If one of the pair of electrodes is transparent or translucent, the other electrode may be an electrode with low light transmittance. Examples of the material of the electrode with low light transmittance include a metal, and a conductive polymer. Specific examples of the material of the electrode with low light transmittance include metals such as lithium, sodium, potassium, rubidium, cesium, magnesium, calcium, strontium, barium, aluminum, scandium, vanadium, zinc, yttrium, indium, cerium, samarium, europium, terbium, and ytterbium; and alloys of two or more types of these metals, or alloys of one or more types of these metals and one or more types of metal selected from the group consisting of gold, silver, platinum, copper, manganese, titanium, cobalt, nickel, tungsten, and tin; graphite; graphite intercalation compounds; polyaniline and derivatives thereof; and polythiophene and derivatives thereof. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy. Hereinafter, a description will be made on the assumption that the first electrode is an anode and the second electrode is a cathode.

(Active layer)

The active layer contains a p-type semiconductor material (electron donating compound) and an n-type semiconductor material (electron accepting compound).

The thickness of the active layer of the photodetector element of the present embodiment is preferably 200 nm or more, more preferably 250 nm or more, and still more preferably 350 nm or more, particularly, from the viewpoint of further reducing dark current. The thickness of the active layer is preferably 10 $\mu$m or less, more preferably 5 $\mu$m or less, and still more preferably 1 $\mu$m or less.

In the active layer, which one of the p-type semiconductor material and the n-type semiconductor material functions can be relatively determined from the value of the energy level of the HOMO or the value of the energy level of the LUMO of the selected compound (polymer). The relationship between the values of the energy levels of the HOMO and LUMO of the p-type semiconductor material contained in the active layer and the values of the energy levels of the HOMO and LUMO of the n-type semiconductor material contained in the active layer can be appropriately set within a range in which the photodetector element operates.

In the present embodiment, as described above, the p-type semiconductor material and the n-type semiconductor material contained in the active layer satisfy a relationship ($0 < \Delta EA + \Delta EB < 0.88$) where the value ($\Delta EA + \Delta EB$) of the sum of the value ($\Delta EA$) obtained by subtracting the absolute value of the energy level of the HOMO of the p-type semiconductor material from the absolute value of the energy level of the HOMO of the n-type semiconductor material and the value ($\Delta EB$) obtained by subtracting the absolute value of the energy level of the LUMO of the p-type semiconductor material from the absolute value of the energy level of the LUMO of the n-type semiconductor material is in a range of more than 0 and less than 0.88. The value ($\Delta EA + \Delta EB$) of the sum is preferably in a range of 0.20 to 0.67.

The values of the energy levels of the HOMO and the LUMO of the p-type semiconductor material and the n-type semiconductor material are usually negative values. In the present embodiment, the absolute values of values of the energy levels of the HOMO and the LUMO are used in the calculation of $\Delta EA$, $\Delta EB$, and $\Delta EA + \Delta EB$.

As the value of the energy level of the HOMO in the polymer, a value measured by ultraviolet photoelectron spectroscopy (UPS method) can be used. Here, the UPS method refers to a method of irradiating a solid surface to be measured with ultraviolet rays, measuring the number of photoelectrons emitted in response to the energy of the ultraviolet rays emitted to the solid surface, calculating the minimum energy generated by the photoelectrons, and estimating the work function in the case of a metal and the value of the energy level of the HOMO in the case of a semiconductor from the minimum energy. Ultraviolet photoelectron spectroscopy can be performed by a photoelectron spectrometer in the air.

In the present embodiment, examples of a p-type semiconductor material and an n-type semiconductor material

that can be suitably used will be described below.

(1) p-type semiconductor material

The p-type semiconductor material used for the photodetector element of the present embodiment is preferably a polymer compound having a predetermined weight average molecular weight in terms of polystyrene.

Here, the weight average molecular weight in terms of polystyrene refers to the weight average molecular weight calculated by using gel permeation chromatography (GPC) using a polystyrene as a standard sample.

The weight average molecular weight of the p-type semiconductor material in terms of polystyrene is preferably 3,000 or more and 500,000 or less particularly from the viewpoint of improving solubility in a solvent.

In the present embodiment, the p-type semiconductor material is preferably a $\pi$-conjugated polymer compound (also referred to as a D-A type conjugated polymer compound) containing a donor constituent unit (also referred to as a D constituent unit) and an acceptor constituent unit (also referred to as an A constituent unit). Whether it is an A constituent unit or a D constituent unit can be relatively determined from the energy level of the HOMO or the LUMO.

Here, the donor constituent unit is a constituent unit in which $\pi$ electrons are excessive, and the acceptor constituent unit is a constituent unit in which $\pi$ electrons are deficient.

In the present embodiment, the constituent unit that can constitute the p-type semiconductor material includes a constituent unit in which a donor constituent unit and an acceptor constituent unit are directly bonded, and further includes a constituent unit in which a donor constituent unit and an acceptor constituent unit are bonded via any preferred spacer (group or constituent unit).

Specific examples of the p-type semiconductor material which is a polymer compound include polyvinylcarbazole and derivatives thereof, polysilane and derivatives thereof, polysiloxane derivatives including an aromatic amine structure in a side chain or the main chain, polyaniline and derivatives thereof, polythiophene and derivatives thereof, polypyrrole and derivatives thereof, polyphenylene vinylene and derivatives thereof, polythienylene vinylene and derivatives thereof, and polyfluorene and derivatives thereof.

The p-type semiconductor material of the present embodiment is preferably a polymer compound containing a constituent unit represented by the following Formula (I). In the present embodiment, the constituent unit represented by the following Formula (I) is usually a donor constituent unit.

[Chemical Formula 14]

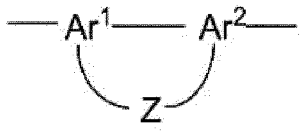

(I)

In Formula (I),

Ar¹ and Ar² represent a trivalent aromatic heterocyclic group optionally having a substituent or a trivalent aromatic carbocyclic group optionally having a substituent, and
Z represents a group represented by Formulae (Z-1) to (Z-7).

[Chemical Formula 15]

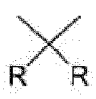
(Z-1)

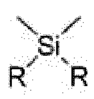
(Z-2)

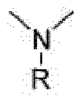
(Z-3)

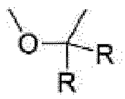
(Z-4)

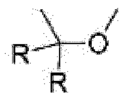
(Z-5)

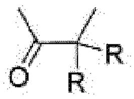
(Z-6)

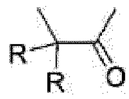
(Z-7)

In Formulae (Z-1) to (Z-7), R represents a hydrogen atom, a halogen atom, an alkyl group optionally having a substituent, an aryl group optionally having a substituent, a cycloalkyl group optionally having a substituent, an alkyloxy group optionally having a substituent, a cycloalkyloxy group optionally having a substituent, an aryloxy group optionally having a substituent, an alkylthio group optionally having a substituent, a cycloalkylthio group optionally having a substituent, an arylthio group optionally having a substituent, a monovalent heterocyclic group optionally having a substituent, a substituted amino group optionally having a substituent, an imine residue optionally having a substituent, an amide group optionally having a substituent, an acid imide group optionally having a substituent, a substituted oxycarbonyl group optionally having a substituent, an alkenyl group optionally having a substituent, a cycloalkenyl group optionally having a substituent, an alkynyl group optionally having a substituent, a cycloalkynyl group optionally having a substituent, a cyano group, a nitro group, a group represented by -C(=O)-$R^a$, or a group represented by -$SO_2$-$R^b$. Here, $R^a$ and $R^b$ each independently represent a hydrogen atom, an alkyl group optionally having a substituent, an aryl group optionally having a substituent, an alkyloxy group optionally having a substituent, an aryloxy group optionally having a substituent, or a monovalent heterocyclic group optionally having a substituent.

Each of the aromatic carbocyclic ring and the aromatic heterocyclic ring that can constitute $Ar^1$ and $Ar^2$ may be a monocyclic ring or a condensed ring. When the aromatic carbocyclic ring or the aromatic heterocyclic ring is a condensed ring, all of the rings constituting the condensed ring may be a condensed ring having aromaticity, or only a part thereof may be a condensed ring having aromaticity. When these rings have a plurality of substituents, these substituents may be the same or different.

Specific examples of the aromatic carbocyclic ring that can constitute $Ar^1$ and $Ar^2$ include a benzene ring, a naphthalene ring, an anthracene ring, a tetracene ring, a pentacene ring, a pyrene ring, and a phenanthrene ring. The aromatic carbocyclic ring is preferably a benzene ring and a naphthalene ring, more preferably a benzene ring and a naphthalene ring, and still more preferably a benzene ring. These rings may have a substituent.

The aromatic heterocyclic ring that can constitute $Ar^1$ and $Ar^2$ include a ring in which a heterocyclic ring itself constituting the ring exhibits no aromaticity but an aromatic ring is condensed to the heterocyclic ring, in addition to a monocyclic ring and a condensed ring in which a heterocyclic ring itself exhibits aromaticity.

Specific examples of the aromatic heterocyclic ring include ring structures of the above-described compounds as the aromatic heterocyclic compound, and include an oxadiazole ring, a thiadiazole ring, a thiazole ring, an oxazole ring, a thiophene ring, a pyrrole ring, a phosphole ring, a furan ring, a pyridine ring, a pyrazine ring, a pyrimidine ring, a triazine ring, a pyridazine ring, a quinoline ring, an isoquinoline ring, a carbazole ring, and a dibenzophosphole ring, and a phenoxazine ring, a phenothiazine ring, a dibenzoborole ring, a dibenzosilole ring, and a benzopyran ring. These rings may have a substituent.

As the combination of $Ar^1$ and $Ar^2$, both $Ar^1$ and $Ar^2$ are preferably an aromatic carbocyclic ring optionally having a substituent (for example, a benzene ring) or an aromatic heterocyclic ring optionally having a substituent (for example, a thiophene ring).

The constituent unit represented by Formula (I) is preferably a constituent unit represented by the following Formula (II) or (III). In other words, the p-type semiconductor material of the present embodiment is preferably a polymer compound containing a constituent unit represented by the following Formula (II) or (III).

[Chemical Formula 16]

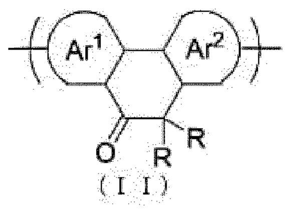

(II)

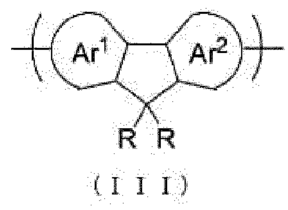

(III)

In Formulae (II) and (III), $Ar^1$, $Ar^2$, and R are as defined above.

Examples of preferred constituent units represented by Formulae (I) and (III) include constituent units represented by the following Formulae (097) to (100).

[Chemical Formula 17]

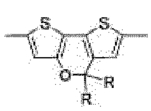

(097)

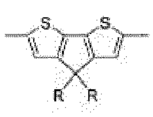

(098)

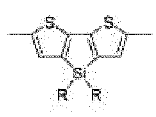

(099)

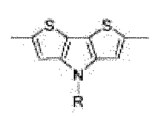

(100)

In Formulae (097) to (100), R is as defined above. When there are two Rs, the two Rs may be the same or different.

The constituent unit represented by Formula (II) is preferably a constituent unit represented by the following Formula (IV). In other words, the p-type semiconductor material of the present embodiment is preferably a polymer compound containing a constituent unit represented by the following Formula (IV).

[Chemical Formula 18]

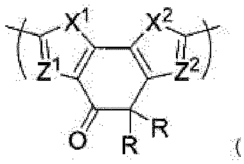
(IV)

In Formula (IV), $X^1$ and $X^2$ are each independently a sulfur atom or an oxygen atom, $Z^1$ and $Z^2$ are each independently a group represented by =C(R)- or a nitrogen atom, and R is as defined above.

The constituent unit represented by Formula (IV) is preferably a constituent unit in which $X^1$ and $X^2$ are a sulfur atom, and $Z^1$ and $Z^2$ are a group represented by = C(R)-.

Examples of preferred constituent units represented by Formula (IV) include constituent units represented by the following Formulae (IV-1) to (IV-16).

[Chemical Formula 19]

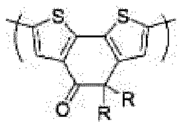
(IV-1)
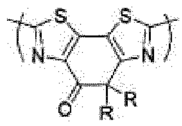
(IV-2)
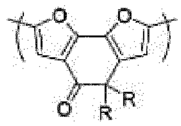
(IV-3)
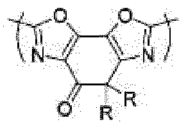
(IV-4)
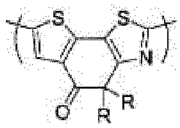
(IV-5)
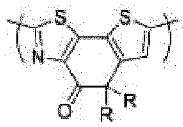
(IV-6)
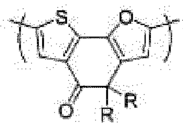
(IV-7)
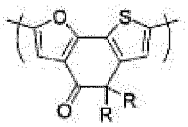
(IV-8)
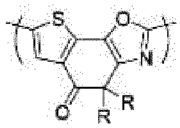
(IV-9)
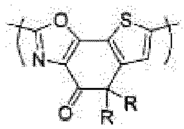
(IV-10)
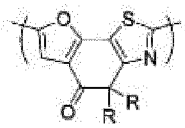
(IV-11)
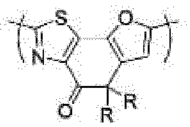
(IV-12)
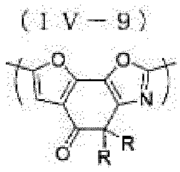
(IV-13)
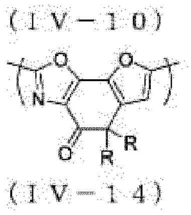
(IV-14)
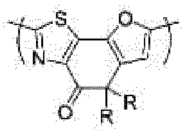
(IV-15)
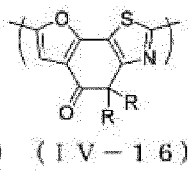
(IV-16)

The constituent unit represented by Formula (IV) is preferably a constituent unit in which $X^1$ and $X^2$ are a sulfur atom, and $Z^1$ and $Z^2$ are a group represented by = C(R)-.

The constituent unit represented by Formula (III) may be a constituent unit represented by the following Formula (V) .

[Chemical Formula 20]

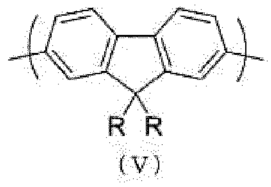

(V)

In Formula (V), R is as defined above.

The p-type semiconductor material of the present embodiment preferably contains a constituent unit represented by the following Formula (VI). In the present embodiment, the constituent unit represented by the following Formula (VI) is usually an acceptor constituent unit.

[Chemical Formula 21]

$—Ar^3—$ (VI)

In Formula (V), $Ar^3$ represents a divalent aromatic heterocyclic group.

The number of carbon atoms of the divalent aromatic heterocyclic group represented by $Ar^3$ is usually 2 to 60, preferably 4 to 60, and more preferably 4 to 20. The divalent aromatic heterocyclic group represented by $Ar^3$ may have a substituent. Examples of the substituent optionally included in the divalent aromatic heterocyclic group represented by $Ar^3$ include a halogen atom, an alkyl group, an aryl group, an alkyloxy group, an aryloxy group, an alkylthio group, an arylthio group, a monovalent heterocyclic group, a substituted amino group, an acyl group, an imine residue, an amide group, an acid imide group, a substituted oxycarbonyl group, an alkenyl group, an alkynyl group, a cyano group, and a nitro group.

Examples of the constituent unit represented by Formula (VI) are preferably constituent units represented by the following Formulae (VI-1) to (VI-7).

[Chemical Formula 22]

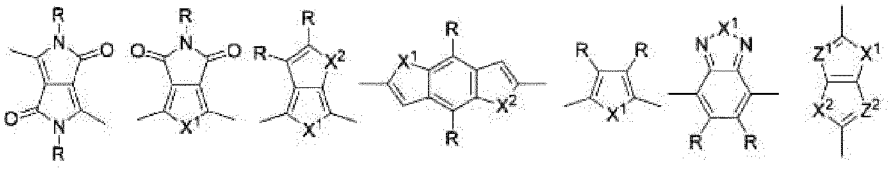

(VI-1) (VI-2) (VI-3) (VI-4) (VI-5) (VI-6) (VI-7)

In Formulae (VI-1) to (VI-7), $X^1$, $X^2$, $Z^1$, $Z^2$, and R are as defined above. When there are two Rs, the two Rs may be the same or different.

$X^1$ and $X^2$ in Formulae (VI-1) to (VI-7) are both preferably a sulfur atom from the viewpoint of availability of raw material compounds.

The p-type semiconductor material is preferably a $\pi$-conjugated polymer compound that contains a constituent unit containing a thiophene backbone, and contains a $\pi$ conjugated system.

Examples of the divalent aromatic heterocyclic group represented by $Ar^3$ include groups represented by the following Formulae (101) to (186).

[Chemical Formula 23]

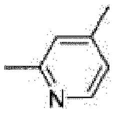
(101)

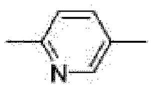
(102)

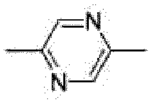
(103)

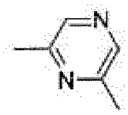
(104)

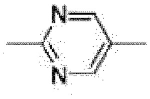
(105)

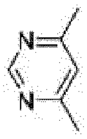
(106)

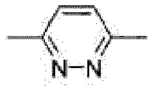
(107)

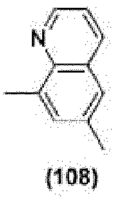
(108)

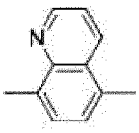
(109)

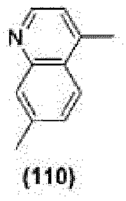
(110)

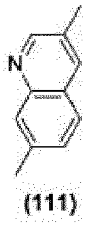
(111)

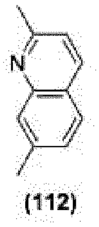
(112)

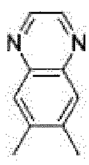
(113)

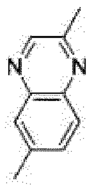
(114)

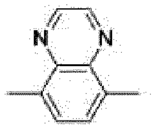
(115)

[Chemical Formula 24]

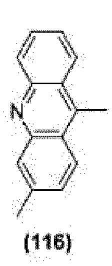
(116)
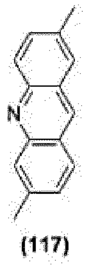
(117)
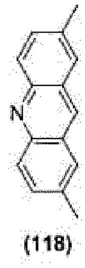
(118)
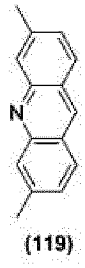
(119)

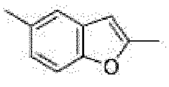
(120)
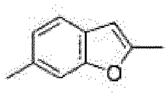
(121)
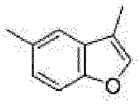
(122)
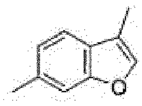
(123)

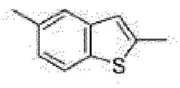
(124)
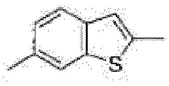
(125)
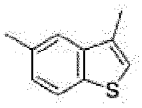
(126)
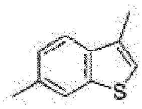
(127)

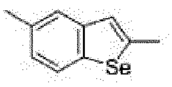
(128)
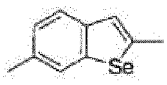
(129)
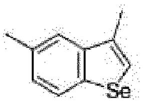
(130)
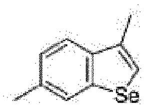
(131)

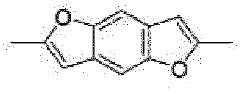
(132)
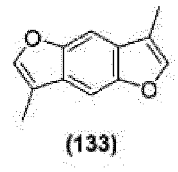
(133)
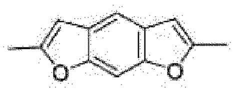
(134)
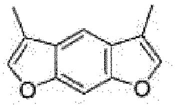
(135)

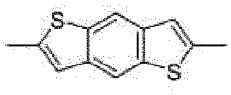
(136)
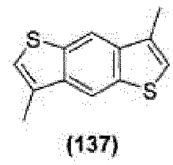
(137)
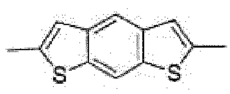
(138)
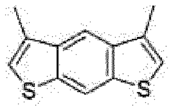
(139)

[Chemical Formula 25]

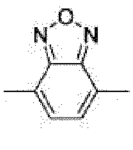
(140)
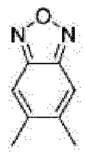
(141)
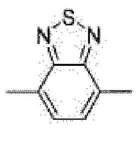
(142)
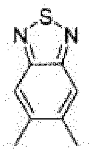
(143)
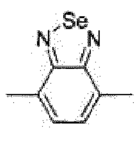
(144)
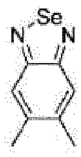
(145)

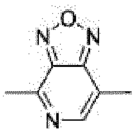
(146)
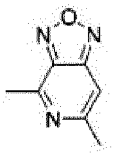
(147)
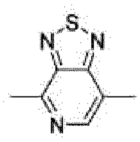
(148)
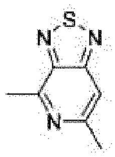
(149)
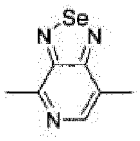
(150)
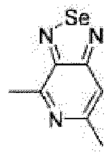
(151)

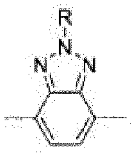
(152)
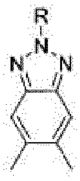
(153)
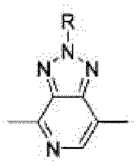
(154)
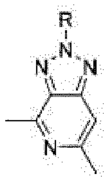
(155)

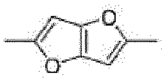
(156)
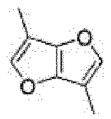
(157)
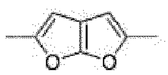
(158)
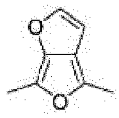
(159)

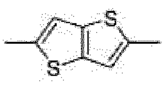
(160)
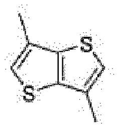
(161)
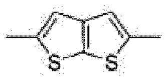
(162)
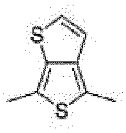
(163)

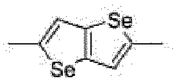
(164)
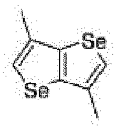
(165)
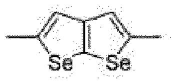
(166)
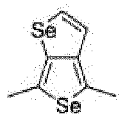
(167)

[Chemical Formula 26]

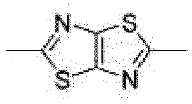
(168)
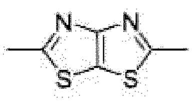
(169)
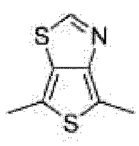
(170)
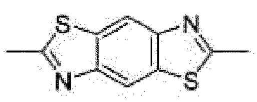
(171)
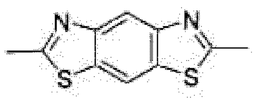
(172)
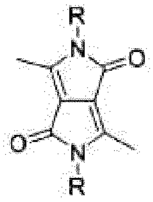
(173)
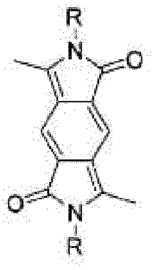
(174)
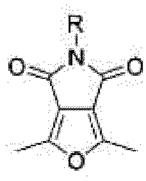
(175)
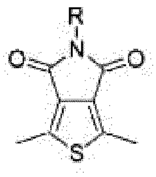
(176)
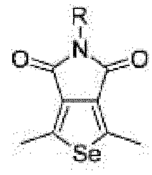
(177)
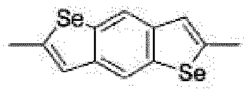
(178)
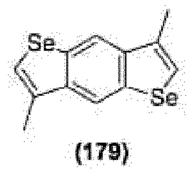
(179)
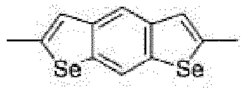
(180)
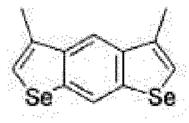
(181)
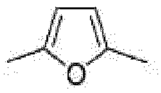
(182)
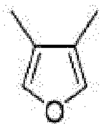
(183)
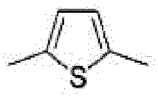
(184)
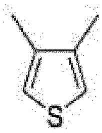
(185)
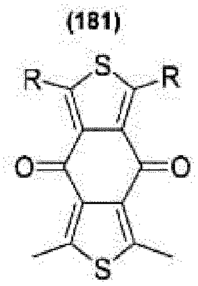
(186)

In Formulae (101) to (186), R represents the same meaning as described above. When there are a plurality of Rs, the plurality of Rs may be the same or different.

The polymer compound which is a p-type semiconductor material of the present embodiment is preferably a π-conjugated polymer compound containing a constituent unit represented by Formula (I) as a donor constituent unit and containing a constituent unit represented by Formula (VI) as an acceptor constituent unit.

The polymer compound which is a p-type semiconductor material may contain two or more types of constituent units represented by Formula (I), or may contain two or more types of constituent units represented by Formula (VI).

For example, the polymer compound which is a p-type semiconductor material may contain a constituent unit represented by the following Formula (VII) in order to improve the solubility in a solvent.

[Chemical Formula 27]

$$-Ar^4- \quad (VII)$$

In Formula (VII), $Ar^4$ represents an arylene group.

The "arylene group" represented by $Ar^4$ refers to a remaining atomic group in which two hydrogen atoms are removed from an aromatic hydrocarbon optionally having a substituent. The aromatic hydrocarbon includes compounds having a condensed ring, and compounds in which two or more selected from the group consisting of independent benzene rings and condensed rings are directly bonded or bonded via a divalent group such as a vinylene group.

Examples of the substituent optionally included in the aromatic hydrocarbon include substituents same as those exemplified as a substituent optionally included in the heterocyclic compound.

The number of carbon atoms of a moiety excluding the substituent in the arylene group is usually 6 to 60, and preferably 6 to 20. The number of carbon atoms of the arylene group including the substituent is usually 6 to 100.

Examples of the arylene group include phenylene groups (for example, the following Formulae 1 to 3), naphthalenediyl groups (for example, the following Formulae 4 to 13), anthracendiyl groups (for example, the following Formulae 14 to 19), biphenyldiyl groups (for example, the following Formulae 20 to 25), terphenyldiyl groups (for example, the following Formulae 26 to 28), condensed-ring compound groups (for example, the following Formulae 29 to 35), fluorenediyl groups (for example, the following Formulae 36 to 38), and benzofluorenediyl groups (for example, the following Formulae 39 to 46).

[Chemical Formula 28]

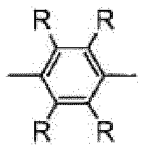
1

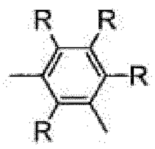
2

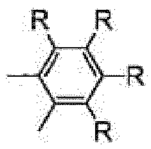
3

[Chemical Formula 29]

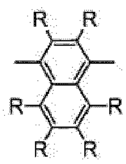
4

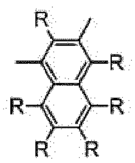
5

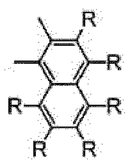
6

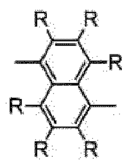
7

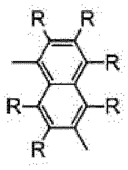
8

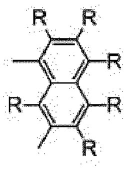
9

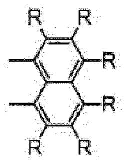
10

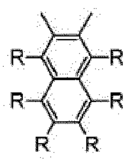
11

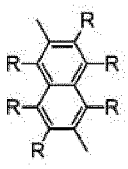
12

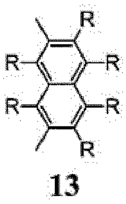
13

[Chemical Formula 30]

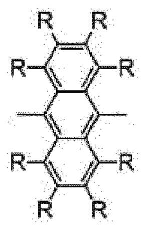
14

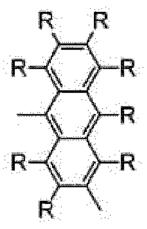
15

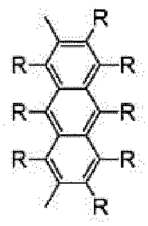
16

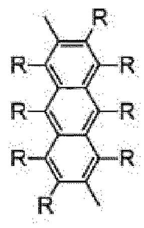
17

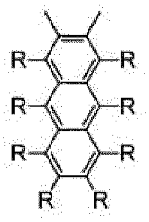
18

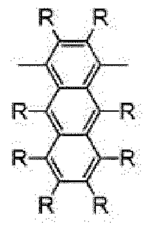
19

[Chemical Formula 31]

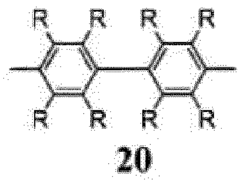
20

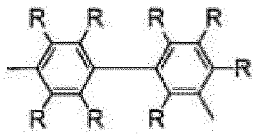
21

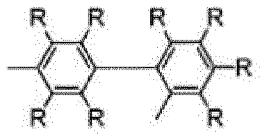
22

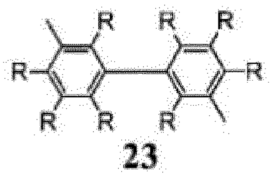
23

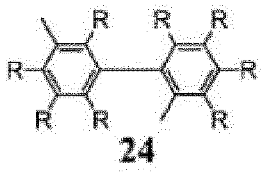
24

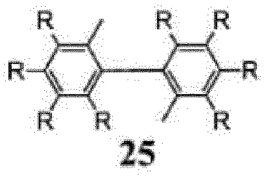
25

[Chemical Formula 32]

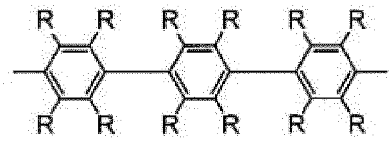
26

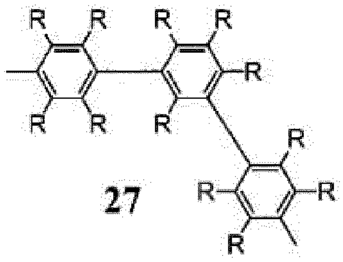
27

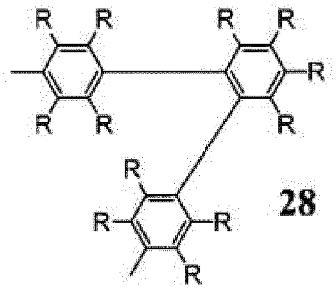
28

[Chemical Formula 33]

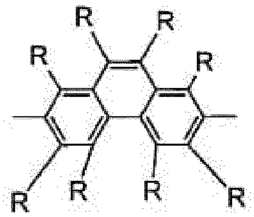
29

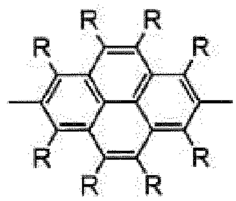
30

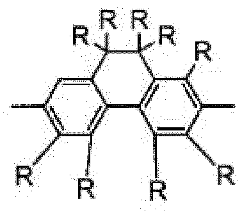
31

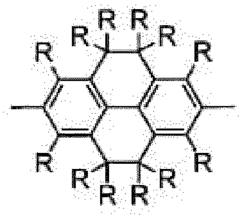
32

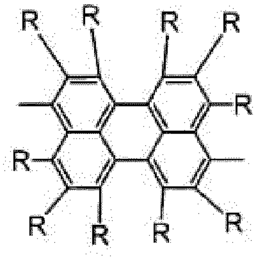
33

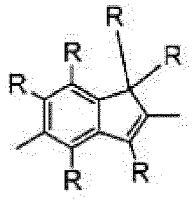
34

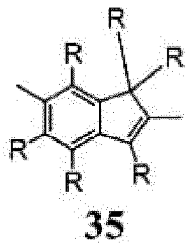
35

[Chemical Formula 34]

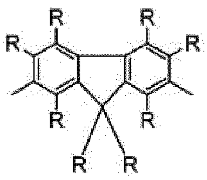
36

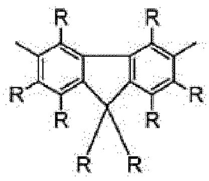
37

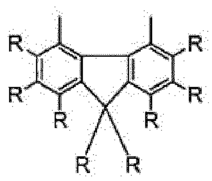
38

[Chemical Formula 35]

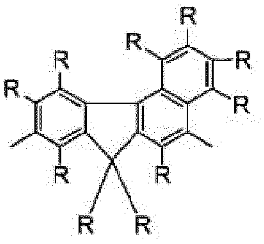
39

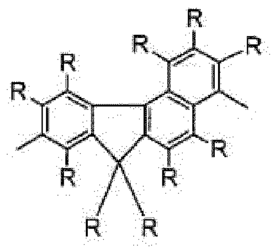
40

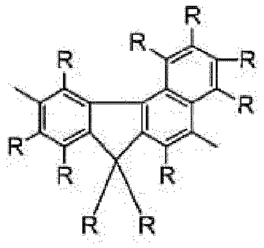
41

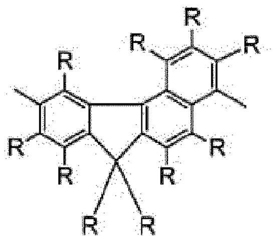
42

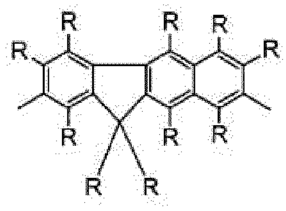
43

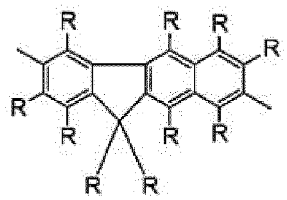
44

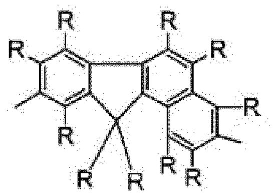
45

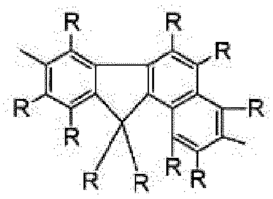
46

In the formulae, R is as defined above. When there are a plurality of Rs, the plurality of Rs may be the same or different.

The constituent unit constituting the polymer compound which is a p-type semiconductor material may be a constituent unit in which two or more types of constituent units selected from the above-described constituent units are combined and linked.

As the constituent unit in which two or more types of constituent units are combined and linked, a constituent unit represented by the following Formula (VI-8) is preferable.

[Chemical Formula 36]

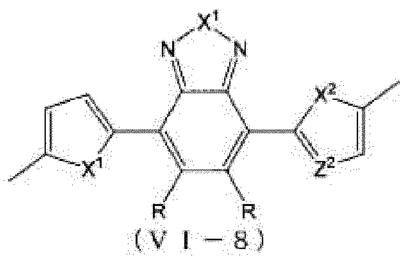
(VI-8)

In Formula (VI-8), $X^1$, $X^2$, $Z^1$, $Z^2$, and R are as defined above. Two Rs may be the same or different.

Specific examples of the constituent unit represented by Formula (VI-8) include a constituent unit represented by the following Formula (VI-8-1).

[Chemical Formula 37]

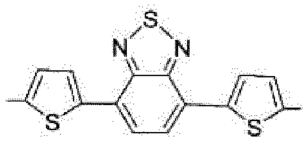

(VI-8-1)

In a case where the polymer compound as a p-type semiconductor material contains the constituent unit represented by Formula (I) and/or the constituent unit represented by Formula (VI), the total amount of the constituent unit represented by Formula (I) and the constituent unit represented by Formula (VI) is usually 20 mol% to 100 mol% when the amount of all constituent units contained in the polymer compound is100 mol%. The total amount is preferably 40 mol% to 100 mol%, and more preferably 50 mol% to 100 mol% because the charge transportability as the p-type semiconductor material can be improved.

Specific examples of the polymer compound which is a p-type semiconductor material in the present embodiment include polymer compounds represented by the following Formulae P-1 to P-7.

[Chemical Formula 38]

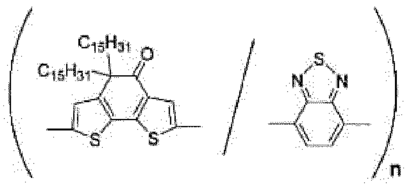

(50:50;mol% )

P − 1

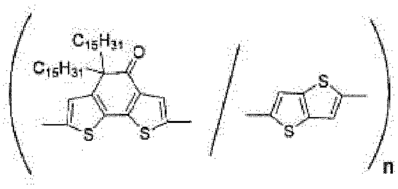

(50:50;mol% )

P − 2

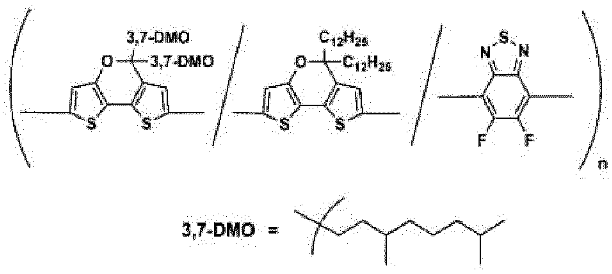

(25:25:50;mol% )

P − 3

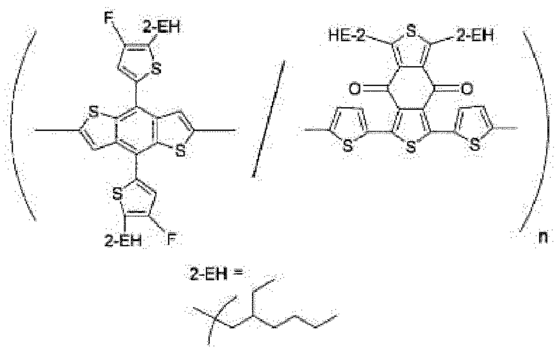

(50:50;mol% )

P − 4

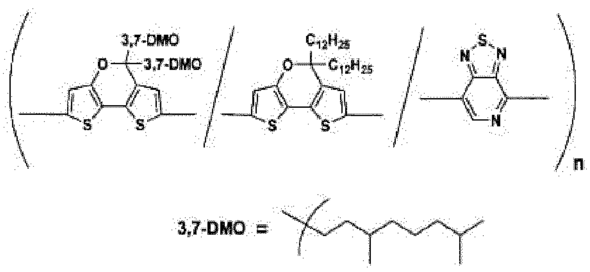

(25:25:50;mol% )

P − 5

[Chemical Formula 39]

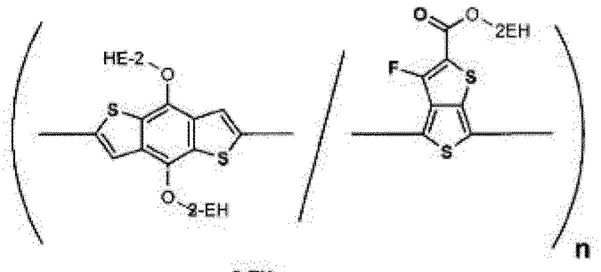

(50:50;mol% )

2-EH =

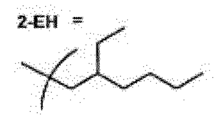

P − 6

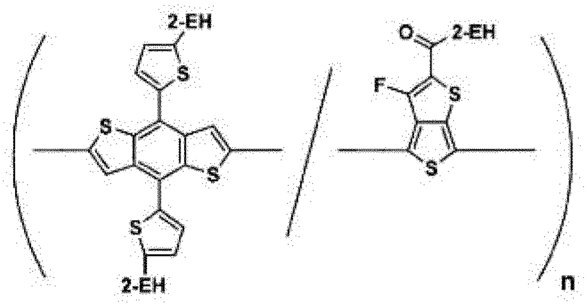

(50:50;mol% )

2-EH =

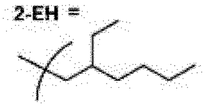

P − 7

The active layer may contain only one type of p-type semiconductor material, or may contain a combination of two or more types at any preferred ratio.

(2) n-type semiconductor material

The n-type semiconductor material of the present embodiment may be a low molecular weight compound or a high molecular weight compound (polymer compound).

The active layer may contain only one type of n-type semiconductor material, or may contain a combination of two or more types at any ratio.

Examples of the n-type semiconductor material (electron accepting compound) which is a low molecular weight compound include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, and phenanthrene derivatives such as bathocuproine.

Examples of the n-type semiconductor material which is a polymer compound include polyvinylcarbazole and derivatives thereof, polysilane and derivatives thereof, polysiloxane derivatives having an aromatic amine structure in a side chain or the main chain, polyaniline and derivatives thereof, polythiophene and derivatives thereof, polypyrrole and derivatives thereof, polyphenylene vinylene and derivatives thereof, polythienylene vinylene and derivatives thereof, polyquinoline and derivatives thereof, polyquinoxaline and derivatives thereof, and polyfluorene and derivatives thereof.

The n-type semiconductor material that can be contained in the active layer of the present embodiment contains a compound that is neither fullerene nor a fullerene derivative as described above. As such a compound, many compounds are known, and commercially available.

The n-type semiconductor material of the present embodiment is preferably a compound that contains a moiety DP having an electron donating property and a moiety AP having an electron accepting property.

The compound containing a moiety DP and a moiety AP (hereinafter, the compound is referred to as a DP-AP compound), which is an n-type semiconductor material, more preferably contains a pair or more atoms in which the moieties DP in the DP-AP compound are n-bonded to each other.

A moiety that does not include any of a ketone structure, a sulfoxide structure, and a sulfone structure in such a compound can be a moiety DP. Examples of the moiety AP include a moiety including a ketone structure.

The n-type semiconductor material of the present embodiment is preferably a compound represented by the following Formula (VIII).

$$A^1\text{-}B^{10}\text{-}A^2 \qquad \text{(VIII)}$$

In Formula (VIII), $A^1$ and $A^2$ each independently represent an electron-withdrawing group, and $B^{10}$ represents a group including a $\pi$ conjugated system. $A^1$ and $A^2$ correspond to the moiety AP having an electron accepting property, and $B^{10}$ corresponds to the moiety DP having an electron donating property.

The "$\pi$ conjugated system" means a system in which $\pi$ electrons are delocalized in a plurality of bonds.

Examples of the electron-withdrawing group which is $A^1$ and $A^2$ include a group represented by $-CH=C(-CN)_2$ and groups represented by the following Formulae (a-1) to (a-9) .

[Chemical Formula 40]

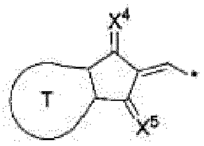

(a-1)

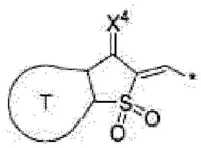

(a-2)

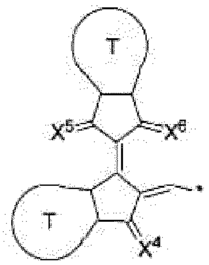

(a-3)

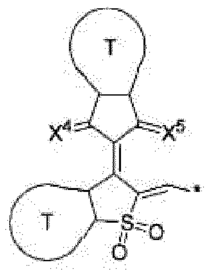

(a-4)

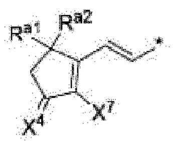

(a-5)

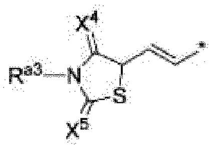

(a-6)

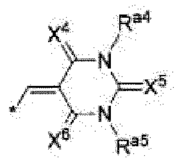

(a-7)

In Formulae (a-1) to (a-7),
T represents a carbocyclic ring optionally having a substituent or a heterocyclic ring optionally having a substituent. The carbocyclic ring and the heterocyclic ring may be a monocyclic ring or a condensed ring. When these rings have a plurality of substituents, the plurality of substituents may be the same or different.

Examples of the carbocyclic ring optionally having a substituent, which is T, include aromatic carbocyclic rings, and aromatic carbocyclic rings are preferable. Specific examples of the carbocyclic ring optionally having a substituent, which is T, include a benzene ring, a naphthalene ring, an anthracene ring, a tetracene ring, a pentacene ring, a pyrene ring, and a phenanthrene ring. A benzene ring, a naphthalene ring, and a phenanthrene ring are preferable, a benzene ring and a naphthalene ring are more preferable, and a benzene ring is still more preferable. These rings may have a substituent.

Examples of the heterocyclic ring optionally having a substituent, which is T, include aromatic heterocyclic rings, and aromatic carbocyclic rings are preferable. Specific examples of the heterocyclic ring optionally having a substituent, which is T, include a pyridine ring, a pyridazine ring, a pyrimidine ring, a pyrazine ring, a pyrrole ring, a furan ring, a thiophene ring, an imidazole ring, an oxazole ring, a thiazole ring, and a thienothiophene ring. A thiophene ring, a pyridine ring, a pyrazine ring, a thiazole ring, and a thiophene ring are preferable, and a thiophene ring is more preferable. These rings may have a substituent.

Examples of the substituent that can be included in the carbocyclic ring or heterocyclic ring as T include a halogen atom, an alkyl group, an alkyloxy group, an aryl group, and a monovalent heterocyclic group. The substituent is preferably a fluorine atom and/or an alkyl group having 1 to 6 carbon atoms.

$X^4$, $X^5$, and $X^6$ each independently represent an oxygen atom, a sulfur atom, an alkylidene group, or a group represented by $=C(-CN)_2$, and is preferably an oxygen atom, a sulfur atom, or a group represented by $=C(-CN)_2$.

$X^7$ represents a hydrogen atom or a halogen atom, a cyano group, an alkyl group optionally having a substituent, an alkyloxy group optionally having a substituent, an aryl group optionally having a substituent, or a monovalent heterocyclic group.

$R^{a1}$, $R^{a2}$, $R^{a3}$, $R^{a4}$, and $R^{a5}$ each independently represent a hydrogen atom, an alkyl group optionally having a substituent, a halogen atom, an alkyloxy group optionally having a substituent, an aryl group optionally having a substituent, or a monovalent heterocyclic group. $R^{a1}$, $R^{a2}$, $R^{a3}$, $R^{a4}$, and $R^{a5}$ are preferably an alkyl group optionally having a substituent or an aryl group optionally having a substituent.

[Chemical Formula 41]

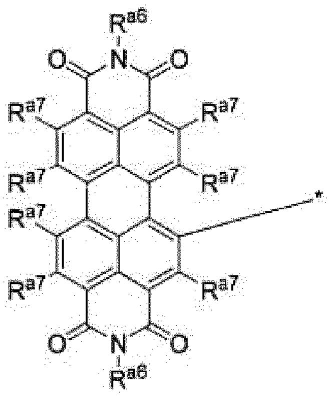

(a-8)

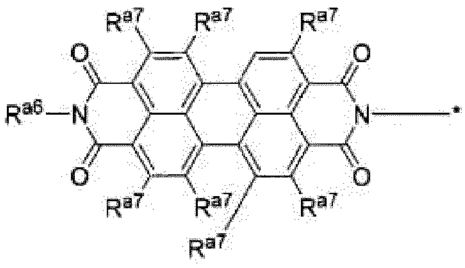

(a-9)

In Formulae (a-8) and (a-9),
$R^{a6}$ and $R^{a7}$ each independently represent a hydrogen atom, a halogen atom, an alkyl group optionally having a substituent, a cycloalkyl group optionally having a substituent, an alkyloxy group optionally having a substituent, a cycloalkyloxy group optionally having a substituent, a monovalent aromatic carbocyclic group optionally having a substituent, or a monovalent aromatic heterocyclic group optionally having a substituent, and a plurality of $R^{a6}$s and $R^{a7}$s may be the same or different.

The group represented by Formula (a-8) or (a-9) has a moiety AP having an electron accepting property and a moiety DP having an electron donating property. The moiety AP and the moiety DP in the groups represented by Formulae (a-8) and (a-9) are shown below.

[Chemical Formula 42]

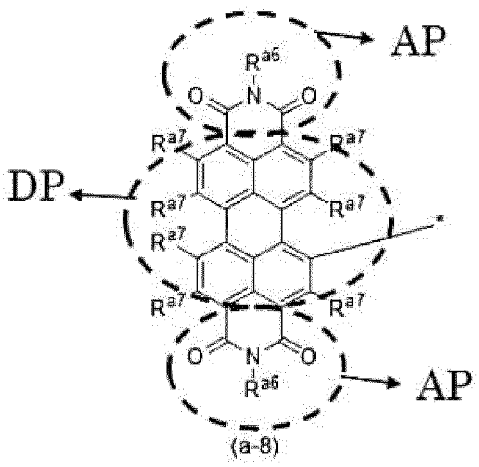


(a-8)

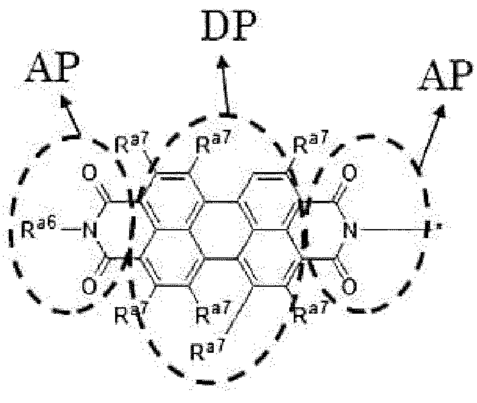


(a-9)

As the electron-withdrawing group which is $A^1$ or $A^2$, groups represented by the following Formulae (a-1-1) to (a-1-4), and Formulae (a-6-1) and (a-7-1) are preferable. Here, a plurality of $R^{a10}$s each independently represent a

hydrogen atom or a substituent, and preferably represent a hydrogen atom, a halogen atom, or an alkyl group. $R^{a3}$, $R^{a4}$, and $R^{a5}$ each independently have the same meaning as described above, and preferably represent an alkyl group optionally having a substituent or an aryl group optionally having a substituent.

[Chemical Formula 43]

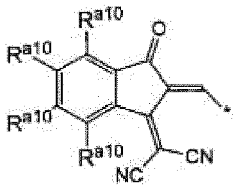
(a-1-1)

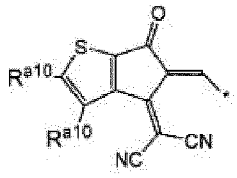
(a-1-2)

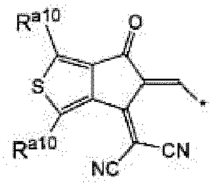
(a-1-3)

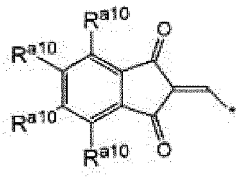
(a-1-4)

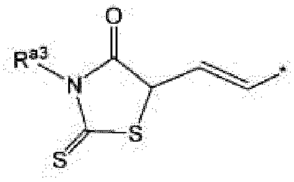
(a-6-1)

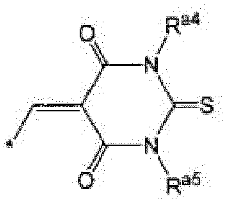
(a-7-1)

Examples of the group including a π conjugated system, which is $B^{10}$, include a group represented by $-(S^1)_{n1}-B^{11}-(S^2)_{n2}-$ in the compound represented by Formula (IX) described later.

The DP-AP compound which is an n-type semiconductor material is preferably a compound represented by the following Formula (IX).

$$A^1-(S^1)_{n1}-B^{11}-(S^2)_{n2}-A^2 \qquad (IX)$$

In Formula (IX),
$A^1$ and $A^2$ each independently represent an electron-withdrawing group. Examples and preferred examples of $A^1$ and $A^2$ are the same as the examples and preferred examples described for $A^1$ and $A^2$ in the above Formula (VIII).

$S^1$ and $S^2$ each independently represent a divalent carbocyclic group optionally having a substituent, a divalent heterocyclic group optionally having a substituent, a group represented by $-C(R^{s1})=C(R^{s2})-$ where $R^{s1}$ and $R^{s2}$ each independently represent a hydrogen atom or a substituent (preferably, a hydrogen atom, a halogen atom, an alkyl group optionally having a substituent, or a monovalent heterocyclic group optionally having a substituent), or a group represented by -C=C-.

The divalent carbocyclic group optionally having a substituent and the divalent heterocyclic group optionally having a substituent, which are $S^1$ and $S^2$, may be a condensed ring. When the divalent carbocyclic group or the divalent heterocyclic group has a plurality of substituents, the plurality of substituents may be the same or different.

As described above, the DP-AP compound represented by Formula (IX) has a structure in which a moiety DP and a moiety AP are linked via $S^1$ and $S^2$ serving as a spacer (group, constituent unit).

Examples of the divalent carbocyclic group include divalent aromatic carbocyclic groups.

Examples of the divalent heterocyclic group include divalent aromatic heterocyclic groups.

When the divalent aromatic carbocyclic group or the divalent aromatic heterocyclic group is a condensed ring, all of the rings constituting the condensed ring may be a condensed ring having aromaticity, or only a part thereof may be a condensed ring having aromaticity.

Examples of $S^1$ and $S^2$ include a group represented by any one of Formulae (101) to (172) and (178) to (185), which are described as examples of the divalent aromatic heterocyclic group represented by $Ar^3$, and a group in which a hydrogen atom in these groups is substituted with a substituent.

$S^1$ and $S^2$ preferably each independently represent a group represented by any one of the following Formulae (s-1) and (s-2).

[Chemical Formula 44]

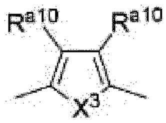

(s-1)

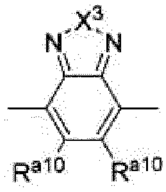

(s-2)

In Formulae (s-1) and (s-2),

$X^3$ represents an oxygen atom or a sulfur atom.
$Ra^{10}$ is as defined above.

$S^1$ and $S^2$ are preferably each independently a group represented by Formula (142), (148), or (184), or a group in which a hydrogen atom in these groups is substituted with a substituent. $S^1$ and $S^2$ are more preferably a group represented by Formula (142) or (184), or a group in which one hydrogen atom in the group represented by Formula (184) is substituted with an alkyloxy group.

$B^{11}$ is a condensed ring group having two or more structures selected from the group consisting of carbocyclic structures and heterocyclic structures, is a condensed ring group including no ortho-peri condensed structure, and represents a condensed ring group optionally having a substituent.

The condensed ring group which is $B^{11}$ may include a structure in which two or more structures identical to each other are condensed.

When the condensed ring group which is $B^{11}$ has a plurality of substituents, the plurality of substituents may be the same or different.

Examples of the carbocyclic structure that can constitute the condensed ring group as $B^{11}$ include ring structures represented by the following Formulae (Cy1) and (Cy2).

[Chemical Formula 45]

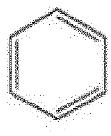

(Cy1)

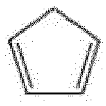

(Cy2)

Examples of the heterocyclic structure that can constitute the condensed ring group as $B^{11}$ include ring structures represented by the following Formulae (Cy3) to (Cy9) .

[Chemical Formula 46]

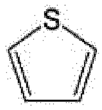
(Cy3)
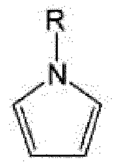
(Cy4)
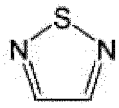
(Cy5)
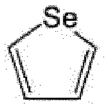
(Cy6)
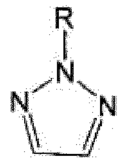
(Cy7)
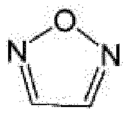
(Cy8)
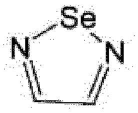
(Cy9)

In the formulae, R is as defined above.

$B^{11}$ is preferably a condensed ring group formed through condensation of two or more structures selected from the group consisting of structures represented by the above Formulae (Cy1) to (Cy9), is a condensed ring group including no ortho-peri condensed structure, and is a condensed ring group optionally having a substituent. $B^{11}$ may include a structure in which two or more identical structures among the structures represented by the above Formulae (Cy1) to (Cy9) are condensed.

$B^{11}$ is more preferably a condensed ring group formed through condensation of two or more structures selected from the group consisting of structures represented by the above Formulae (Cy1) to (Cy5) and (Cy7), is a condensed ring group including no ortho-peri condensed structure, and is a condensed ring optionally having a substituent.

The substituent optionally included in the condensed ring group as $B^{11}$ is preferably an alkyl group optionally having a substituent, an aryl group optionally having a substituent, an alkyloxy group optionally having a substituent, and a monovalent heterocyclic group optionally having a substituent. The aryl group optionally included in the condensed ring group represented by $B^{11}$ may be substituted with, for example, an alkyl group.

Examples of the condensed ring group which is $B^{11}$ include groups represented by the following Formulae (b-1) to (b-14) and a group in which a hydrogen atom in these groups is substituted with a substituent (preferably, an alkyl group optionally having a substituent, an aryl group optionally having a substituent, an alkyloxy group optionally having a substituent, or a monovalent heterocyclic group optionally having a substituent).

In Formulae (b-1) to (b-14), $R^{a10}$ is as defined above. In Formulae (b-1) to (b-14), a plurality of $R^{a10}$s each independently represent a hydrogen atom or a substituent, and preferably represent an alkyl group optionally having a substituent or an aryl group optionally having a substituent.

[Chemical Formula 47]

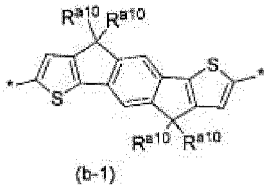

(b-1)

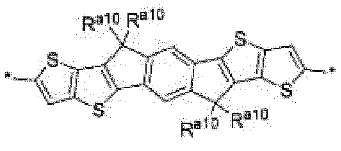

(b-2)

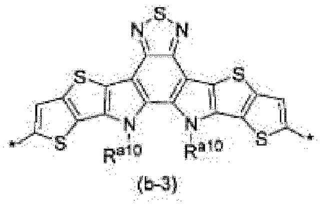

(b-3)

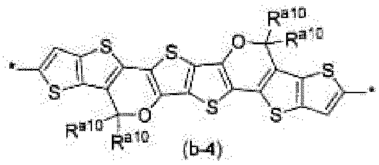

(b-4)

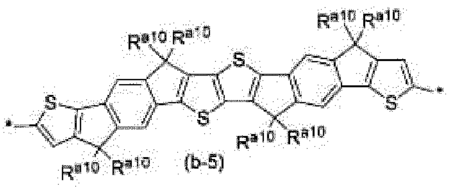

(b-5)

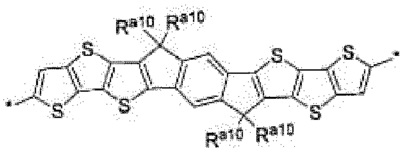

(b-6)

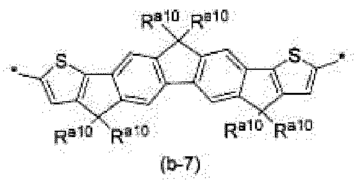

(b-7)

[Chemical Formula 48]

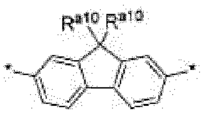
(b-8)

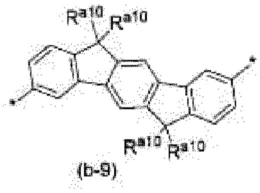
(b-9)

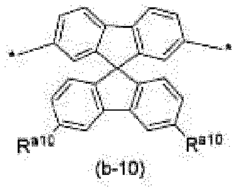
(b-10)

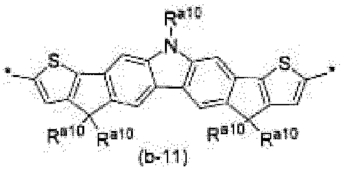
(b-11)

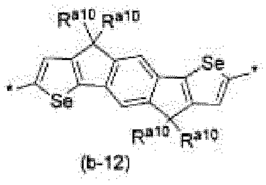
(b-12)

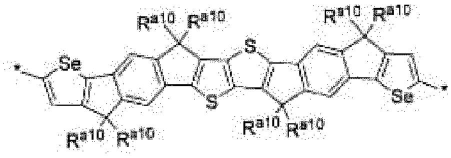
(b-13)

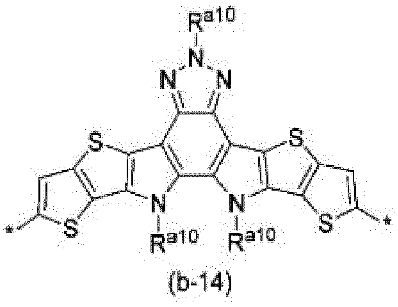
(b-14)

In Formula (IX), n1 and n2 each independently represent an integer of 0 or more, preferably each independently represent 0 or 1, and more preferably simultaneously represent 0 or 1.

Examples of the compound represented by Formula (VIII) or (IX) include compounds represented by the following formulae.

[Chemical Formula 49]

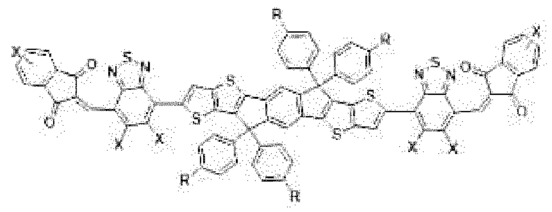

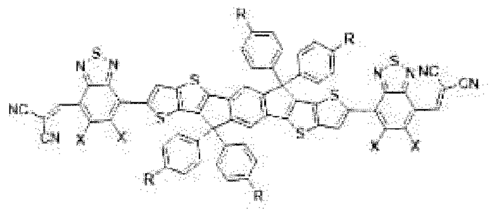

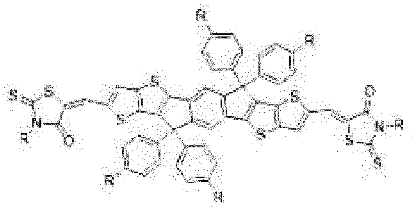

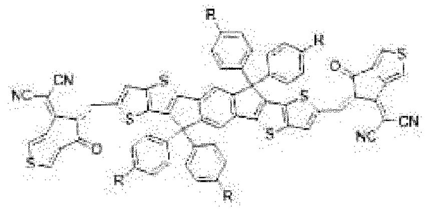

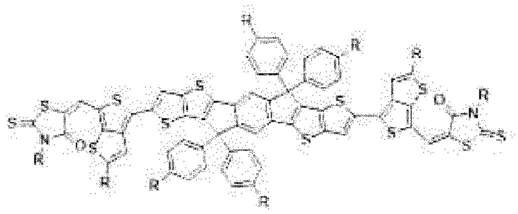

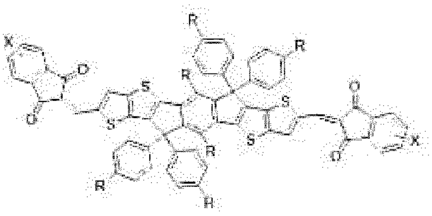

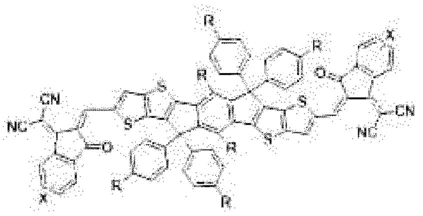

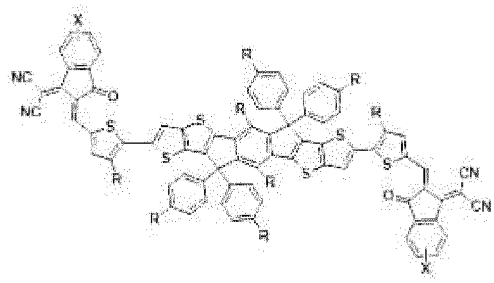

[Chemical Formula 50]

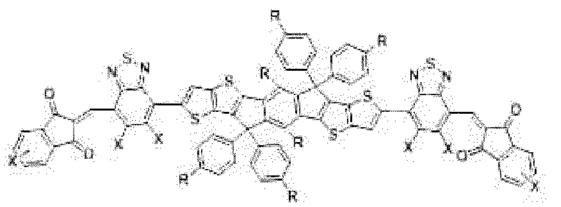

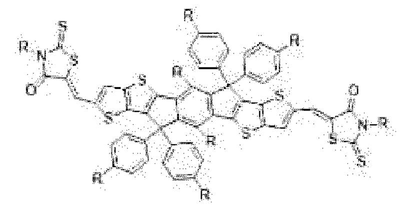

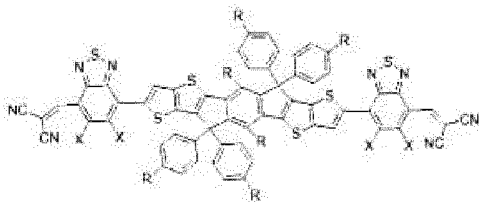

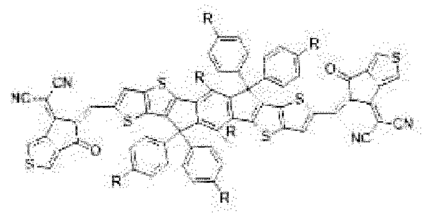

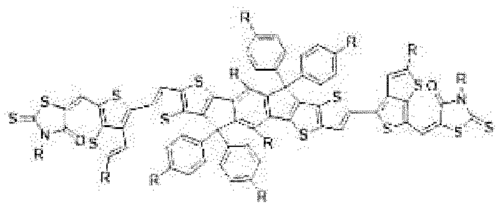

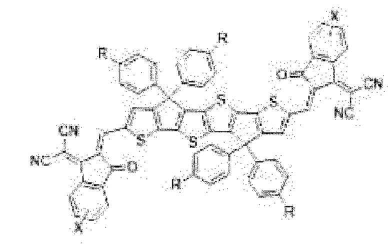

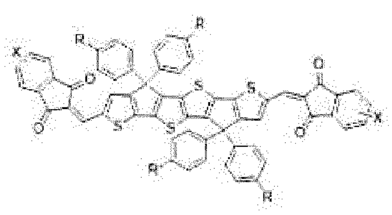

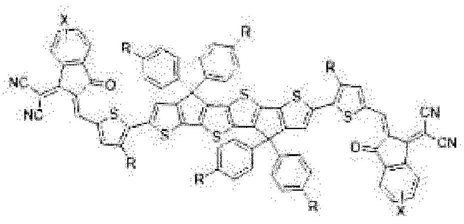

[Chemical Formula 51]

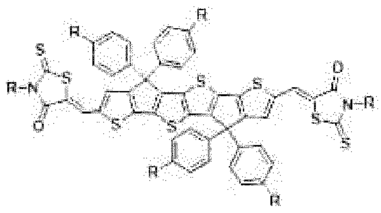

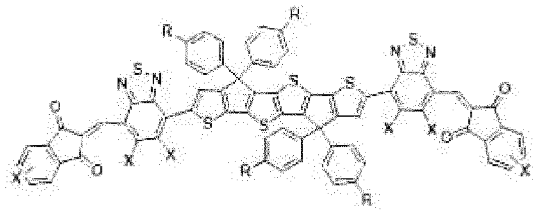

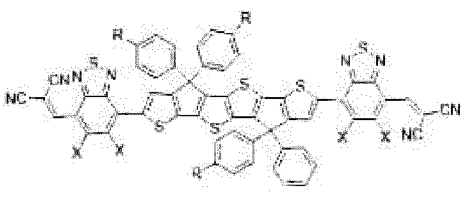

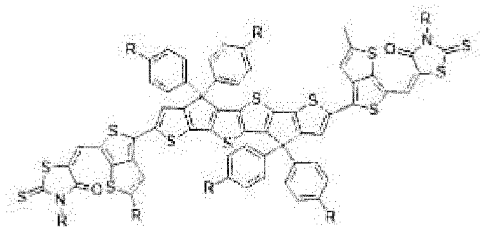

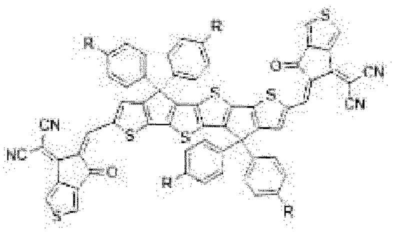

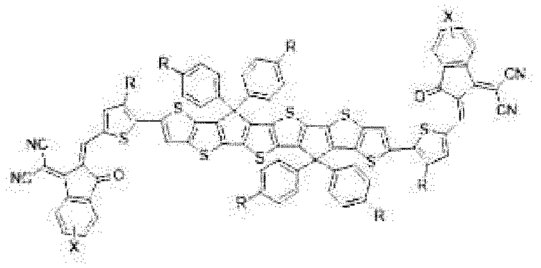

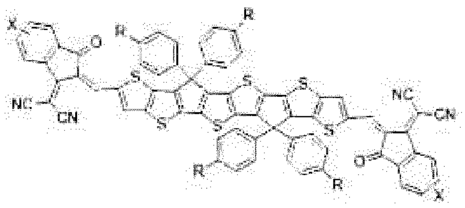

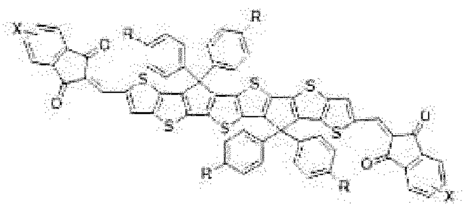

[Chemical Formula 52]

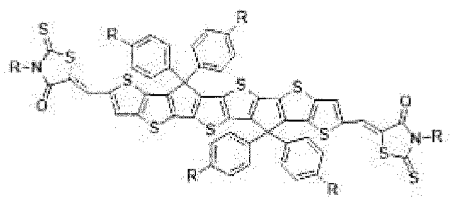
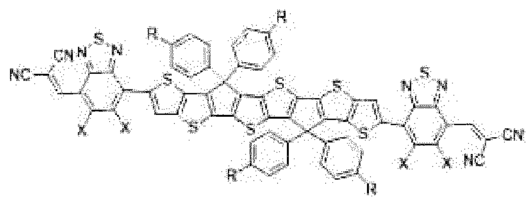
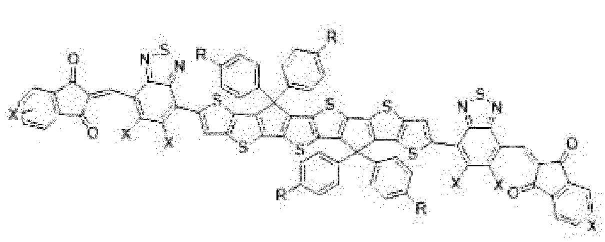
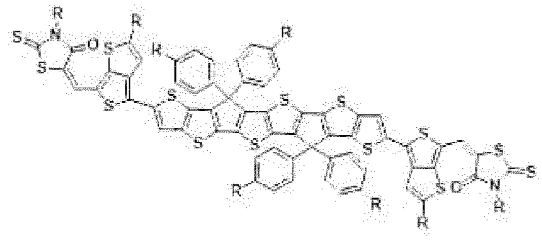
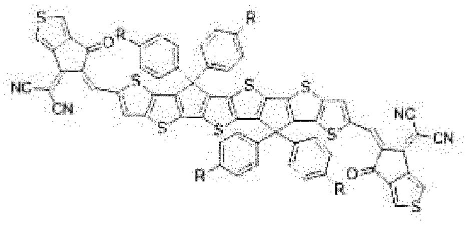
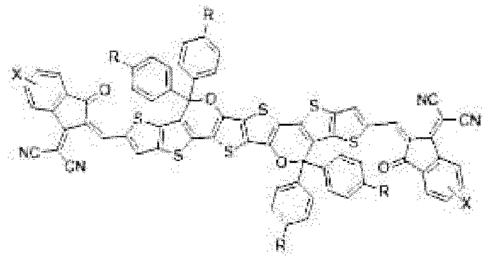
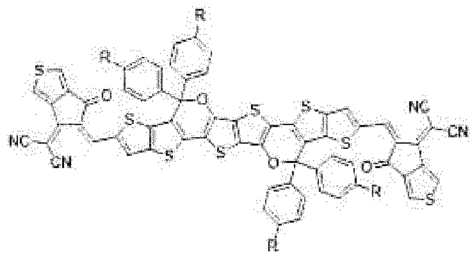
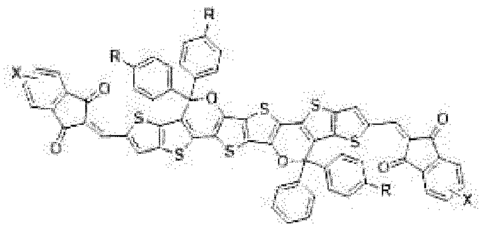

[Chemical Formula 53]

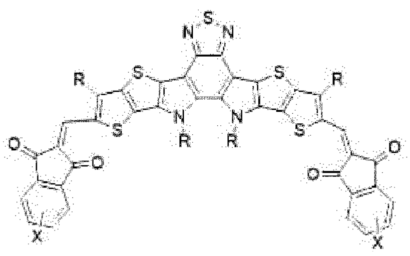
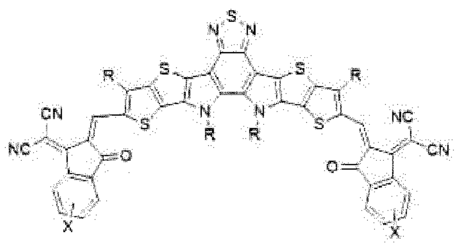

[Chemical Formula 54]

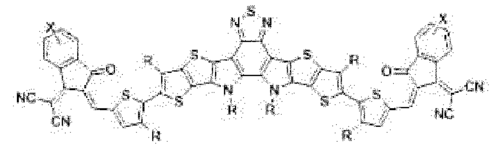

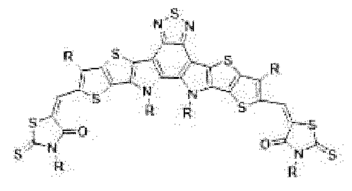

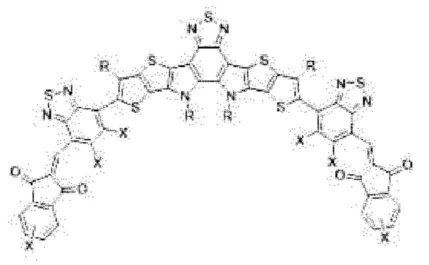

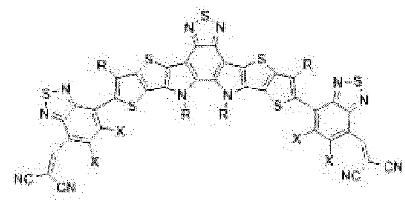

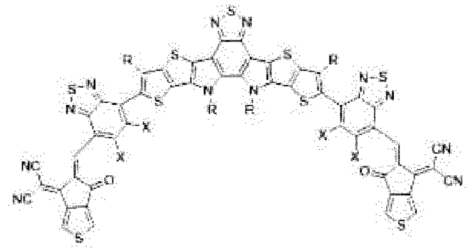

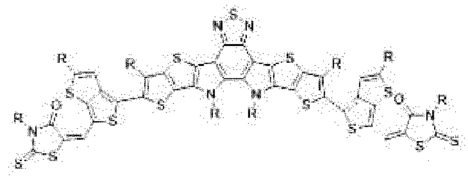

[Chemical Formula 55]

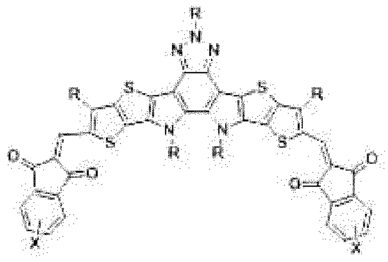

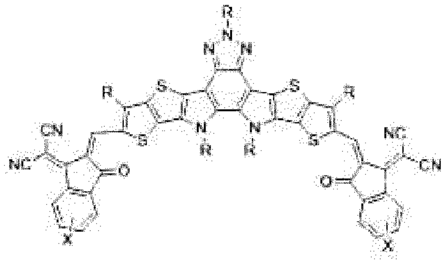

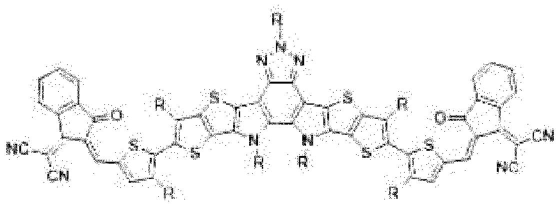

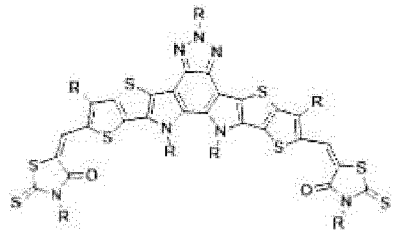

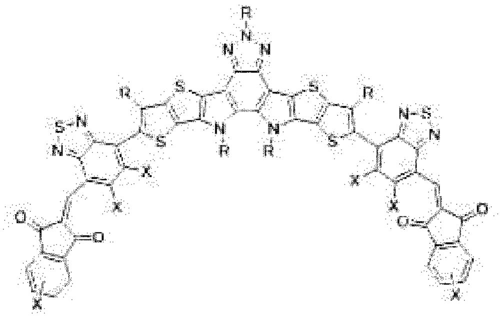

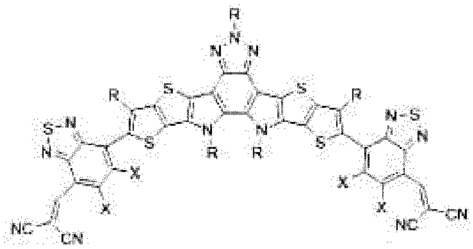

[Chemical Formula 56]

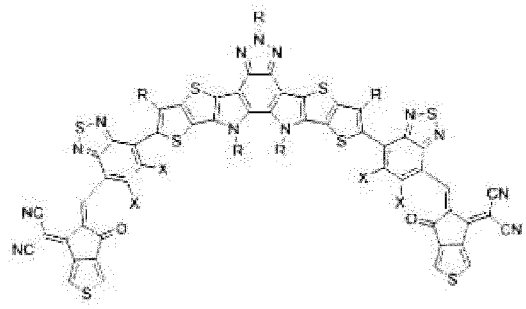

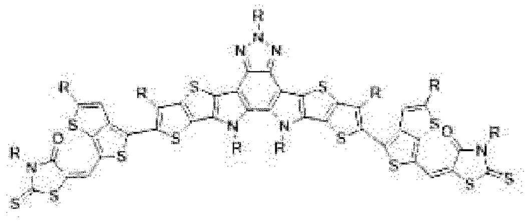

In the above formulae, R represents a hydrogen atom, an alkyl group optionally having a substituent, an aryl group optionally having a substituent, or an alkyloxy group optionally having a substituent, and X represents a hydrogen atom, a halogen atom, a cyano group, or an alkyl group optionally having a substituent.

Examples of the moiety AP and the moiety DP in the compound represented by Formula (VIII) or (IX) are shown below.

[Chemical Formula 57]

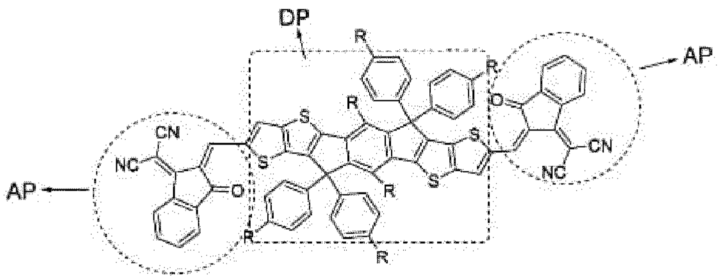

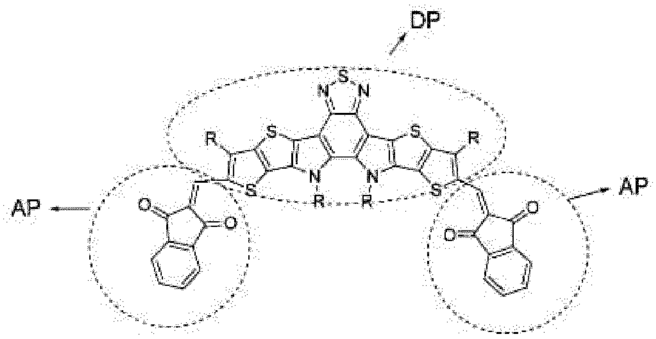

As the compound represented by Formula (VIII) or (IX), compounds represented by the following Formulae N-1 to N-4 are preferable.

[Chemical Formula 58]

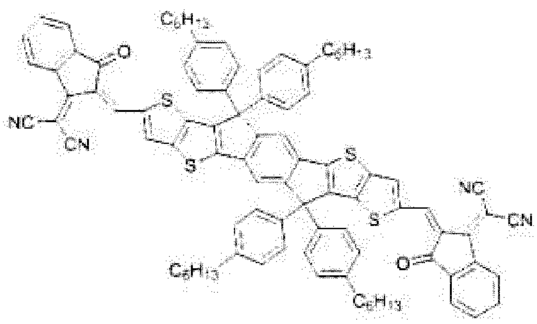

N - 1

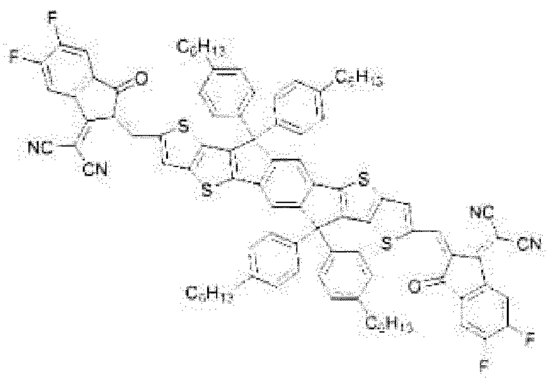

N - 2

[Chemical Formula 59]

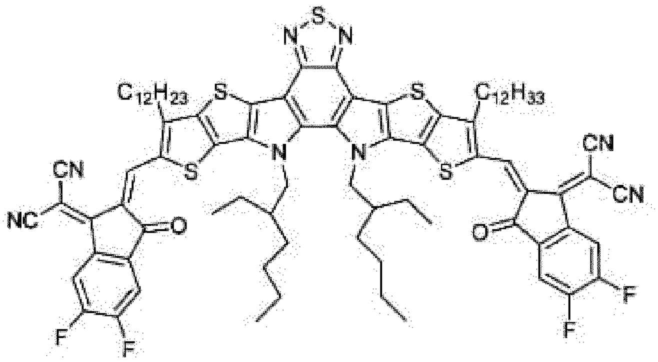

N－3

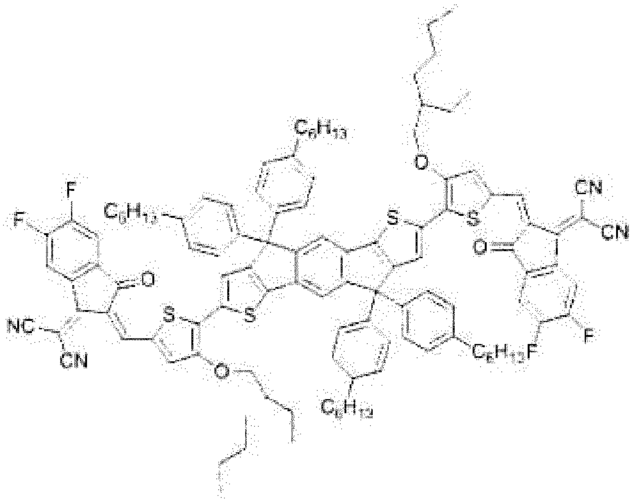

N－4

The DP-AP compound which is an n-type semiconductor material may be a compound having a perylene tetracarboxylic diimide structure. Examples of the compound having a perylene tetracarboxylic diimide structure as the DP-AP compound include compounds represented by the following formulae.

[Chemical Formula 60]

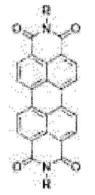
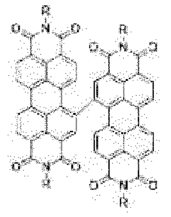
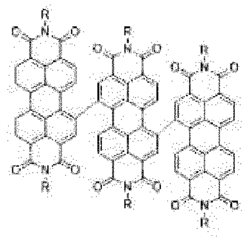
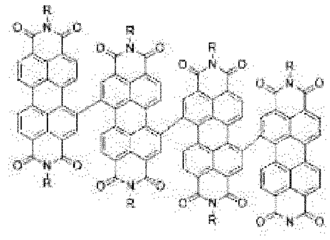

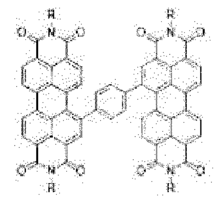
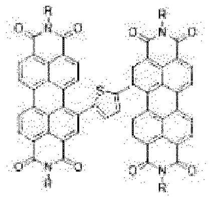
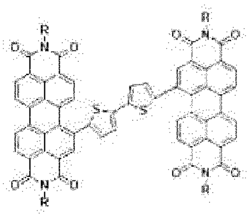
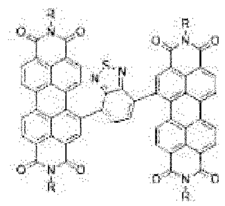

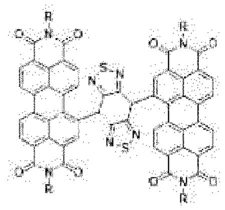
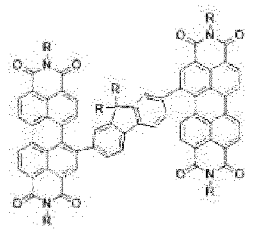
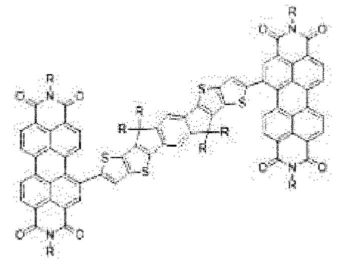

[Chemical Formula 61]

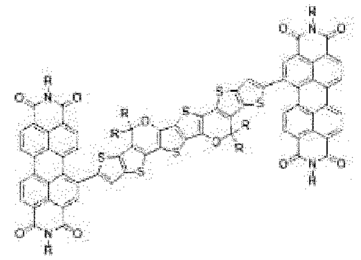

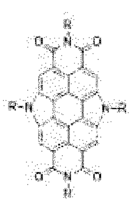
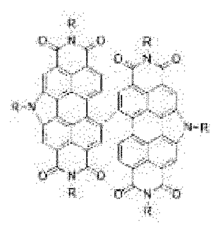
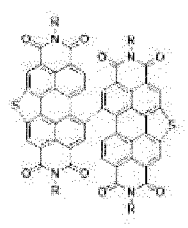
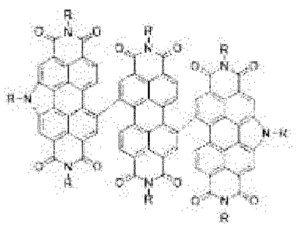

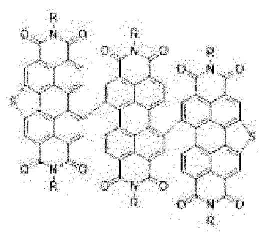
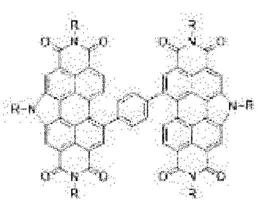
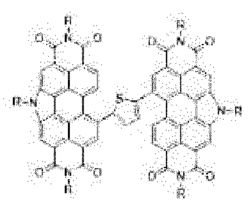
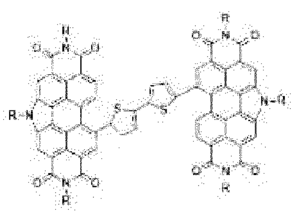

[Chemical Formula 62]

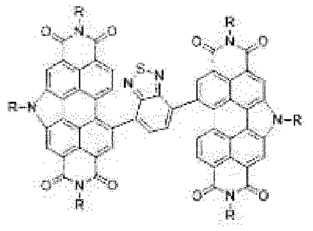
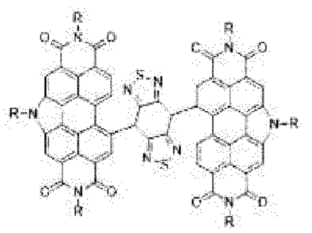
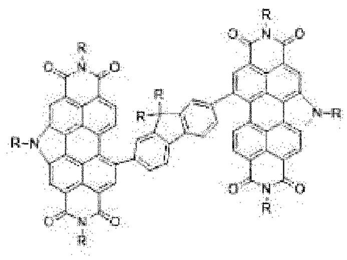
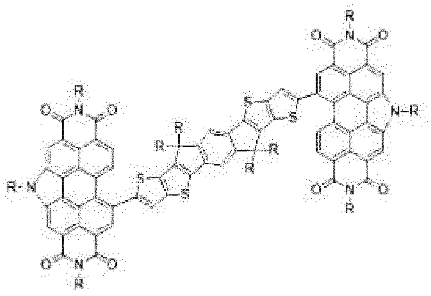
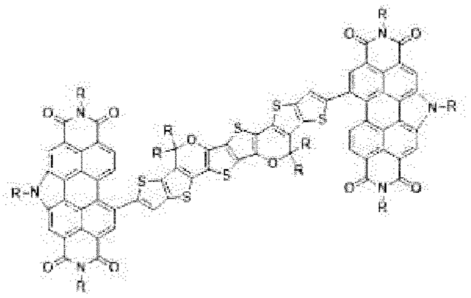
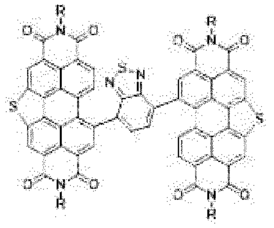
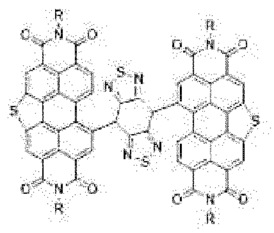
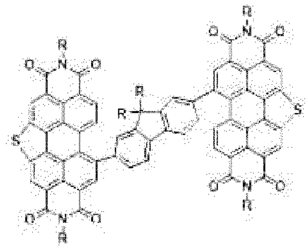

[Chemical Formula 63]

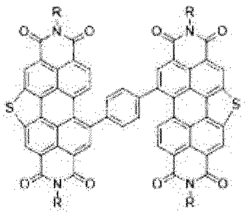

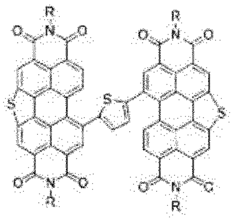

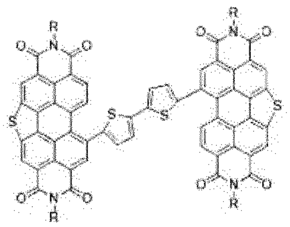

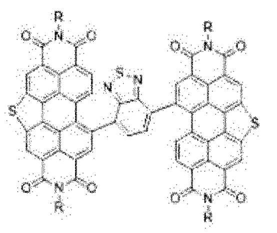

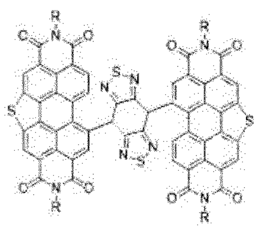

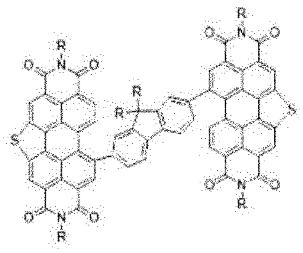

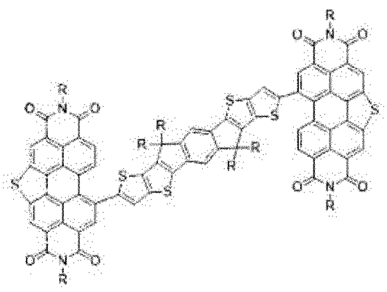

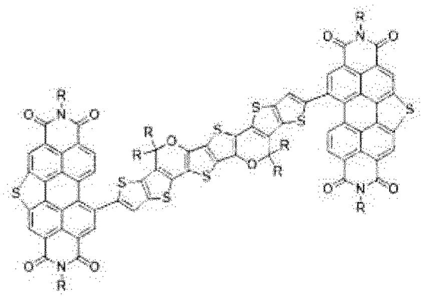

[Chemical Formula 64]

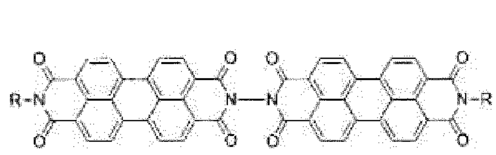

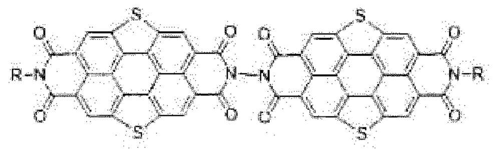

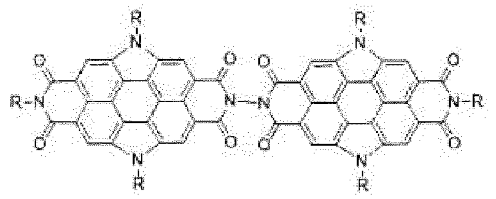

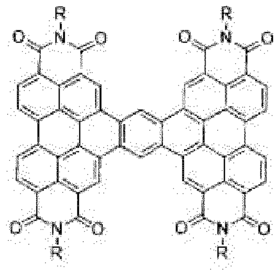

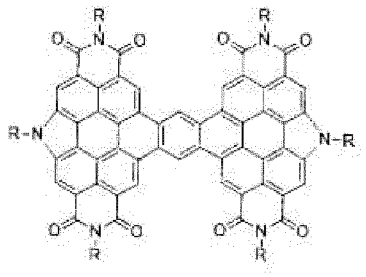

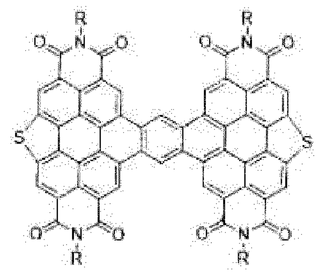

[Chemical Formula 65]

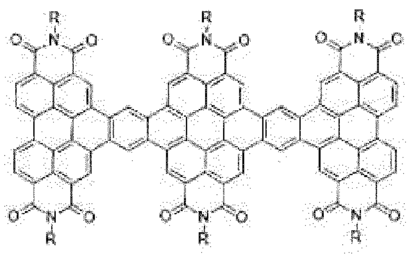

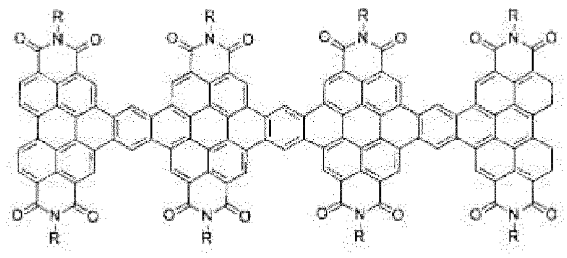

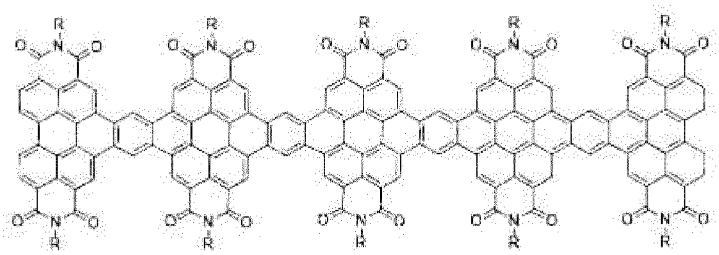

[Chemical Formula 66]

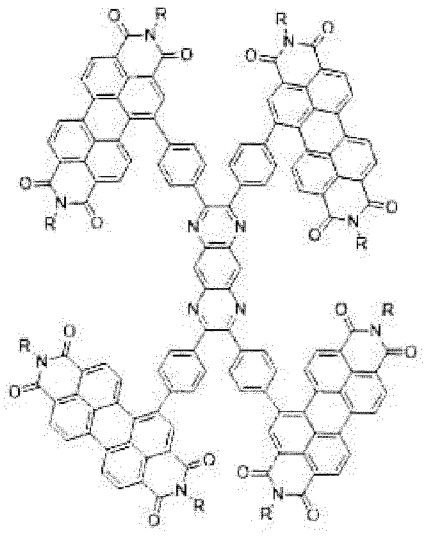

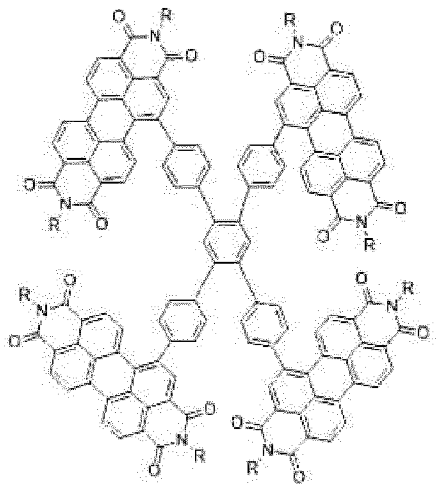

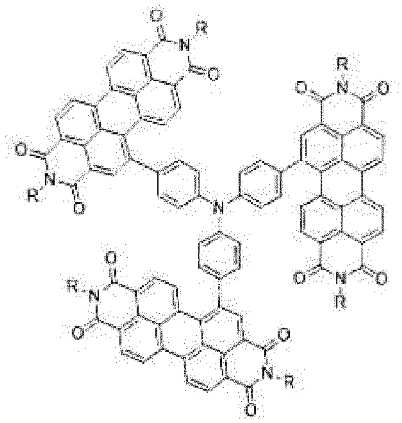

In the formulae, R is as defined above. A plurality of Rs may be the same or different.

The DP-AP compound which is an n-type semiconductor material is preferably a compound represented by the following Formula (X) or (XI), and more preferably a compound represented by the following Formula (X). The compound represented by the following Formula (X) or (XI) is a compound having a perylene tetracarboxylic diimide structure.

[Chemical Formula 67]

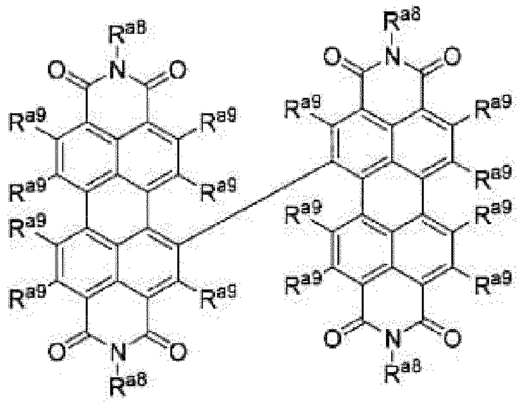

(X)

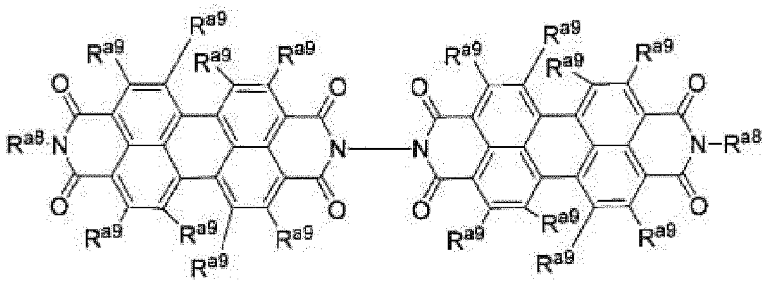

(XI)

In Formulae (X) and (XI), $R^{a8}$ and $R^{a9}$ each independently represent a hydrogen atom, a halogen atom, an alkyl group optionally having a substituent, a cycloalkyl group optionally having a substituent, an alkyloxy group optionally having a substituent, a cycloalkyloxy group optionally having a substituent, a monovalent aromatic carbocyclic group optionally having a substituent, or a monovalent aromatic heterocyclic group optionally having a substituent. A plurality of $R^{a8}$s and $R^{a9}$s may be the same or different.

$R^{a8}$ is preferably an alkyl group optionally having a substituent or an aryl group optionally having a substituent, more preferably an alkyl group optionally having a substituent, and still more preferably an alkyl group having 6 to 20 carbon atoms and optionally having a substituent. The number of carbon atoms of the alkyl group does not include the number of carbon atoms of the substituent.

$R^{a9}$ is preferably a hydrogen atom, a halogen atom, an alkyl group optionally having a substituent, an alkyloxy group optionally having a substituent, an aryl group optionally having a substituent, or a monovalent heterocyclic group optionally having a substituent, and more preferably a hydrogen atom.

Examples of the compound represented by Formula (X) include a compound represented by the following Formula N-5.

[Chemical Formula 68]

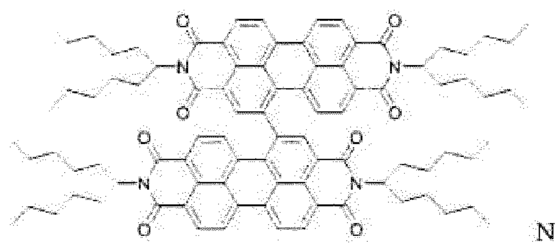

N-5

Here, regarding the relationship between the p-type semiconductor material and the n-type semiconductor material, the absolute value of the energy level of the HOMO of the p-type semiconductor material is defined as |HOMOp|, the absolute value of the energy level of the LUMO is defined as |LUMOp|, the absolute value of the energy level of the HOMO of the n-type semiconductor material is defined as |HOMOn|, and the absolute value of the energy level of the LUMO is defined as |LUMOn|. The value of ΔEA (|HOMOn|-|HOMOp|) is preferably more than -0.5 eV, more preferably more than 0.01 eV, still more preferably less than 3 eV, still even more preferably less than 2 eV, particularly preferably more than -0.5 eV and less than 3 eV, and particularly preferably more than 0.01 eV and less than 2 eV.

The value of ΔEB (|LUMOn|-|LUMOp|) is preferably more than -0.5 eV, more preferably more than 0.01 eV, still more preferably less than 2 eV, still even more preferably more than -0.5 eV and less than 2 eV, and particularly preferably more than 0.01 eV and less than 2 eV.

(Intermediate layer)

As illustrated in Fig. 1, the photodetector element of the present embodiment preferably includes, for example, an intermediate layer (buffer layer) such as a charge transportation layer (electron transportation layer, hole transportation layer, electron injection layer, hole injection layer) as a component for improving characteristics.

Examples of the material used for the intermediate layer include metals such as calcium, inorganic oxide semiconductors such as molybdenum oxide and zinc oxide, and a mixture of PEDOT (poly(3,4-ethylenedioxythiophene)) and PSS (poly(4-styrenesulfonate)) (PEDOT : PSS).

The intermediate layer can be formed by any preferred publicly known forming method. The intermediate layer can be formed by a vacuum deposition method, a coating method, or the like.

As illustrated in Fig. 1, the photodetector element preferably includes an electron transportation layer as an intermediate layer between the second electrode as a cathode and the active layer. The electron transportation layer has a function of transporting electrons from the active layer to the second electrode.

Note that an electron transportation layer provided in contact with the second electrode may be particularly referred to as an electron injection layer. The electron transportation layer (electron injection layer) provided in contact with the second electrode has a function of promoting injection of electrons generated in the active layer into the second electrode.

The electron transportation layer contains an electron transporting material. Examples of the electron transporting material include polyethyleneimine ethoxylated (PEIE), polymer compounds having a fluorene structure, metals such as calcium, and metal oxides.

Examples of the polymer compound having a fluorene structure include poly[(9,9-bis(3'-(N, N-dimethylamino)propyl)-2,7-fluorene)-ortho-2,7-(9,9'-dioctylfluorene)] (PFN) and PFN-P2.

Examples of the metal oxide include zinc oxide, gallium-doped zinc oxide, aluminum-doped zinc oxide, titanium oxide, and niobium oxide. As the metal oxide, a metal oxide containing zinc is preferable, and zinc oxide is particularly preferable.

Examples of other electron transporting materials include poly(4-vinylphenol) and perylene diimide.

As illustrated in Fig. 1, the photodetector element of the present embodiment preferably includes a hole transportation layer as an intermediate layer between the first electrode and the active layer. The hole transportation layer has a function of transporting holes from the active layer to the first electrode. The hole transportation layer may be in contact with the first electrode. The hole transportation layer may be in contact with the active layer.

A hole transportation layer provided in contact with the first electrode may be particularly referred to as a hole injection layer. The hole transportation layer (hole injection layer) provided in contact with the first electrode has a function of promoting injection of holes into the first electrode. The hole transportation layer (hole injection layer) may be in contact with the active layer.

The hole transportation layer contains a hole transporting material. Examples of the hole transporting material include polythiophene and derivatives thereof, aromatic amine compounds, polymer compounds containing a constituent unit having an aromatic amine residue, CuSCN, CuI, NiO, tungsten oxide ($WO_3$), and molybdenum oxide (MoOs) .

The photodetector element of the present embodiment preferably has a configuration in which the intermediate layer is an electron transportation layer, and a hole transportation layer, and a substrate (supporting substrate), a first electrode, a hole transportation layer, an active layer, an electron transportation layer, and a second electrode are layered in this order so as to be in contact with each other.

(Sealing member)

The photodetector element of the present embodiment preferably further includes a sealing member, and is preferably a sealed body sealed by the sealing member.

Any preferred publicly known member can be used as the sealing member. Examples of the sealing member include a combination of a glass substrate as a substrate (sealing substrate) and a sealing material (adhesive) such as a UV curable resin.

The sealing member may be a sealing layer having a layer structure of one or more layers. Examples of the layer constituting the sealing layer include a gas barrier layer and a gas barrier film.

The sealing layer is preferably formed of a material having a property of blocking moisture (water vapor barrier property) or a property of blocking oxygen (oxygen barrier property). Examples of materials suitable as the material of the sealing layer include organic materials such as polytrifluoroethylene, polychlorotrifluoroethylene (PCTFE), polyimide,

polycarbonate, polyethylene terephthalate, alicyclic polyolefin, and ethylene-vinyl alcohol copolymers; and inorganic materials such as silicon oxide, silicon nitride, aluminum oxide, and diamond-like carbon.

The sealing member is formed of a material that can withstand a heat treatment performed when the sealing member is incorporated into a device to which the photodetector element is usually applied, for example, a device of the following application example.

3. Method for producing photodetector element

The method for producing a photodetector element of the present embodiment is not particularly limited. The photodetector element can be produced by combining a forming method suitable for the material selected in the formation of each component.

The components of the photodetector element of the present embodiment can be produced by a coating method using an ink composition which is a coating liquid.

A method for producing a photodetector element according to the present embodiment is a method for producing a photodetector element including: an anode; a cathode; an active layer provided between the anode and the cathode; and an electron transportation layer provided between the cathode and the active layer, wherein the active layer contains an n-type semiconductor material and a p-type semiconductor material, and the value ($\Delta EA + \Delta EB$) of the sum of the value ($\Delta EA$) obtained by subtracting the absolute value of the energy level of the HOMO of the p-type semiconductor material from the absolute value of the energy level of the HOMO of the n-type semiconductor material and the value ($\Delta EB$) obtained by subtracting the absolute value of the energy level of the LUMO of the p-type semiconductor material from the absolute value of the energy level of the LUMO of the n-type semiconductor material is in a range of more than 0 and less than 0.88 ($0 < \Delta EA + \Delta EB < 0.88$).

In such a production method, at least the active layer is preferably formed by a coating method using a coating liquid. Hereinafter, the method for producing a photodetector element of the present embodiment will be specifically described.

(Step of preparing substrate)

In this step, a supporting substrate provided with an anode is prepared.

The method for providing the anode on the supporting substrate is not particularly limited. The anode can be formed on the supporting substrate formed of the material described above, for example, by using the material exemplified as the material of the electrode by a vacuum deposition method, a sputtering method, an ion plating method, a plating method, or the like.

In addition, a supporting substrate provided with an anode can be prepared, for example, by obtaining a substrate provided with a conductive thin film formed of the material of the electrode described above from the market, and patterning the conductive thin film as necessary to form an anode.

(Step of forming hole transportation layer)

If necessary, a hole transportation layer is formed on the anode.

A method for forming the hole transportation layer is not particularly limited. From the viewpoint of further simplifying the step of forming the hole transportation layer, the hole transportation layer is preferably formed by a coating method. The hole transportation layer can be formed, for example, by applying a coating liquid containing the hole transporting material described above and a solvent, onto a layer on which the hole transportation layer is to be formed.

Examples of the solvent constituting the coating liquid used in the coating method for forming the hole transportation layer include water, alcohol, ketone, and hydrocarbon. Specific examples of the alcohol include methanol, ethanol, isopropanol, butanol, ethylene glycol, propylene glycol, butoxyethanol, and methoxybutanol. Specific examples of the ketone include acetone, methyl ethyl ketone, methyl isobutyl ketone, 2-heptanone, and cyclohexanone. Specific examples of the hydrocarbon include n-pentane, cyclohexane, n-hexane, benzene, toluene, xylene, tetralin, chlorobenzene, and o-dichlorobenzene. The coating liquid may contain one type of solvent alone, or two or more types of solvents. The coating liquid may contain two or more types of solvents exemplified above. The amount of the solvent in the coating liquid is preferably 1 part by weight or more and 10,000 parts by weight or less, and more preferably 10 parts by weight or more and 1,000 parts by weight or less, based on 1 part by weight of the material of the hole transportation layer.

Examples of the method for applying the coating liquid containing the material of the hole transportation layer and the solvent (coating method) include a slot die coating method, a spin coating method, a casting method, a micro gravure coating method, a gravure coating method, a bar coating method, a roll coating method, a wire bar coating method, a dip coating method, a spray coating method, a screen printing method, a flexo printing method, an offset printing method, an inkjet printing method, a dispenser printing method, a nozzle coating method, and a capillary coating

method. Among them, a slot die coating method, a spin coating method, a flexo printing method, an inkjet printing method, and a dispenser printing method are preferable.

It is preferable to perform a step of removing the solvent by subjecting a coating film obtained by applying the coating liquid containing the material of the hole transportation layer and the solvent to a heat treatment, an air drying treatment, a decompression treatment, or the like.

(Step of forming active layer)

The step of forming an active layer of the present embodiment is a step of forming a bulk heterojunction-type active layer. An ink composition which is a coating liquid contains an n-type semiconductor material and a p-type semiconductor material. The ink composition contains a solvent and a composition in which the value ($\Delta EA + \Delta EB$) of the sum of the value ($\Delta EA$) obtained by subtracting the absolute value of the energy level of the HOMO of the p-type semiconductor material from the absolute value of the energy level of the HOMO of the n-type semiconductor material and the value ($\Delta EB$) obtained by subtracting the absolute value of the energy level of the LUMO of the p-type semiconductor material from the absolute value of the energy level of the LUMO of the n-type semiconductor material is in a range of more than 0 and less than 0.88 ($0 < \Delta EA + \Delta EB < 0.88$).

The step of forming the active layer of the present embodiment includes: step (i) of applying a coating liquid to an object to be coated, to obtain a coating film; and step (ii) of removing a solvent from the coating film.

Hereinafter, steps (i) and (ii) included in the method for forming the active layer of the photodetector element of the present embodiment will be described.

Step (i)

As a method for applying the coating liquid to an object to be coated, any preferred coating method can be used.

The coating liquid for forming the active layer is applied to an object to be coated, which is selected according to the photodetector element and the production method thereof. The coating liquid for forming the active layer can be applied to a functional layer which is included in the photodetector element and in which the active layer can be present in a step of producing the photodetector element. Therefore, an object to which the coating liquid for forming the active layer is applied varies depending on the layer structure of the photodetector element to be produced and the order of layer formation. For example, when the photodetector element has a layer structure of substrate/anode/hole transportation layer/active layer/electron transportation layer/cathode, and a layer described on the more left (front) side is formed first, an object to which the coating liquid is applied is the hole transportation layer. In addition, for example, when the photodetector element has a layer structure of substrate/cathode/electron transportation layer/active layer/hole transportation layer/anode, and the layer described on the more left (front) side is formed first, an object to which the coating liquid is applied is the electron transportation layer. In the present embodiment, the active layer is formed on the anode.

Step (ii)

As a method for removing the solvent from the coating film of the coating liquid, in other words, a method for removing the solvent from the coating film to form a solidified film, any preferred method can be used. Examples of the method for removing the solvent include drying methods such as a method of directly heating using a hot plate, a hot-air drying method, an infrared-radiation heat drying method, a flash lamp annealing method, and a reduced-pressure drying method.

The step of forming the active layer may include another step in addition to the above steps (i) and (ii) as long as the objects and effects of the present invention are not impaired.

The method for producing a photodetector element may be a method of producing a photodetector element including a plurality of active layers, or may be a method in which step (i) and step (ii) are repeated a plurality of times.

The thickness of the active layer can be adjusted, for example, by changing the amount of the solvent in the total amount of the coating liquid in the step of forming the active layer. Specifically, the thickness of the active layer can be adjusted to a suitable thickness, for example, by further decreasing the amount of the solvent in the coating liquid in a case of adjusting the thickness of the active layer to be thicker, or further increasing the amount of the solvent in the coating liquid in a case of adjusting the thickness of the active layer to be thinner.

In particular, when the active layer is formed by a spin coating method, the thickness of the active layer can be appropriately adjusted by changing the rotational speed (the number of rotations per predetermined time). Specifically, the thickness of the active layer can be adjusted to be thinner by increasing the rotational speed, and the thickness of the active layer can be adjusted to be thicker by decreasing the rotational speed.

(Coating liquid)

The ink composition which is the coating liquid of the present embodiment is a coating liquid for forming the active layer. The ink composition contains a p-type semiconductor material, an n-type semiconductor material, and a first solvent as a solvent, and may further contain a second solvent as desired. Hereinafter, the components of the coating liquid will be described.

The coating liquid may contain only one type of n-type semiconductor material, or may contain a combination of two or more types at any ratio.

(Weight ratio (p/n ratio) of p-type semiconductor material to n-type semiconductor material)

The weight ratio (p-type semiconductor material/n-type semiconductor material) of the p-type semiconductor material to the n-type semiconductor material in the coating liquid is preferably in a range of 9/1 to 1/9, more preferably in a range of 5/1 to 1/5, and particularly preferably in a range of 3/1 to 1/3.

(First solvent)

The solvent may be selected considering the solubility for the selected p-type semiconductor material and the n-type semiconductor material, and the characteristics corresponding to the drying conditions in the formation of the active layer (such as the boiling point).

The first solvent is preferably an aromatic hydrocarbon optionally having a substituent such as an alkyl group or a halogen atom (hereinafter, simply referred to as an aromatic hydrocarbon) or a halogenated alkyl solvent. The first solvent is preferably selected considering the solubility for the selected p-type semiconductor material and the n-type semiconductor material.

Examples of the aromatic hydrocarbon as a first solvent include toluene, xylenes (for example, o-xylene, m-xylene, and p-xylene), trimethylbenzenes (for example, mesitylene, and 1,2,4-trimethylbenzene (pseudocumene)), butylbenzenes (for example, n-butylbenzene, sec-butylbenzene, and tert-butylbenzene), methylnaphthalenes (for example, 1-methylnaphthalene), tetralin, indan, chlorobenzene, and dichlorobenzene (1,2-dichlorobenzene).

Examples of the halogenated alkyl solvent as a first solvent include chloroform.

The first solvent may be composed of only one type of aromatic hydrocarbon, or composed of two or more types of aromatic hydrocarbons. The first solvent is preferably composed of only one type of aromatic hydrocarbon.

The first solvent preferably contains one or more types selected from the group consisting of toluene, o-xylene, m-xylene, p-xylene, mesitylene, pseudocumene, n-butylbenzene, sec-butylbenzene, tert-butylbenzene, methylnaphthalene, tetralin, indan, chlorobenzene, o-dichlorobenzene, and chloroform.

(Second solvent)

The second solvent is particularly preferably a solvent selected from the viewpoint of enhancing the solubility of the n-type semiconductor material and reducing dark current. Examples of the second solvent include ketone solvents such as acetone, methyl ethyl ketone, cyclohexanone, acetophenone, and propiophenone; ester solvents such as ethyl acetate, butyl acetate, phenyl acetate, ethyl cellosolve acetate, methyl benzoate, butyl benzoate, and benzyl benzoate; and aromatic carbon solvents such as o-dichlorobenzene.

(Weight ratio of first solvent to second solvent)

The weight ratio of the first solvent to the second solvent (first solvent/second solvent) is preferably in a range of 85/15 to 99/1 from the viewpoint of further improving the solubility for the p-type semiconductor material and the n-type semiconductor material.

(Weight percentage of total of first solvent and second solvent in coating liquid)

The total weight of the first solvent and the second solvent contained in the coating liquid is preferably 90 wt.% or more, more preferably 92 wt.% or more, and still more preferably 95 wt.% or more when the total weight of the coating liquid is 100 wt.%, from the viewpoint of further improving the solubility of the p-type semiconductor material and the n-type semiconductor material. The total weight of the first solvent and the second solvent is preferably 99.9 wt.% or less from the viewpoint of increasing the concentration of the p-type semiconductor material and the n-type semiconductor material in the coating liquid to facilitate formation of a layer having a predetermined thickness or more.

(Optional solvent)

The coating liquid may contain an optional solvent other than the first solvent and the second solvent. The content of the optional solvent is preferably 5 wt.% or less, more preferably 3 wt.% or less, and still more preferably 1 wt.% or less when the total weight of the entire solvent contained in the coating liquid is 100 wt.%. The optional solvent is preferably a solvent having a boiling point higher than that of the second solvent.

(Optional components)

The coating liquid may contain optional components such as an ultraviolet absorber, an antioxidant, a sensitizer for for sensitizing a function of generating charges by absorbed light, and a photostabilizer for increasing the stability against ultraviolet rays, in addition to the first solvent (and the second solvent), the p-type semiconductor material, and the n-type semiconductor material, to the extent that the objects and effects of the present invention are not impaired.

(Concentration of p-type semiconductor material and n-type semiconductor material in coating liquid)

The concentration of the total of the p-type semiconductor material and the n-type semiconductor material in the coating liquid can be any preferred concentration depending on the required thickness of the active layer. The concentration of the total of the p-type semiconductor material and the n-type semiconductor material is preferably 0.01 wt.% or more and 20 wt.% or less, more preferably 0.01 wt.% or more and 10 wt.% or less, still more preferably 0.01 wt.% or more and 5 wt.% or less, and particularly preferably 0.1 wt.% or more and 5 wt.% or less.
In the coating liquid, the p-type semiconductor material and the n-type semiconductor material may be dissolved or dispersed.
Preferably, at least a part of the p-type semiconductor material and the n-type semiconductor material is dissolved, or more preferably, all of them are dissolved.

(Preparation of coating liquid)

The coating liquid can be prepared by a publicly known method. The coating liquid can be prepared by, for example, a method of mixing a first solvent and a second solvent to prepare a mixed solvent, and then adding a p-type semiconductor material and an n-type semiconductor material to the mixed solvent, and a method of adding a p-type semiconductor material to a first solvent and adding an n-type semiconductor material to a second solvent, and then mixing the first solvent and the second solvent to which each material has been added.
The first solvent (and the second solvent), and the p-type semiconductor material and the n-type semiconductor material may be mixed while heating these materials to a temperature equal to lower than the boiling point of the solvent.
After mixing of the first solvent and the second solvent, and the p-type semiconductor material and the n-type semiconductor material, the obtained mixture is filtrated with a filter, and the resulting filtrate may be used as a coating liquid. As the filter, a filter made of a fluororesin such as polytetrafluoroethylene (PTFE) can be used, for example.

(Step of forming electron transportation layer)

The method for producing a photodetector element according to the present embodiment includes a step of forming an electron transportation layer (electron injection layer) provided between the active layer and the cathode.
Specifically, the method for producing a photodetector element according to the present embodiment further includes a step of forming an electron transportation layer after the step of forming the active layer.
A method for forming the electron transportation layer is not particularly limited. From the viewpoint of further simplifying the step of forming the electron transportation layer, the electron transportation layer is preferably formed by the same coating method as the step of forming the active layer described above. That is, preferably, after formation of the active layer, the electron transportation layer is formed by applying a coating liquid containing an electron transporting material and a solvent to be described later onto the active layer, and removing the solvent by, for example, performing a drying treatment (heat treatment) as necessary.
The electron transporting material for forming the electron transportation layer may be an organic compound or an inorganic compound.
The electron transporting material which is an organic compound may be a low molecular weight organic compound or a high molecular weight organic compound.
Examples of the electron transporting material which is a low molecular weight organic compound include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, fullerenes such as $C_{60}$ fullerene and derivatives thereof, and phenanthrene derivatives such as bathocuproine.

Examples of the electron transporting material which is a high molecular weight organic compound include polyvinylcarbazole and derivatives thereof, polysilane and derivatives thereof, polysiloxane derivatives having an aromatic amine structure in a side chain or the main chain, polyaniline and derivatives thereof, polythiophene and derivatives thereof, polypyrrole and derivatives thereof, polyphenylene vinylene and derivatives thereof, polythienylene vinylene and derivatives thereof, and polyfluorene and derivatives thereof.

Examples of the electron transporting material which is an inorganic compound include zinc oxide, titanium oxide, zirconium oxide, tin oxide, indium oxide, GZO (gallium-doped zinc oxide), ATO (antimony-doped tin oxide), and AZO (aluminum-doped zinc oxide). Among them, zinc oxide, gallium-doped zinc oxide, or aluminum-doped zinc oxide is preferable. In the formation of the electron transportation layer, the electron transportation layer is preferably formed using a coating liquid containing particulate zinc oxide, gallium-doped zinc oxide, or aluminum-doped zinc oxide. Such an electron transporting material is preferably formed by using zinc oxide nanoparticles, gallium-doped zinc oxide nanoparticles, or aluminum-doped zinc oxide nanoparticles. The electron transportation layer is more preferably formed by using an electron transporting material composed only of zinc oxide nanoparticles, gallium-doped zinc oxide nanoparticles, or aluminum-doped zinc oxide nanoparticles.

The average particle diameter corresponding to sphere of the zinc oxide nanoparticle, the gallium-doped zinc oxide nanoparticle, and the aluminum-doped zinc oxide nanoparticle is preferably 1 nm to 1,000 nm, and more preferably 10 nm to 100 nm. The average particle diameter can be measured by, for example, a laser light scattering method, an X-ray diffraction method, or the like.

Examples of the solvent contained in the coating liquid containing the electron transporting material include water, alcohol, ketone, and hydrocarbon. Specific examples of the alcohol include methanol, ethanol, isopropanol, butanol, ethylene glycol, propylene glycol, butoxyethanol, and methoxybutanol. Specific examples of the ketone include acetone, methyl ethyl ketone, methyl isobutyl ketone, 2-heptanone, and cyclohexanone. Specific examples of the hydrocarbon include n-pentane, cyclohexane, n-hexane, benzene, toluene, xylene, tetralin, chlorobenzene, and o-dichlorobenzene. The coating liquid may contain one type of solvent alone, or two or more types of solvents. The coating liquid may contain two or more types of the solvents described above.

The coating liquid is preferably a coating liquid that hardly damages a layer (active layer or the like) to which the coating liquid is applied. Specifically, the coating liquid is preferably a coating liquid that hardly dissolves the layer (active layer or the like) to which the coating liquid is applied.

(Step of forming cathode)

In the present embodiment, a cathode is formed on the electron transportation layer.

A method for forming the cathode is not particularly limited. The cathode can be formed on a layer on which the cathode is to be formed (for example, an active layer, an electron transportation layer), by using the material of the cathode described above, by a vacuum deposition method, a sputtering method, an ion plating method, a plating method, a coating method, or the like.

When the material of the cathode is polyaniline and a derivative thereof, polythiophene and a derivative thereof, nanoparticles of a conductive substance, nanowires of a conductive substance, or nanotubes of a conductive substance, the cathode can be formed by a coating method using an emulsion, a suspension, or the like containing these materials and a solvent.

When the material of the cathode contains a conductive substance, the cathode may be formed by a coating method using a coating liquid containing a conductive substance, a metal ink, a metal paste, a low-melting point metal in a molten state, or the like. Examples of the coating method using the coating liquid containing the material of the cathode and the solvent include the same method as the step of forming the active layer described above.

Examples of the solvent contained in the coating liquid used for forming the cathode by a coating method include hydrocarbon solvents such as toluene, xylene, mesitylene, tetralin, decalin, bicyclohexyl, n-butylbenzene, sec-butylbenzene, and tert-butylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, and bromocyclohexane; halogenated aromatic hydrocarbon solvents such as chlorobenzene, dichlorobenzene, and trichlorobenzene; ether solvents such as tetrahydrofuran and tetrahydropyran; water, and alcohol. Specific examples of the alcohol include methanol, ethanol, isopropanol, butanol, ethylene glycol, propylene glycol, butoxyethanol, and methoxybutanol. The coating liquid may contain one type of solvent alone, or two or more types of solvents. The coating liquid may contain two or more types of solvents described above.

4. Application example of photodetector element

The photodetector element of the present embodiment can be applied to a detection part (sensor) included in various electronic devices such as work stations, personal computers, portable information terminals, entering/leaving management systems, digital cameras, and medical appliances.
In particular, the photodetector element according to the present embodiment can be applied to an image sensor and a biometric authentication device.
The photodetector element of the present embodiment can be suitably applied to, for example, an image detection part (for example, an image sensor such as an X-ray sensor) for solid-state imaging devices such as an X-ray imaging device and a CMOS image sensor; a detection part (for example, a near-infrared sensor) for detecting predetermined characteristics of a part of the living body, such as a fingerprint detection part, a face detection part, a vein detection part, and an iris detection part; and a detection part of optional biosensors such as a pulse oximeter, which are included in the above exemplified electronic devices.
Hereinafter, among detection parts to which the photodetector element of the present embodiment can be suitably applied, configuration examples of an image detection part for a solid-state imaging device and a fingerprint detection part for a biometric authentication device (for example, a fingerprint authentication device) will be described with reference to the drawings.

(Image detection part)

Fig. 2 is a schematic view illustrating a configuration example of an image detection part for a solid-state imaging device.
An image detection part 1 includes: a CMOS transistor substrate 20; an interlayer insulating film 30 provided so as to cover the CMOS transistor substrate 20; a photodetector element 10 of an embodiment of the present invention provided on the interlayer insulating film 30; an interlayer wiring part 32 provided so as to penetrate the interlayer insulating film 30 and electrically connecting the CMOS transistor substrate 20 and the photodetector element 10; a sealing layer 40 provided so as to cover the photodetector element10; and a color filter 50 provided on the sealing layer 40.
The CMOS transistor substrate 20 includes any preferred publicly known components in an aspect according to the design.
The CMOS transistor substrate 20 includes a transistor, a capacitor, and the like formed within the thickness of the substrate. The CMOS transistor substrate 20 includes functional elements such as a CMOS transistor circuit (MOS transistor circuit) for achieving various functions.
Examples of the functional element include a floating diffusion, a reset transistor, an output transistor, and a selection transistor.
In the CMOS transistor substrate 20, a signal reading circuit and the like is fabricated with such a functional element and wiring.
The interlayer insulating film 30 can be formed of any preferred publicly known insulating material such as silicon oxide, and an insulating resin, for example. The interlayer wiring part 32 can be formed of any preferred publicly known conductive material (wiring material) such as copper, and tungsten, for example. The interlayer wiring part 32 may be, for example, a wiring in the hole, formed simultaneously with formation of a wiring layer, or an embedded plug formed separately from the wiring layer.
The sealing layer 40 can be formed of any preferred publicly known material on the condition that permeation of harmful substances such as oxygen and water, which may deteriorate the function of the photodetector element 10, can be prevented or suppressed. The sealing layer 40 can have the same configuration as the sealing member 17 described above.
As the color filter 50, a primary color filter, which is formed of any preferred publicly known material and corresponds to the design of the image detection part 1, can be used, for example. As the color filter 50, a complementary color filter, which enables to increase the thickness compared to the primary color filter, can also be used. As the complementary color filter, color filters of the following combination of three types of (yellow, cyan, magenta), three types of (yellow, cyan, transparent), three types of (yellow, transparent, magenta), and three types of (transparent, cyan, magenta) can be used, for example. These filters can be optionally and suitably arranged according to the design of the photodetector element 10 and the CMOS transistor substrate 20 on the condition that color image data can be generated.
Light received in the photodetector element 10 though the color filter 50 is converted into an electric signal corresponding to the received light amount by the photodetector element 10, and then output outside the photodetector element 10 via the electrode, as a received light signal, that is, an electric signal corresponding to an imaging target.
Then, the received light signal output from the photodetector element 10 is received as input in the CMOS transistor substrate 20 via the interlayer wiring part 32, and then read by the signal reading circuit fabricated in the CMOS transistor substrate 20 and subjected to signal processing in any preferred publicly known functional part (not illustrated).

Thus, image information based on the imaging target can be generated.

(Fingerprint detection part)

Fig. 3 is a schematic view illustrating a configuration example of a fingerprint detection part integrally formed in a display device.

A display device 2 of a portable information terminal includes: a fingerprint detection part 100 including the photodetector element 10 of the present embodiment as a main component; and a display panel part 200 provided on the fingerprint detection part 100 and displaying a predetermined image.

In this configuration example, the fingerprint detection part 100 is provided in a region substantially corresponding to a display region 200a of the display panel part 200. In other words, the display panel part 200 is integrally layered on the fingerprint detection part 100.

In a case where fingerprint detection is performed only in a part of the display region 200a, the fingerprint detection part 100 may be provided corresponding to only the part of the display region 200a.

The fingerprint detection part 100 includes the photodetector element 10 of the present embodiment as a functional part exhibiting an essential function. The fingerprint detection part 100 can include any preferred publicly known members such as a protection film, a supporting substrate, a sealing substrate, a sealing member, a barrier film, a bandpass filter, and an infrared cut film (not illustrated) in an aspect corresponding to the design where desired characteristics can be obtained. The configuration of the image detection part which has been described can be employed for the fingerprint detection part 100.

The photodetector element 10 can be included in the display region 200a in any aspect. For example, a plurality of photodetector elements 10 may be arranged in a matrix pattern.

The photodetector element 10 is provided on the supporting substrate 11 as described above. The supporting substrate 11 is provided with an electrode (anode or cathode) in a matrix pattern, for example.

Light received in the photodetector element 10 is converted into an electric signal corresponding to the received light amount by the photodetector element 10, and then output outside the photodetector element 10 via the electrode, as a received light signal, that is, an electric signal corresponding to the imaged fingerprint.

In this configuration example, the display panel part 200 is configured as an organic electroluminescence display panel (organic EL display panel) including a touch sensor panel. The display panel part 200 may be composed of a display panel having any preferred publicly known components such as a liquid crystal display panel including a light source such as a back light instead of the organic EL display panel, for example.

The display panel part 200 is provided on the fingerprint detection part 100 which has been described. The display panel part 200 includes an organic electroluminescence element (organic EL element) 220 as a functional part exhibiting an essential function. The display panel part 200 can further include any preferred publicly known members, for example, a substrate (supporting substrate 210 or sealing substrate 240) such as any preferred publicly known glass substrate, a sealing member, a barrier film, a polarizing plate such as a circularly polarizing plate, and a touch sensor panel 230 in an aspect corresponding to desired characteristics.

In the configuration example as described above, the organic EL element 220 is used as a light source of pixels in the display region 200a, and is also used as a light source for imaging a fingerprint in the fingerprint detection part 100.

Here, operations of the fingerprint detection part 100 will be simply described.

In execution of fingerprint authentication, the fingerprint detection part 100 detects a fingerprint by using light emitted from the organic EL element 220 in the display panel part 200. Specifically, light emitted from the organic EL element 220 passes through components existing between the organic EL element 220 and the photodetector element 10 of the fingerprint detection part 100, and is reflected by the skin of the fingertip (surface of the finger) placed on the surface of the display panel part 200 in the display region 200a. At least a part of light reflected by the surface of the finger passes through components exiting between the organic EL element 220 and the photodetector element 10, is then received by the photodetector element 10, and converted into an electric signal corresponding to the received light amount of the photodetector element 10. Then, image information about the fingerprint of the surface of the finger is constituted based on the converted electric signal.

The portable information terminal including the display device 2 executes fingerprint authentication by comparing the obtained image information with fingerprint data for fingerprint authentication which has been recorded in advance by any preferred publicly known step.

EXAMPLES

Hereinafter, examples will be given for further detailed description of the present invention. The present invention is not limited to the following examples.

The p-type semiconductor material and the n-type semiconductor material used in examples and comparative

examples were obtained and used as follows.

A polymer compound P-1 which is a p-type semiconductor material was synthesized with reference to the method described in WO 2014/31364 A and used.

A polymer compound P-2 which is a p-type semiconductor material was synthesized with reference to the method described in WO 2014/31364 A and used.

A polymer compound P-3 which is a p-type semiconductor material was synthesized with reference to the method described in WO 2013/051676 A and used.

As a polymer compound P-4 which is a p-type semiconductor material, PM6 (trade name, manufactured by 1-material) was obtained from the market and used.

A polymer compound P-5 which is a p-type semiconductor material was synthesized with reference to the method described in WO 2011/052709 A and used.

As a polymer compound P-6 which is a p-type semiconductor material, PTB7 (trade name, manufactured by 1-material) was obtained from the market and used.

As a polymer compound P-7 which is a p-type semiconductor material, PCE10/PTB7-Th (trade name, manufactured by 1-material) was obtained from the market and used.

As a compound N-1 which is an n-type semiconductor material, ITIC (trade name, manufactured by 1-material) was obtained from the market and used.

As a compound N-2 which is an n-type semiconductor material, ITIC-4F (trade name, manufactured by 1-material) was obtained from the market and used.

As a compound N-3 which is an n-type semiconductor material, Y6 (trade name, manufactured by 1-material) was obtained from the market and used.

As a compound N-4 which is an n-type semiconductor material, IEICO-4F (trade name, manufactured by 1-material) was obtained from the market and used.

As a compound N-5 which is an n-type semiconductor material, diPDI (trade name, manufactured by 1-material) was obtained from the market and used.

As a compound N-6 (fullerene derivative) which is an n-type semiconductor material, E100 (trade name, manufactured by Frontier Carbon Corporation) which is "[60] PCBM (phenyl C61-butyric acid methyl ester)" was obtained from the market and used.

The energy levels of the HOMO (eV) and energy levels of the LUMO (eV) of the (polymer) compounds P-1 to P-7 and N-1 to N-5 excluding the compound N-6 were calculated based on values measured by ultraviolet photoelectron spectroscopy (UPS method). Hereinafter, a calculation method will be specifically described.

(1) Sample preparation

First, a solution was obtained by dissolving each of the (polymer) compounds P-1 to P-7 and N-1 to N-5 in o-dichlorobenzene. Next, each obtained solution was applied onto a glass substrate by a spin coating method to form a coating film, and dried on a hot plate at 70°C to form a layer having a thickness of 100 nm, thereby preparing a sample.

(2) Measurement of energy level of HOMO by UPS method

For each obtained sample, the energy level of the HOMO of each of the (polymer) compounds P-1 to P-7 and N-1 to N-5 can be calculated based on the number of electrons measured by the UPS method using a photoelectron spectrometer (Model AC-2, manufactured by Riken Keiki Co., Ltd.) in the air.

Here, the UPS method is a method of measuring the number of photoelectrons emitted in response to the energy of the ultraviolet rays emitted to a solid surface. From the minimum energy generated by photoelectrons, the work function can be estimated when the sample is a metal, and the energy level of the HOMO can be estimated when the sample is a semiconductor material.

The energy level of the LUMO of each of the (polymer) compounds P-1 to P-7 and N-1 to N-5 can be calculated by the following equation.

$$\text{Equation: energy level of LUMO} = \text{band gap (Eg)} - \text{energy level of HOMO}$$

Here, the band gap (Eg) can be calculated by the following equation based on the absorption edge wavelength of the p-type semiconductor material.

wavelength

where h represents the Planck's constant ($h = 6.626 \times 10^{-34}$ Js) and c represents the light velocity ($c = 3 \times 10^{8}$ m/s) .

The absorption edge wavelength was measured using a spectrophotometer (for example, ultraviolet-visible near-infrared spectrophotometer JASCO-V670, manufactured by JASCO Corporation) capable of measuring in wavelength ranges of ultraviolet light, visible light, and near-infrared light.

In the absorption spectrum obtained by the spectrophotometer, a value of a wavelength at the intersection between the baseline and the straight line obtained by fitting at the shoulder (high-wavelength side) of the absorption peak was taken as the absorption edge wavelength (nm). The absorption spectrum was shown by plotting with the absorbance (absorption intensity) of the (polymer) compound on the vertical axis and the wavelength on the horizontal axis.

The energy level of the HOMO and the energy level of the LUMO of the compound N-6 can be measured by CV (cyclic voltammetry) measurement. Hereinafter, a specific description will be given.

The CV measurement can be performed, for example, under the conditions described in Nanoscale Research Letters 2011, 6: 545 page.

The CV measurement can be performed using, for example, the following equipment.

CV measurement apparatus: three-electrode system
Supporting electrolyte: acetonitrile solution containing tetrabutylammonium hexafluorophosphate ($Bu_4NPF_6$) at a concentration of 0.1 M
Working electrode: glassy carbon
Counter electrode: platinum wire
Reference electrode: $Ag/Ag^+$
Standard potential: ferrocene (E1/2 = 0.120 V vs. $Ag/Ag^+$)
Scan rate: 100 mV/sec

The energy level of the HOMO of the compound N-6 was -6.20 eV. The energy level of the LUMO of the compound N-6 was -4.30 eV.

The absolute value of the energy level (eV) of the HOMO, the absolute value of the energy level (eV) of the LUMO, and the absorption edge wavelength (nm) of the (polymer) compounds P-1 to P-7 and N-1 to N-6 are as shown in the following Table 1.

[Table 1]

(Table 1)

| (Polymer) compound | HOMO (eV) | LUMO (eV) | Absorption edge wavelength (nm) |
|---|---|---|---|
| P-1 | 5.66 | 4.03 | 760 |
| P-2 | 5.58 | 3.67 | 650 |
| P-3 | 5.20 | 3.81 | 892 |
| P-4 | 5.19 | 3.36 | 678 |
| P-5 | 5.03 | 3.89 | 1085 |
| P-6 | 4.99 | 3.32 | 740 |
| P-7 | 5.09 | 3.50 | 780 |
| N-1 | 5.74 | 4.15 | 780 |
| N-2 | 5.88 | 4.33 | 800 |
| N-3 | 5.79 | 4.51 | 969 |

(continued)

| (Polymer) compound | HOMO (eV) | LUMO (eV) | Absorption edge wavelength (nm) |
|---|---|---|---|
| N-4 | 5.58 | 4.34 | 1000 |
| N-5 | 5.76 | 3.73 | 611 |
| N-6 | 6.20 | 4.30 | Not measured |

<Preparation Example 1> (Preparation of ink composition I-1)

As also shown in the following Table 2, a compound N-1 as an n-type semiconductor material and a polymer compound P-1 as a p-type semiconductor material were mixed with 1,2-dichlorobenzene as a solvent such that the concentration of each of the compound N-1 and the polymer compound P-1 was 2 wt.% relative to the total weight of the ink composition (the ratio of the n-type semiconductor material to the p-type semiconductor material was 1/1). The mixture was stirred at 75°C for 3 hours, and the resulting mixed solution was filtrated using a filter to obtain an ink composition (I-1).

<Preparation Examples 2 to 7 and Comparative Preparation Examples 1 to 13>

Ink compositions (I-2) to (I-7) and ink compositions (C-1) to (C-13) were prepared in the same manner as in Preparation Example 1 except that the n-type semiconductor material and the p-type semiconductor material were used in the combination shown in Table 2 below.

[Table 2]

(Table 2)

| | Ink composition | p-type semiconductor material | n-type semiconductor material |
|---|---|---|---|
| | | Polymer compound | Compound |
| Preparation Example 1 | I-1 | P-1 | N-1 |
| Preparation Example 2 | I-2 | P-1 | N-2 |
| Preparation Example 3 | I-3 | P-1 | N-4 |
| Preparation Example 4 | I-4 | P-2 | N-2 |
| Preparation Example 5 | I-5 | P-2 | N-3 |
| Preparation Example 6 | I-6 | P-2 | N-4 |
| Preparation Example 7 | I-7 | P-2 | N-5 |
| Comparative Preparation Example 1 | C-1 | P-1 | N-5 |
| Comparative Preparation Example 2 | C-2 | P-3 | N-1 |
| Comparative Preparation Example 3 | C-3 | P-3 | N-3 |
| Comparative Preparation Example 4 | C-4 | P-3 | N-4 |
| Comparative Preparation Example 5 | C-5 | P-4 | N-1 |
| Comparative Preparation Example 6 | C-6 | P-4 | N-3 |

(continued)

| | Ink composition | p-type semiconductor material | n-type semiconductor material |
|---|---|---|---|
| | | Polymer compound | Compound |
| Comparative Preparation Example 7 | C-7 | P-5 | N-1 |
| Comparative Preparation Example 8 | C-8 | P-5 | N-3 |
| Comparative Preparation Example 9 | C-9 | P-5 | N-6 |
| Comparative Preparation Example 10 | C-10 | P-6 | N-1 |
| Comparative Preparation Example 11 | C-11 | P-6 | N-4 |
| Comparative Preparation Example 12 | C-12 | P-7 | N-1 |
| Comparative Preparation Example 13 | C-13 | P-7 | N-4 |

<Example 1> (Production and evaluation of photodetector element)

(1) Production of photodetector element and sealed body thereof

A photodetector element and a sealed body thereof were produced as follows.

A glass substrate was prepared on which an ITO thin film (anode) having a thickness of 50 nm has been formed by a sputtering method. The glass substrate was subjected to ozone UV treatment as a surface treatment.

Next, the ink composition (I-1) was applied onto the ITO thin film by a spin coating method to form a coating film. The coating film was then dried by heat treatment for 10 minutes using a hot plate heated to 100°C under a nitrogen gas atmosphere. The thickness of the active layer thus formed was about 250 nm.

Next, in a resistance heating vapor deposition apparatus, a calcium (Ca) layer having a thickness of about 5 nm was formed on the active layer thus formed, thereby forming an electron transportation layer.

Then, a silver (Ag) layer having a thickness of about 60 nm was formed on the electron transportation layer thus formed, thereby forming a cathode.

Through the above steps, a photodetector element was produced on the glass substrate. The obtained structure was used as a sample 1.

Next, a UV-curable sealing agent as a sealing material was applied onto the glass substrate as a supporting substrate so as to surround the periphery of the produced photodetector element, and a glass substrate as a sealing substrate was bonded to the supporting substrate. Then, the photodetector element was enclosed in a gap between the supporting substrate and the sealing substrate by irradiation with UV light, thereby obtaining a sealed body of the photodetector element. The planar shape of the photodetector element enclosed in the gap between the supporting substrate and the sealing substrate as viewed from the thickness direction was a square of 2 mm × 2 mm.

(2) Evaluation of photodetector element

A reverse bias voltage of -2 V was applied to the produced sealed body of the photodetector element. The external quantum efficiency (EQE) and the dark current at the applied voltage were respectively measured by a solar simulator (CEP-2000, manufactured by Bunkoukeiki Co., Ltd.) and a source meter (KEITHLEY 2450 Source Meter, manufactured by Keithley Instruments), and evaluated.

Regarding the EQE, first, the sealed body of the photodetector element was irradiated with light of a predetermined number of photons (1.0 × 1016) every 20 nm in a wavelength range of 300 nm to 1,200 nm in a state where a reverse bias voltage of -2 V was applied to the sealed body, and the value of a current generated at that time was measured. Then, a spectrum of the EQE at a wavelength of 300 nm to 1,200 nm was obtained by a known technique.

Next, among a plurality of measured values obtained for every 20 nm, a measured value at a wavelength

($\lambda$max) closest to the absorption peak wavelength of the p-type semiconductor material was taken as the value (%) of the EQE.

Regarding the dark current, a voltage of -10 V to 2 V was applied to the sealed body of the photodetector element in a dark state where the sealed body was not irradiated with light. A current value when a reverse bias voltage of -2 V was applied, the current value being measured by a known technique, was obtained as the value of the dark current.

Next, the specific detectivity (detectivity) (D*) (Jones) at an applied voltage of -2 V was calculated by the obtained measured value and a calculation formula represented by the following equation.

[Mathematical Formula 1]

$$D^* = \frac{(\lambda_{max}/1240) \times (EQE)}{\sqrt{2eJ_d}}$$

In the equation, EQE is the external quantum efficiency and represents EQE at $\lambda_{max}$, and $J_d$ represents the dark current density.

The results are shown in Table 3 below together with the value ($\Delta$EA + $\Delta$EB) of the sum of the value ($\Delta$EA) obtained by subtracting the absolute value of the energy level of the HOMO of the p-type semiconductor material from the absolute value of the energy level of the HOMO of the n-type semiconductor material and the value ($\Delta$EB) obtained by subtracting the absolute value of the energy level of the LUMO of the p-type semiconductor material from the absolute value of the energy level of the LUMO of the n-type semiconductor material used in each of Examples and Comparative Examples.

<Examples 2 to 5 and Comparative Examples 1 to 13>

Photodetector elements and sealed bodies thereof according to Examples 2 to 5 and Comparative Examples 1 to 13 were produced and evaluated in the same manner as in Example 1 except for using the ink composition (I-2) in Example 2, the ink composition (I-3) in Example 3, the ink composition (I-6) in Example 4, and the ink composition (I-7) in Example 5, for Examples 2 to 5, and the ink compositions (C-1) to (C-13) for Comparative Examples 1 to 13 in place of the ink composition (I-1). The results are shown in Table 3.

[Table 3]

(Table 3)

| | Ink composition | ΔEA+ΔEB (eV) | D*(Jones) |
|---|---|---|---|
| Example 1 | I-1 | 0.20 | 3.02E+13 |
| Example 2 | I-2 | 0.52 | 1.23E+14 |
| Example 3 | I-3 | 0.23 | 1.20E+14 |
| Example 4 | I-6 | 0.67 | 3.49E+13 |
| Example 5 | I-7 | 0.24 | 2.11E+13 |
| Comparative Example 1 | C-1 | -0.20 | 4.04E+12 |
| Comparative Example 2 | C-2 | 0.88 | 7.77E+12 |
| Comparative Example 3 | C-3 | 1.29 | 4.38E-12 |
| Comparative Example 4 | C-4 | 0.91 | 7.20E-12 |
| Comparative Example 5 | C-5 | 1.34 | 5.81E-12 |
| Comparative Example 6 | C-6 | 1.75 | 4.87E-12 |
| Comparative Example 7 | C-7 | 0.97 | 3.65E+12 |
| Comparative Example 8 | C-8 | 1.38 | 2.40E+12 |
| Comparative Example 9 | C-9 | 1.58 | 7.11E-12 |

(continued)

| | Ink composition | ΔEA+ΔEB (eV) | D*(Jones) |
|---|---|---|---|
| Comparative Example 10 | C-10 | 1.58 | 5.41E+12 |
| Comparative Example 11 | C-11 | 1.61 | 2.15E+12 |
| Comparative Example 12 | C-12 | 1.30 | 3.43E+12 |
| Comparative Example 13 | C-13 | 1.33 | 4.88E+12 |

DESCRIPTION OF REFERENCE SIGNS

| | |
|---|---|
| 1 | Image detection part |
| 2 | Display device |
| 10 | Photodetector element |
| 11, 210 | Supporting substrate |
| 12 | First electrode |
| 13 | Electron transportation layer |
| 14 | Active layer |
| 15 | Hole transportation layer |
| 16 | Second electrode |
| 17 | Sealing member |
| 20 | CMOS transistor substrate |
| 30 | Interlayer insulating film |
| 32 | Interlayer wiring part |
| 40 | Sealing layer |
| 50 | Color filter |
| 100 | Fingerprint detection part |
| 200 | Display panel part |
| 200a | Display region |
| 220 | Organic EL element |
| 230 | Touch sensor panel |
| 240 | Sealing substrate |

## Claims

**1.** A photodetector element comprising: an anode; a cathode; and an active layer provided between the anode and the cathode and containing a p-type semiconductor material and an n-type semiconductor material,
wherein a value (ΔEA + ΔEB) of a sum of a value (ΔEA) obtained by subtracting an absolute value of an energy level of a highest occupied molecular orbital (HOMO) of the p-type semiconductor material from an absolute value of an energy level of a HOMO of the n-type semiconductor material and a value (ΔEB) obtained by subtracting an absolute value of an energy level of a lowest unoccupied molecular orbital (LUMO) of the p-type semiconductor material from an absolute value of an energy level of a LUMO of the n-type semiconductor material is in a range of more than 0 and less than 0.88.

**2.** The photodetector element according to claim 1, wherein the value (ΔEA + ΔEB) of the sum is in a range of 0.20 to 0.67.

**3.** The photodetector element according to claim 1 or 2, wherein the p-type semiconductor material is a polymer compound containing a constituent unit represented by Formula (I):

[Chemical Formula 1]

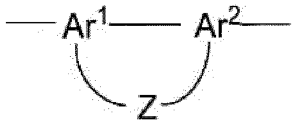

(I)

where $Ar^1$ and $Ar^2$ represent a trivalent aromatic heterocyclic group optionally having a substituent or a trivalent aromatic carbocyclic group optionally having a substituent, and Z represents a group represented by Formulae (Z-1) to (Z-7);

[Chemical Formula 2]

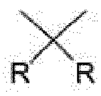
(Z-1)
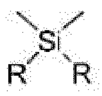
(Z-2)
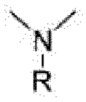
(Z-3)
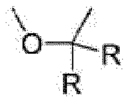
(Z-4)
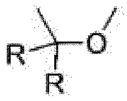
(Z-5)
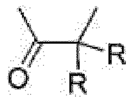
(Z-6)
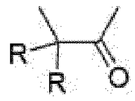
(Z-7)

where

R each independently represents

a hydrogen atom,
a halogen atom,
an alkyl group optionally having a substituent,
an aryl group optionally having a substituent,
a cycloalkyl group optionally having a substituent,
an alkyloxy group optionally having a substituent,
a cycloalkyloxy group optionally having a substituent,
an aryloxy group optionally having a substituent,
an alkylthio group optionally having a substituent,
a cycloalkylthio group optionally having a substituent,
an arylthio group optionally having a substituent,
a monovalent heterocyclic group optionally having a substituent,
a substituted amino group optionally having a substituent,
an imine residue optionally having a substituent,
an amide group optionally having a substituent,
an acid imide group optionally having a substituent,
a substituted oxycarbonyl group optionally having a substituent,
an alkenyl group optionally having a substituent,
a cycloalkenyl group optionally having a substituent,
an alkynyl group optionally having a substituent,
a cycloalkynyl group optionally having a substituent,
a cyano group,
a nitro group,
a group represented by $-C(=O)-R^a$, or
a group represented by $-SO_2-R^b$,

$R^a$ and $R^b$ each independently represent

a hydrogen atom,
an alkyl group optionally having a substituent,
an aryl group optionally having a substituent,
an alkyloxy group optionally having a substituent,

an aryloxy group optionally having a substituent, or
a monovalent heterocyclic group optionally having a substituent, and

when there are two Rs, the two Rs may be the same or different.

**4.** The photodetector element according to any one of claims 1 to 3, wherein the p-type semiconductor material is a polymer compound containing a constituent unit represented by Formula (II) or (III):

[Chemical Formula 3]

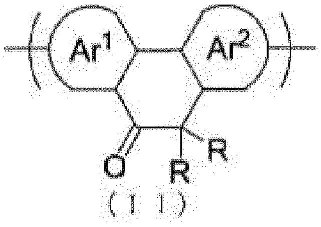
(I I)

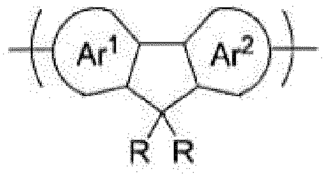
(I I I)

where $Ar^1$, $Ar^2$, and R are as defined above.

**5.** The photodetector element according to claim 4, wherein the p-type semiconductor material is a polymer compound containing a constituent unit represented by Formula (IV):

[Chemical Formula 4]

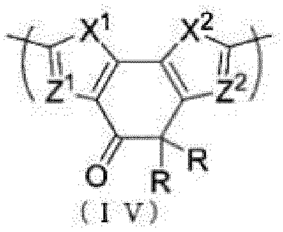
(I V)

where

$X^1$ and $X^2$ are each independently a sulfur atom or an oxygen atom,
$Z^1$ and $Z^2$ are each independently a group represented by =C(R)- or a nitrogen atom, and
R is as defined above.

**6.** The photodetector element according to claim 5, wherein in Formula (IV), $X^1$ and $X^2$ are a sulfur atom, and $Z^1$ and $Z^2$ are a group represented by =C(R)-.

**7.** The photodetector element according to any one of claims 1 to 6, wherein the p-type semiconductor material is a polymer compound containing a constituent unit represented by Formulae (VI-1) to (VI-7):

[Chemical Formula 5]

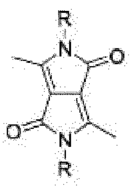
(VI-1)

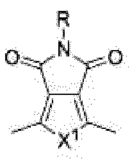
(VI-2)

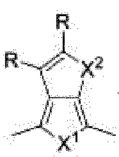
(VI-3)

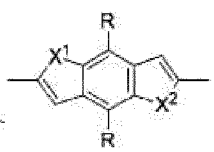
(VI-4)

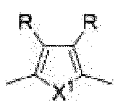
(VI-5)

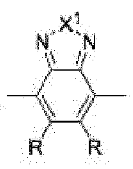
(VI-6)

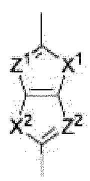
(VI-7)

where $X^1$, $X^2$, $Z^1$, $Z^2$, and R are as defined above, and when there are two Rs, the two Rs may be the same or different.

8. The photodetector element according to any one of claims 1 to 7, wherein the n-type semiconductor material is a compound represented by Formula (VIII):

$$A^1\text{-}B^{10}\text{-}A^2 \qquad \text{(VIII)}$$

where

$A^1$ and $A^2$ each independently represent an electron-withdrawing group, and
$B^{10}$ represents a group including a $\pi$ conjugated system.

9. The photodetector element according to claim 8, wherein the n-type semiconductor material is a compound represented by Formula (IX):

$$A^1\text{-}(S^1)_{n1}\text{-}B^{11}\text{-}(S^2)_{n2}\text{-}A^2 \qquad \text{(IX)}$$

where

$A^1$ and $A^2$ are as defined above,
$S^1$ and $S^2$ each independently represent
a divalent carbocyclic group optionally having a substituent,
a divalent heterocyclic group optionally having a substituent,
a group represented by $-C(R^{s1})=C(R^{s2})-$, or
a group represented by -C=C-,
$R^{s1}$ and $R^{s2}$ each independently represent a hydrogen atom or a substituent,
$B^{11}$ is a divalent group including a condensed ring formed through condensation of two or more ring structures selected from the group consisting of carbocyclic rings and heterocyclic rings, and represents a divalent group including no ortho-peri condensed structure and optionally having a substituent, and
n1 and n2 each independently represent an integer of 0 or more.

10. The photodetector element according to claim 9, wherein $B^{11}$ is a divalent group including a condensed ring formed through condensation of two or more ring structures selected from the group consisting of structures represented by Formulae (Cy1) to (Cy9), and is a divalent group optionally having a substituent:

[Chemical Formula 6]

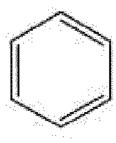
(Cy1)

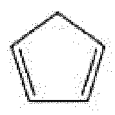
(Cy2)

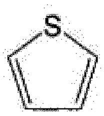
(Cy3)

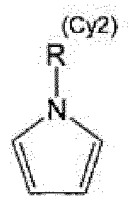
(Cy4)

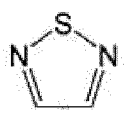
(Cy5)

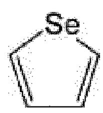
(Cy6)

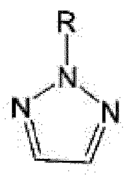
(Cy7)

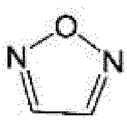
(Cy8)

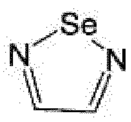
(Cy9)

where R is as defined above.

**11.** The photodetector element according to claim 9 or 10, wherein $S^1$ and $S^2$ are each independently a group represented by Formula (s-1) or a group represented by Formula (s-2):

[Chemical Formula 7]

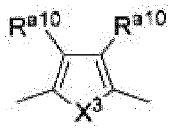

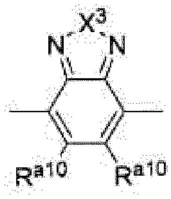

(s-1) (s-2)

where

$X^3$ represents an oxygen atom or a sulfur atom, and
$R^{a10}$ each independently represents a hydrogen atom, a halogen atom, or an alkyl group.

**12.** The photodetector element according to any one of claims 8 to 11, wherein $A^1$ and $A^2$ are each independently a group represented by $-CH=C(-CN)_2$ and a group selected from the group consisting of groups represented by Formulae (a-1) to (a-9):

[Chemical Formula 8]

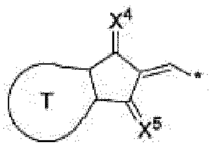

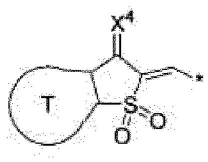

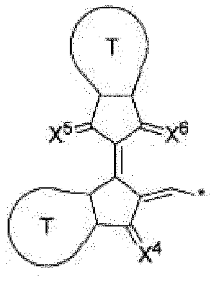

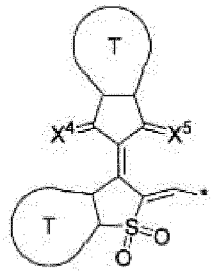

(a-1) (a-2) (a-3) (a-4)

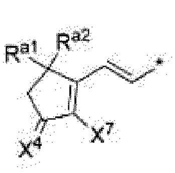

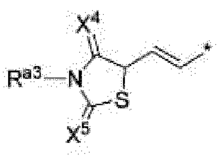

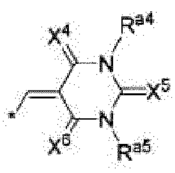

(a-5) (a-6) (a-7)

where

T is

a carbocyclic ring optionally having a substituent, or
a heterocyclic ring optionally having a substituent,

$X^4$, $X^5$, and $X^6$ each independently represent an oxygen atom, a sulfur atom, an alkylidene group, or a group represented by =C(-CN)$_2$,
$X^7$ represents a hydrogen atom, a halogen atom, a cyano group, an alkyl group optionally having a substituent, an alkyloxy group optionally having a substituent, an aryl group optionally having a substituent, or a monovalent heterocyclic group optionally having a substituent, and
$R^{a1}$, $R^{a2}$, $R^{a3}$, $R^{a4}$, and $R^{a5}$ each independently represent a hydrogen atom, an alkyl group optionally having a substituent, a halogen atom, an alkyloxy group optionally having a substituent, an aryl group optionally having a substituent, or a monovalent heterocyclic group;

[Chemical Formula 9]

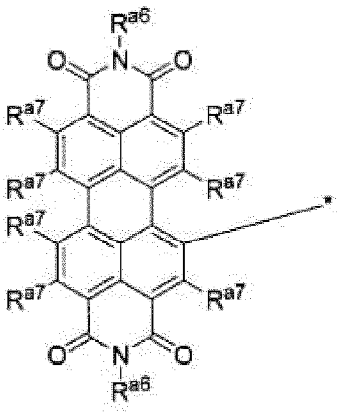

(a-8)

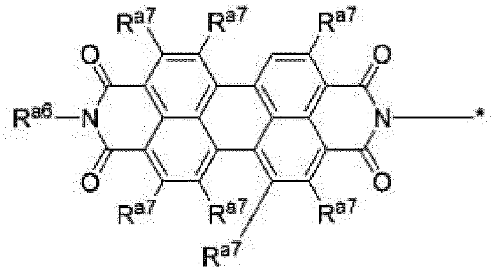

(a-9)

where
$R^{a6}$ and $R^{a7}$ each independently represent

a hydrogen atom,
a halogen atom,
an alkyl group optionally having a substituent,
a cycloalkyl group optionally having a substituent,
an alkyloxy group optionally having a substituent,
a cycloalkyloxy group optionally having a substituent,
a monovalent aromatic carbocyclic group optionally having a substituent, or
a monovalent aromatic heterocyclic group optionally having a substituent, and a plurality of $R^{a6}$s and $R^{a7}$s may be the same or different.

**13.** The photodetector element according to any one of claims 1 to 7, wherein the n-type semiconductor material is a compound represented by Formula (X) or (XI):
[Chemical Formula 10]

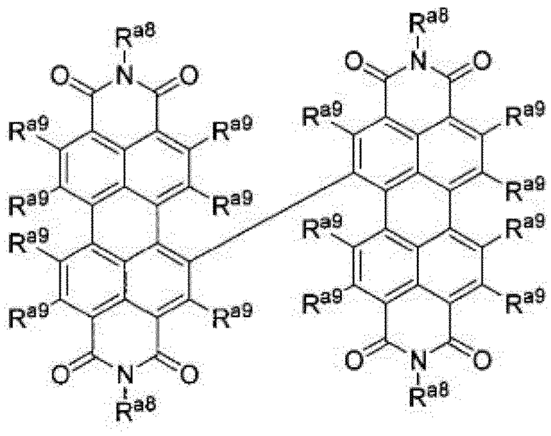

(X)

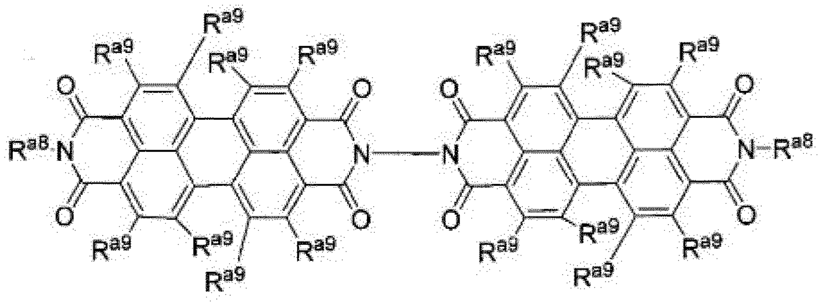

(X I)

where
$R^{a8}$ and $R^{a9}$ are each independently represent

a hydrogen atom,
a halogen atom,
an alkyl group optionally having a substituent,
a cycloalkyl group optionally having a substituent,
an alkyloxy group optionally having a substituent,
a cycloalkyloxy group optionally having a substituent,
a monovalent aromatic carbocyclic group optionally having a substituent, or
a monovalent aromatic heterocyclic group optionally having a substituent, and a plurality of $R^{a8}$s and $R^{a9}$s may be the same or different.

**14.** The photodetector element according to claim 13, wherein the n-type semiconductor material is a compound represented by Formula N-5:

[Chemical Formula 11]

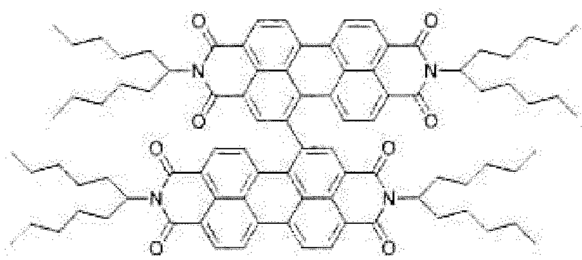

N − 5

.

**15.** A sensor comprising the photodetector element according to any one of claims 1 to 14.

**16.** A biometric authentication device comprising the photodetector element according to any one of claims 1 to 14.

**17.** An X-ray sensor comprising the photodetector element according to any one of claims 1 to 14.

**18.** A near-infrared sensor comprising the photodetector element according to any one of claims 1 to 14.

**19.** A composition comprising: an n-type semiconductor material; and a p-type semiconductor material,
wherein a value ($\Delta EA + \Delta EB$) of a sum of a value ($\Delta EA$) obtained by subtracting an absolute value of an energy level of a HOMO of the p-type semiconductor material from an absolute value of an energy level of a HOMO of the n-type semiconductor material and a value ($\Delta EB$) obtained by subtracting an absolute value of an energy level of a LUMO of the p-type semiconductor material from an absolute value of an energy level of a LUMO of the n-type semiconductor material is in a range of more than 0 and less than 0.88.

**20.** An ink composition comprising: the composition according to claim 19; and a solvent.

[FIG. 1]

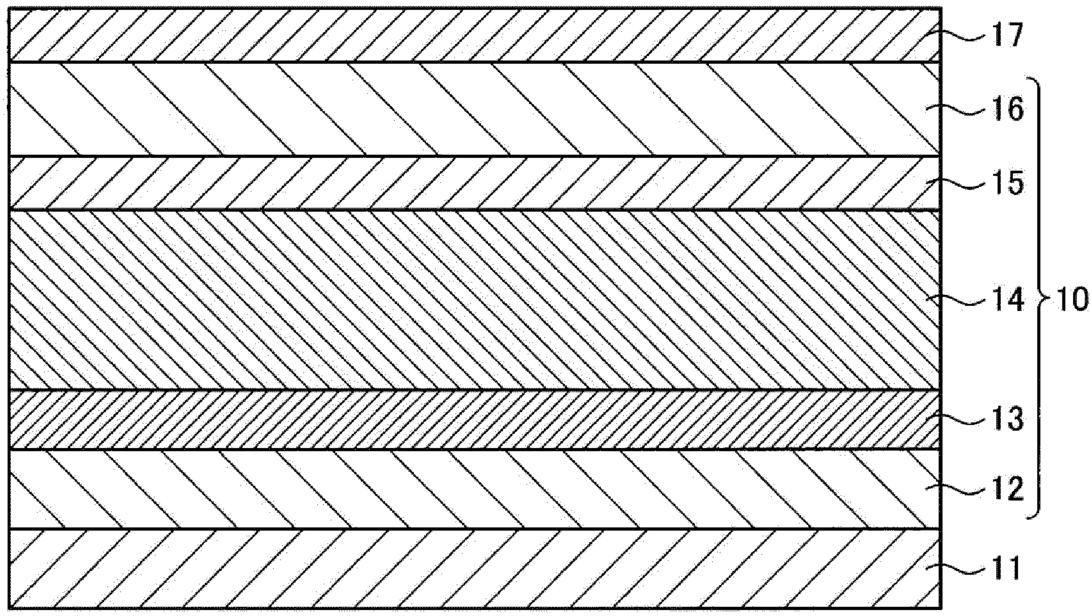


[FIG. 2]

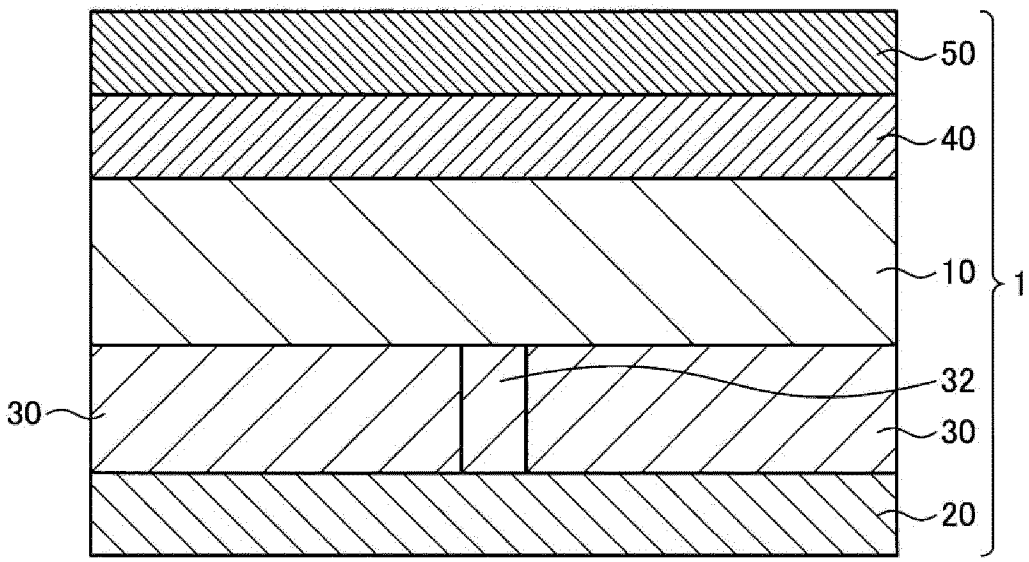


[FIG. 3]

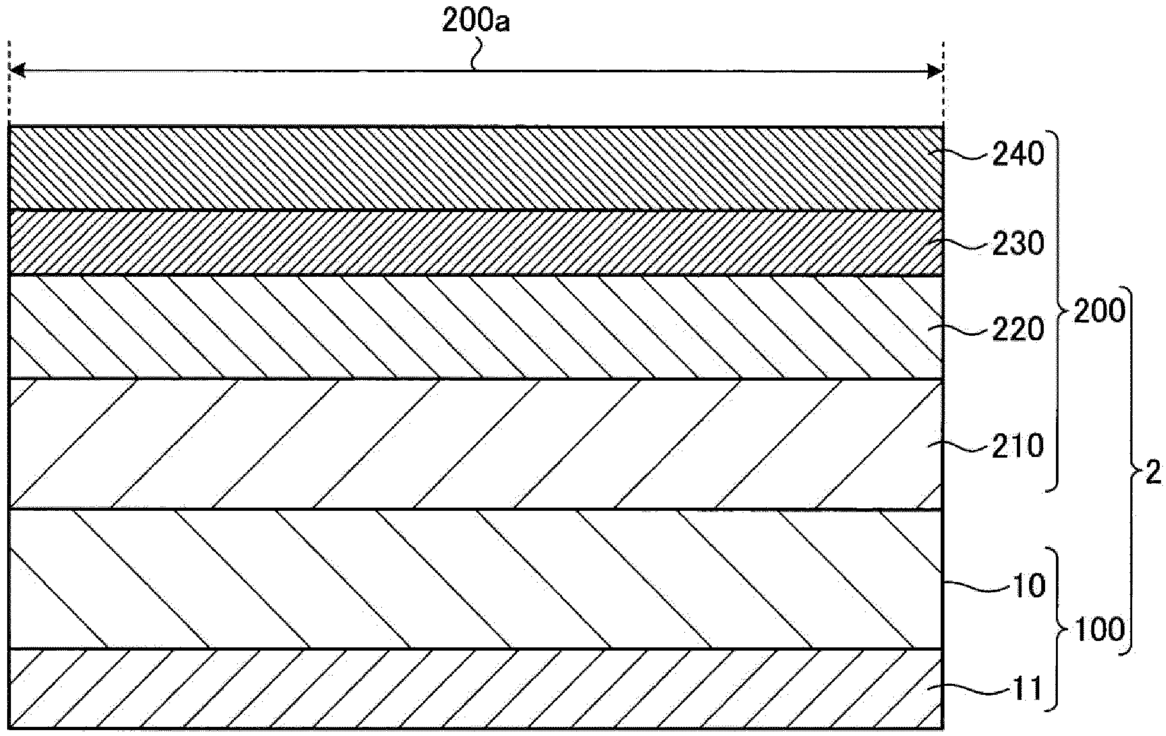
200a
240
230
220
200
210
2
10
100
11

## INTERNATIONAL SEARCH REPORT

International application No.
PCT/JP2021/011597

A. CLASSIFICATION OF SUBJECT MATTER
H01L 51/42(2006.01)i; H01L 31/10(2006.01)i; H01L 27/30(2006.01)i
FI: H01L31/08 T; H01L31/10 A; H01L27/30

According to International Patent Classification (IPC) or to both national classification and IPC

B. FIELDS SEARCHED

Minimum documentation searched (classification system followed by classification symbols)
H01L51/42-51/48; H01L31/08-31/119; H01L27/30

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2017/126401 A1 (SUMITOMO CHEMICAL CO., LTD.) 27 July 2017 (2017-07-27) paragraphs [0128]-[0129], [0159]-[0161], [0164], [0184], [0195], [0200], [0203] | 1, 3-7, 15-20<br>2, 8-14 |
| Y | WO 2019/193331 A2 (CAMBRIDGE DISPLAY TECHNOLOGY LIMITED) 10 October 2019 (2019-10-10) specification, page 30, line 26 to page 33, line 2 | 2, 8-14 |
| A | JP 2015-220331 A (SUMITOMO CHEMICAL CO., LTD.) 07 December 2015 (2015-12-07) | 1-20 |
| A | US 2017/0057962 A1 (UNIVERSITY OF WASHINGTON) 02 March 2017 (2017-03-02) | 1-20 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 31 May 2021 (31.05.2021) | 08 June 2021 (08.06.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/011597

| Patent Documents referred in the Report | Publication Date | Patent Family | Publication Date |
|---|---|---|---|
| WO 2017/126401 A1 | 27 Jul. 2017 | US 2021/0139643 A1 paragraphs [0179]-[0182], [0226]-[0231], [0237], [0264]-[0265], [0286]-[0287], [0296], [0299] | |
| WO 2019/193331 A2 | 10 Oct. 2019 | GB 2572573 A<br>GB 2572659 A | |
| JP 2015-220331 A | 07 Dec. 2015 | (Family: none) | |
| US 2017/0057962 A1 | 02 Mar. 2017 | WO 2015/038671 A2 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 201431364 A
- WO 2013051676 A
- WO 2011052709 A


### Non-patent literature cited in the description


- *Scientific Reports,* vol. 6, 39201
- *Adv. Mater.,* 2015, vol. 27, 6411-6417
- *Nanoscale Research Letters,* 2011, vol. 6, 545